# EUROPÄISCHE PATENTSCHRIFT

(11) **EP 1 427 768 B1**
(45) Veröffentlichungstag und Bekanntmachung des Hinweises auf die Patenterteilung: **24.01.2007**
(21) Anmeldenummer: 02772227.1
(22) Anmeldetag: 29.08.2002
(51) Int. Cl.: C08G 61/00, C09K 11/06, H05B 33/14, H01L 51/30

(54) **KONJUGIERTE POLYMERE ENTHALTEND SPIROBIFLUOREN-EINHEITEN UND DEREN VERWENDUNG**
CONJUGATED POLYMERS CONTAINING SPIROBIFLUORENE UNITS AND THE USE THEREOF
POLYMERES CONJUGUES CONTENANT DES UNITES SPIROBIFLUORENE ET LEUR UTILISATION

(30) Priorität: 04.09.2001 DE 10143353
(43) Veröffentlichungstag der Anmeldung: 16.06.2004
(73) Patentinhaber: Merck Patent GmbH, 64293 Darmstadt (DE)
(72) Erfinder: BECKER, Heinrich, 61479 Glashütten (DE); TREACHER, Kevin, Northwich, Cheshire CW8 4TG (GB); SPREITZER, Hubert, 68519 Viernheim (DE); FALCOU, Aurelie, 60489 Frankfurt (DE); STÖSSEL, Philipp, 65929 Frankfurt (DE); BÜSING, Arne, 65929 Frankfurt (DE); PARHAM, Amir, 60435 Frankfurt (DE); SCHRÖDER, Bernd, 65606 Villmar-Weyer (DE)
(86) Internationale Anmeldenummer: PCT/EP2002/009628
(87) Internationale Veröffentlichungsnummer: WO 2003/020790

(56) Entgegenhaltungen:
- EP-A- 0 894 107
- WO-A-00/46321
- WO-A-02/077060
- US-A- 5 621 131
- HEEGER ET AL: "Spiro-functionalized Polyfluorene Derivatives as Blue-Light-Emitting materials" ADVANCED MATERIALS, VCH VERLAGSGESELLSCHAFT, WEINHEIM, DE, Bd. 12, Nr. 11, 22. Mai 2000 (2000-05-22), Seiten 828-831, XP002209789 ISSN: 0935-9648
- CARTER ET. AL.: "Amorphous Poly-2,7-fluorene Networks" CHEMISTRY OF MATERIALS, Bd. 13, - 13. Oktober 2001 (2001-10-13) Seiten 4285-4289, XP002221867

## Beschreibung

Die vorliegende Anmeldung handelt von neuartigen konjugierten Polymeren und deren Verwendung in opto-elektronischen Vorrichtungen, bevorzugt z. B. in Displays auf der Basis polymerer organischer Leuchtdioden.

Seit ca. 10 Jahren läuft eine breitangelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 (WO 90/13148) offenbart sind. Im Gegensatz zu den niedermolekularen organischen Leuchtdioden (OLEDs), bei denen die Markteinführung bereits erfolgt ist, wie die im Markt erhältlichen Auto-Radios mit "organischem Display" der Firma Pioneer belegen, steht diese bei den PLEDs noch bevor. Es sind hier immer noch deutliche Verbesserungen nötig, um diese Displays zu einer echten Konkurrenz zu den derzeit marktbeherrschenden Flüssigkristallanzeigen (LCD) zu machen bzw. diese zu überflügeln.

In EP-A-0 423 283, EP-A-0 443 861, WO 98/27136, EP-A-1 025 183 und WO 99/24526 werden als konjugierte polymere Emitter Poly-Arylen-Vinylen-Derivate offenbart.
In EP-A-0 842 208, WO 99/54385, WO 00/22027, WO 00/22026 und WO 00/46321 werden als konjugierte polymere Emitter Poly-Fluoren-Derivate offenbart. In EP-A-0 707 020 und EP-A-0 894 107 werden als konjugierte polymere Emitter Poly-Spirobifluoren-Derivate offenbart.
In EP 1381639 werden als konjugierte polymere Emitter Polymere offenbart, welche Spirobifluoren-Einheiten, Fluoren-Einheiten und gegebenenfalls weitere Einheiten enthalten.

Konjugierte Polymere im Sinne dieser Erfindung sollen Polymere sein, die in der Hauptkette hauptsächlich sp²-hybridisierte Kohlenstoffatome, die auch durch entsprechende Heteroatome ersetzt sein können, enthalten. Dies ist gleichbedeutend mit dem abwechselnden Vorliegen von Doppel- und Einfachbindungen in der Hauptkette. Hauptsächlich meint, daß natürlich auftretende Defekte, die zu Konjugationsunterbrechungen führen, den Begriff "Konjugierte Polymere" nicht entwerten. Es sind jedoch keine Polymere, welche absichtlich eingefügte größere Mengen an nichtkonjugierten Segmenten enthalten, gemeint. Des weiteren wird in diesem Anmeldetext ebenfalls als konjugiert bezeichnet, wenn sich in der Hauptkette z. B. Arylamineinheiten und/oder bestimmte Heterocyclen (d. h. Konjugation über N-, O-, oder S-Atome) und/oder Metallorganische Komplexe (d. h. Konjugation über das Metallatom) befinden. Hingegen würden Einheiten wie einfache (Thio)Etherbrücken, Esterverknüpfungen, Amid- oder Imidverknüpfungen eindeutig als nicht-konjugierte Segmente definiert.

Der allgemeine Aufbau von PLEDs ist in den o. g. Anmeldeschriften bzw. Patenten wiedergegeben und auch weiter unten noch näher erläutert. Weitere Verfeinerungen (beispielsweise Passiv-Matrix-Adressierung, Aktiv-Matrix-Adressierung) sind ebenfalls bereits bekannt, sind aber für die weitere Beschreibung der hier vorliegenden Anmeldung nicht entscheidend.
Derzeit wird die Kommerzialisierung von sowohl einfarbigen als auch mehr- bzw. vollfarbigen Displays basierend auf PLEDs erwogen. Während die einfarbigen Displays eventuell durch einfache Beschichtungstechnologien (wie z. B. Rackeln, Spin-Coaten) erzeugt werden können, ist bei mehr- bzw. vollfarbigen Anzeigeelementen der Einsatz von Druckverfahren (z. B. Tintenstrahldrucken, Off-Set-Drucken, Tiefdruckverfahren, Siebdruck-Verfahren) sehr wahrscheinlich. All diese Verfahren benötigen jedoch lösliche Polymere.

Die konjugierten Polymere gemäß den o. g. Anmeldungen zeigen zum Teil schon gute Eigenschaften für die aufgeführten Anwendungen auf.
Wichtige Eigenschaften sind hierbei v. a. folgende:
- Hohe Leucht- und Energieeffizienz bei der Verwendung in PLEDs.
- Lange Operative Lebensdauer bei der Verwendung in PLEDs.
- Niedrige Betriebsspannung.
- Gute Lagerstabilität, sowohl in der Verwendung in PLEDs, als auch vor deren Einbringen in entsprechende Vorrichtungen.
- Gute Löslichkeit in organischen Lösemitteln um überhaupt ein entsprechendes Beschichtungsverfahren zu ermöglichen.
- Vernünftige Zugänglichkeit um die wirtschaftliche Verwendung in Massenprodukten zu ermöglichen.
- Erzielbarkeit verschiedener Farben, um vollfarbige Anzeigeelemente (Displays) zu ermöglichen.

Es wurde nun überraschend gefunden, daß eine verbesserte, weiterentwickelte neue Klasse von konjugierten Polymeren sehr gute und den o. g. Stand der Technik übertreffende Eigenschaften aufweist. Diese Polymere und deren Verwendung in PLEDs sind Gegenstand der vorliegenden Erfindung.

Gegenstand der Erfindung sind konjugierte Polymere, die neben Einheiten der Formel (I) 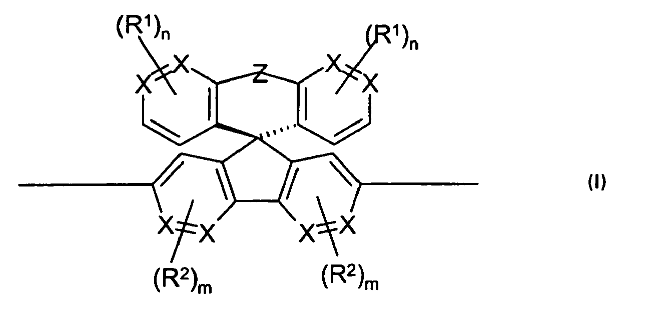 zusätzlich noch ein oder mehrere Einheiten ausgewählt aus folgenden Gruppen 1 bis 4 enthalten,
wobei die Gruppe 1 für Einheiten steht, welche die Lochinjektions- oder
- transporteigenschaften der Polymere deutlich erhöhen und aus den Formeln (II) bis (XI) und (XIII) bis (XIX) ausgewählt sind, 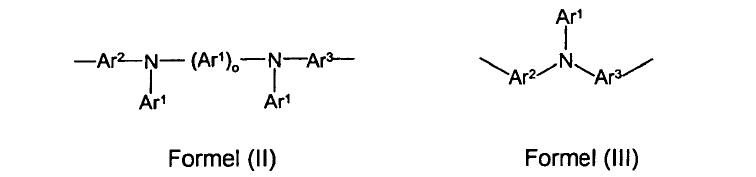 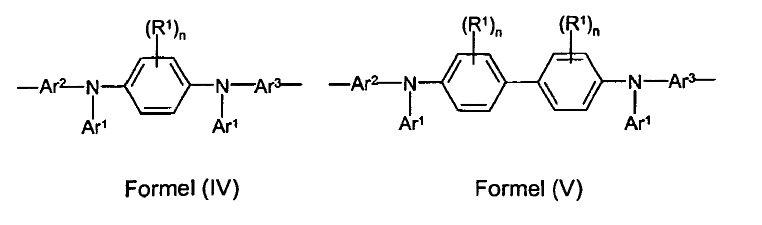 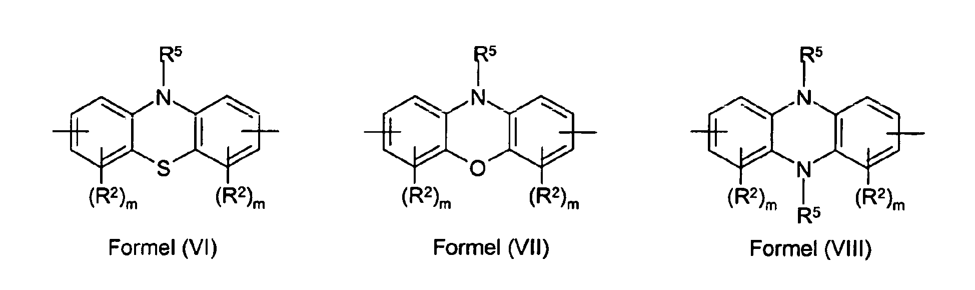 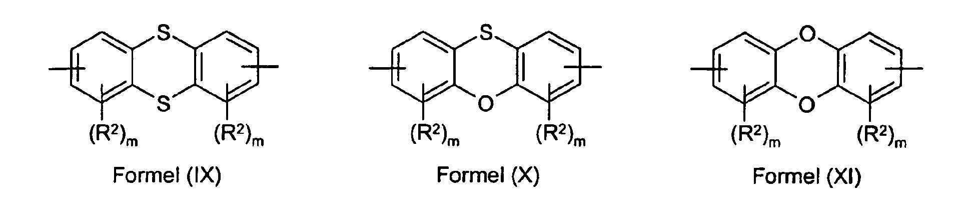 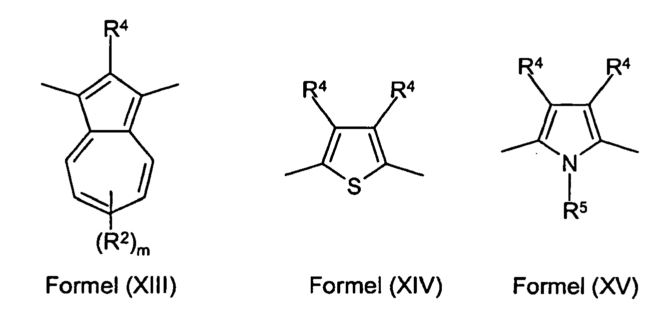 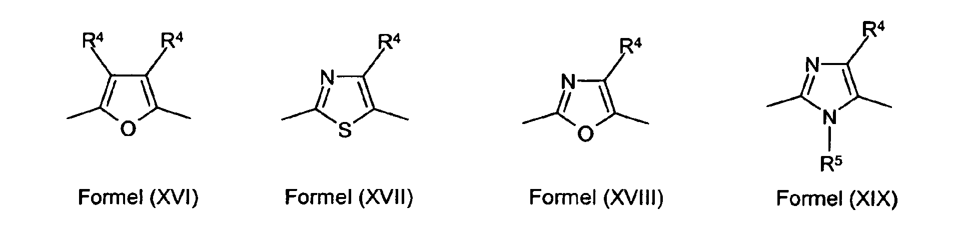
wobei die Symbole
- Ar¹, Ar², Ar³: bei jedem Auftreten gleich oder verschieden aromatischen oder heteroaromatischen Kohlenwasserstoffen mit 2 bis 40 C-Atomen, welche auch mit einem oder mehreren nicht-aromatischen Resten R¹ substituiert sein können, sind;
- o: 1, 2 oder 3 ist;
wobei die Gruppe 2 für Einheiten steht, welche die Elektroneninjektions- oder -transporteigenschaften der Polymere deutlich erhöhen und aus den Formeln (XX) bis (XXX) ausgewählt sind, 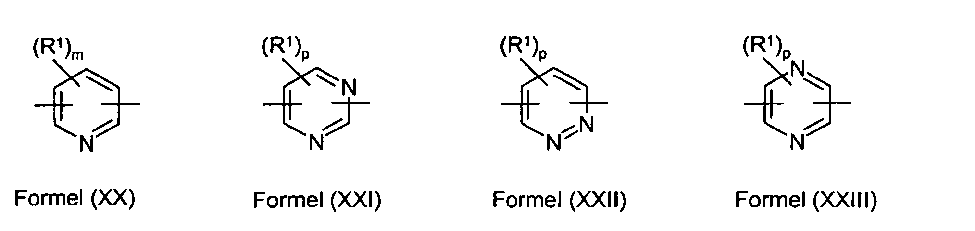 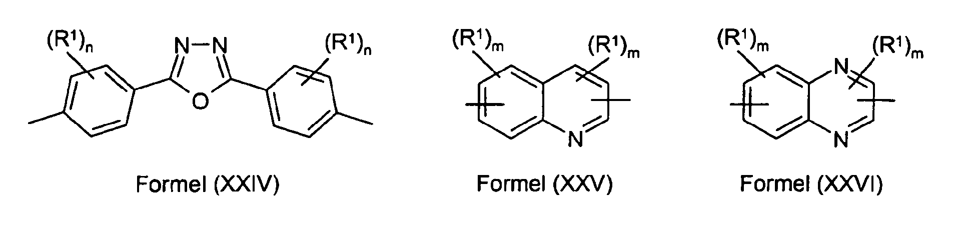 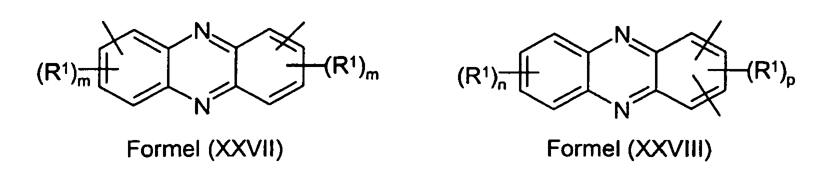 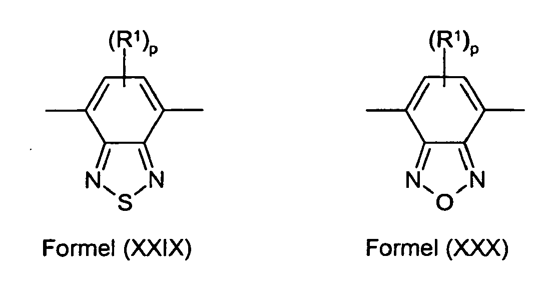 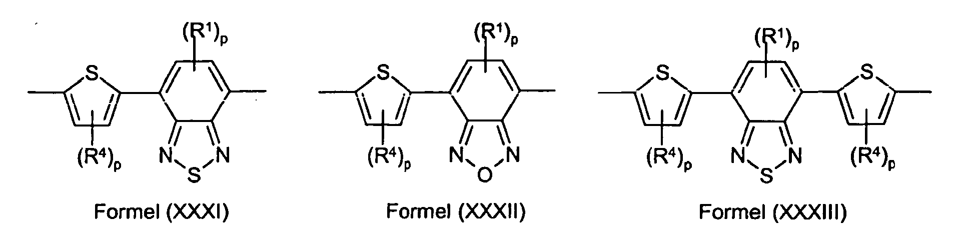 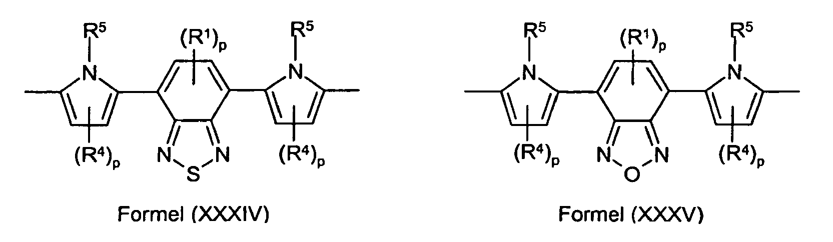 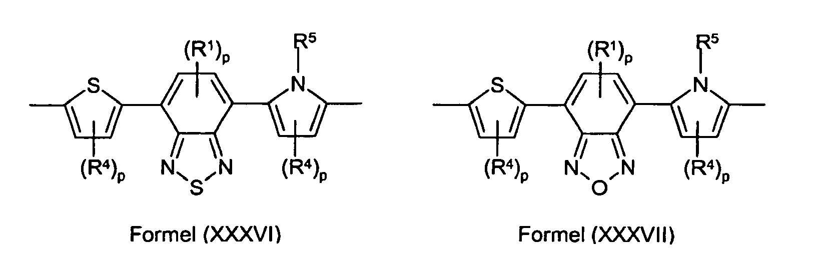 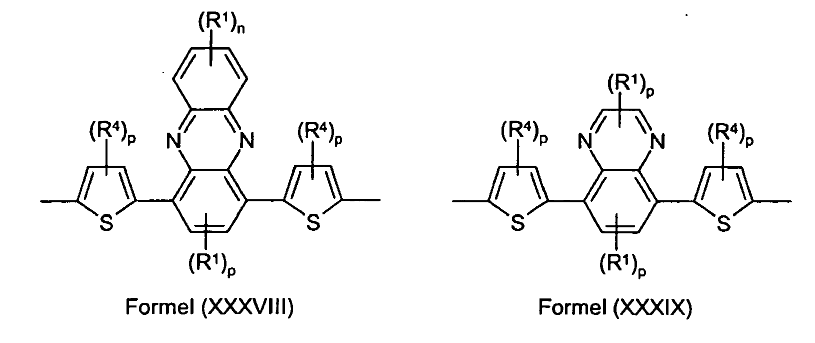 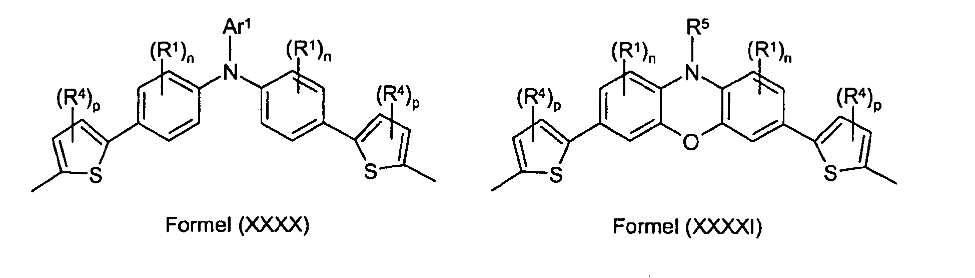 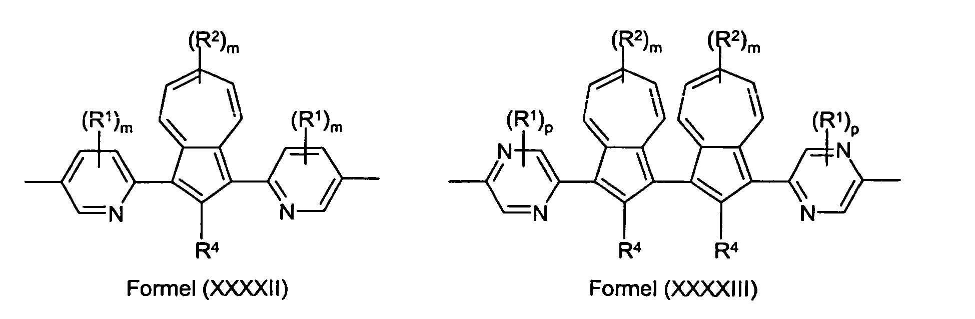 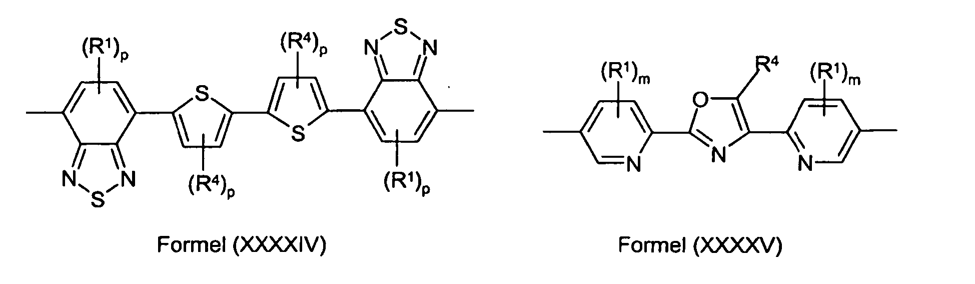 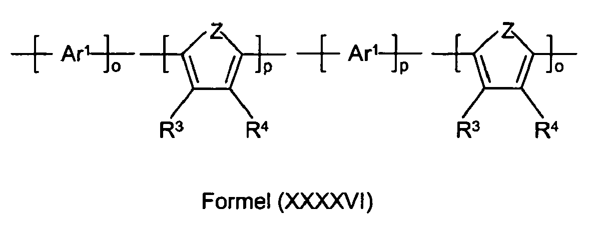 wobei die Symbole
- o: 1, 2 oder 3, bevorzugt 1 oder 2 bedeuten und;
- p: 0, 1 oder 2, bevorzugt 0 oder 1 ist;
wobei die Gruppe 4 für Einheiten steht, welche die Emissionscharakteristik insoweit verändern, daß statt Fluoreszenz Phosphoreszenz erhalten werden kann und aus den Formeln (XXXXVII) bis (XXXXX) ausgewählt sind, 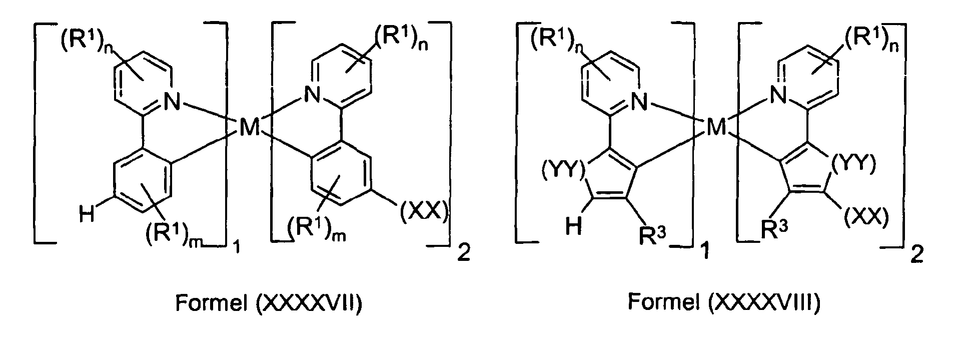 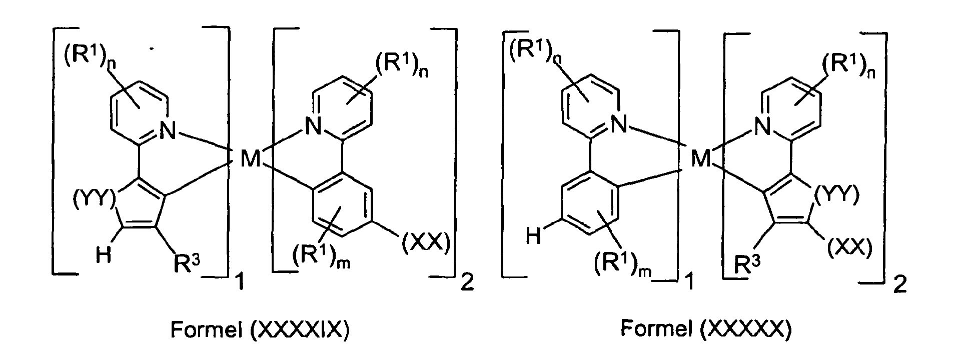 wobei das Symbol
- M: Rh oder Ir entspricht;
- XX: der Verknüpfungsstelle im Polymer entspricht;
- YY: bei jedem Auftreten gleich oder verschieden O, S oder Se ist;
wobei die anderen Symbole und Indizes die folgende Bedeutung haben:
- X: ist bei jedem Auftreten gleich oder verschieden CH, CR¹ oder N,
- Z: ist bei jedem Auftreten gleich oder verschieden einer chemischen Einfachbindung, einer CR³R⁴-Gruppierung, einer -CR³R⁴-CR³R⁴-Gruppierung, einer -CR³=CR⁴-Gruppierung, O, S, N-R⁵, C=O, C=CR³R⁴ oder SiR³R⁴;
- R¹: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryloder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R⁵)₂, N(R⁵)₃⁺ wobei auch zwei oder mehrere Reste R¹ miteinander ein Ringsystem bilden können;
- R²: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryloder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN;
- R³, R⁴: sind bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN; mehrere benachbarte Reste R³ und/oder R⁴ können zusammen auch einen Ring ausbilden;
- R⁵: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
- m: ist bei jedem Auftreten gleich oder verschieden 0, 1, 2, oder 3, bevorzugt 0, 1, oder 2, besonders bevorzugt 0 oder 1;
- n: ist bei jedem Auftreten gleich oder verschieden 0, 1, 2, 3, oder 4, bevorzugt 0, 1, oder 2, besonders bevorzugt 1 oder 2;
mit der Maßgabe, daß der Gesamtanteil der Wiederholeinheiten vom Typ Formel (I) und der Einheiten gemäß aus den Gruppen 1 bis 4 zusammen mindestens 40%, bevorzugt mindestens 60%, besonders bevorzugt mindestens 80% aller Wiederholeinheiten im Polymer ausmachen, und daß dabei das Verhältnis der Wiederholeinheiten vom Typ Formel (I) zur Summe derer aus den Gruppen 1 bis 4 im Bereich von 20:1 bis 1:2, bevorzugt 5:1 bis 1:2, besonders bevorzugt 3:1 bis 1:1 liegt, ausgenommen Polymere, die eine Gruppe der Formel 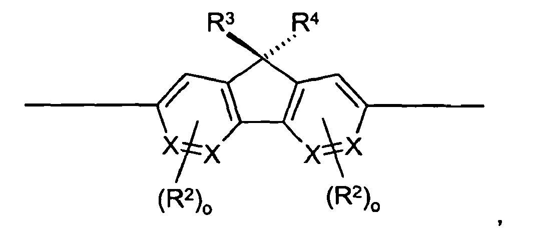 worin die Reste folgende Bedeutungen haben:
- X: ist bei jedem Auftreten gleich oder verschieden CH, CR¹ oder N,
- R¹: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R⁵)₂, wobei auch zwei oder mehrere Reste R¹ miteinander ein Ringsystem bilden können;
- R²: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN;
- R³, R⁴: sind bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN; die beiden Reste R³ und R⁴ können zusammen auch einen Ring ausbilden, der allerdings nicht zu Strukturen gemäß Formel (I) führt;
- R⁵: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
- o: ist bei jedem Auftreten gleich oder verschieden 0, 1, 2, oder 3, bevorzugt 0, 1, oder 2, besonders bevorzugt 0 oder 1,
enthalten.

Bevorzugt sind dabei erfindungsgemäße Polymere, die gleichzeitig neben Struktureinheiten gemäß Formel (I), solche aus mindestens zwei der Gruppen 1 bis 4 vorliegen haben.
Besonders bevorzugt ist hierbei das gleichzeitige Vorhandensein von Einheiten der Gruppen 1 und 2, bzw. 1 und 3, bzw. 1 und 4, bzw. 2 und 3, bzw. 2 und 4, bzw. 3 und 4. Des weiteren bevorzugt ist auch das gleichzeitige Vorliegen von Strukturen aus den Gruppen 1 und 2 und 3, bzw. 1 und 2 und 4, bzw. 2 und 3 und 4.

So ist es ebenfalls besonders bevorzugt, wenn gleichzeitig Einheiten gemäß den Formeln (II) bis (V) und solche gemäß den Formeln (XXIV) bzw. (XXVI) bis (XXX) vorliegen.

So ist es ebenfalls besonders bevorzugt, wenn gleichzeitig Einheiten gemäß den Formeln (II) bis (V) und solche gemäß den Formeln (XXIV) bzw. (XXVI) bis (XXX) vorliegen.

Des weiteren ist es ebenfalls bevorzugt, wenn gleichzeitig mehr als eine Struktureinheit aus einer Gruppe vorliegt. So ist es bevorzugt, wenn gleichzeitig mindestens zwei Struktureinheiten aus der Gruppe 1, bzw. Gruppe 2, bzw. Gruppe 3, bzw. Gruppe 4 vorliegen.

Auch wenn dies aus der Beschreibung hervorgeht, sei hier noch mal explizit darauf verwiesen, daß die Struktureinheiten gemäß Formel (I) unsymmetrisch substituiert sein können, d. h. an einer Einheit unterschiedliche Substituenten R¹ und/oder R² vorhanden sein können, bzw. diese auch unterschiedliche Stellungen auf den jeweils beiden Seiten haben können.

Die Synthese der entsprechenden Monomeren ist z. B. in den oben bereits genannten Anmeldeschriften und Patenten ausführlich beschrieben.
So können beispielsweise Monomere, die dann im Polymer Strukturen gemäß Formel (I) ergeben, gemäß EP-A-0676461, EP-A-0707020, EP-A-0894107 und den darin zitierten Literaturstellen synthetisiert werden.

Die erfindungsgemäßen Polymere sind verschieden gegenüber den bereits bekannten Poly-Spirobifluorenen (gemäß EP-A-0 707 020 und EP-A-0 894 107): In diesen Anmeldungen werden Polymere beschrieben, die zwar Strukturen gemäß der Formel (I) enthalten können, auf die Formel (II) bis (XXXXX) wird jedoch nicht verwiesen. Es werden zwar Copolymere vorgestellt, diese enthalten aber gemäß den Beschreibungen neben Strukturen gemäß Formel (1) hauptsächlich Arylen bzw. Vinylenstrukturen. Das Vorhandensein von Elementen gemäß den Strukturen (II) bis (XXXXX) bringt nun folgende überraschende Vorteile:
(1) Sind Strukturen gemäß den Formeln (II) bis (XIX) vorhanden, ist verbesserte Ladungsinjektion und -transport v. a. für Löcher zu beobachten. Dies führt in der Anwendung dazu, daß bei einer gegebenen Spannung ein höherer Stromfluß und damit auch eine höhere Leuchtdichte erreicht wird. Dies ist v. a. für mobile Applikationen (z. B. Displays für Handys, PDAs, etc.) von entscheidender Bedeutung, da hier die maximale Betriebsspannung begrenzt ist. Weitere Details s. a. Beispiel P1 (Vergleich: V1-V3); auch P2-P19, P21-P23, P25-P32, P34-P41.
(2) Sind Strukturen gemäß den Formeln (XX) bis (XXX) enthalten, ist Analoges für Elektronen beobachtbar. Dies kann ähnliche Vorteile wie unter (1) beschrieben bieten. Sind sowohl Strukturen gemäß (II) bis (XIX) als auch solche gemäß (XX) bis (XXX) vorhanden, kann dies den Effekt noch steigern. Weitere Details s. a. Beispiel P12-P24, P40, P41 (Vergleich: V1-V3).
(3) Strukturen gemäß den Formeln (XXIX) bis (XXXXV) ermöglichen eine Variation des elektronischen Bandabstands, und somit eine Veränderung der Farbeigenschaften. Während in den o. g. Anmeldungen hauptsächlich von blauer Emission gesprochen wird, ist es durch Verwendung dieser Strukturen möglich auch blau-grüne, grüne, gelbe, orange und rote Emission zu erzielen. Weitere Details s. a. P12-P35, P40, P41 (Vergleich: V1).
(4) Die Strukturen gemäß den Formeln (XXXXVII) bis (XXXXX) führen nun dazu, daß eine andere Art von Emission (die sogenannte Phosphoreszenz) auftritt. Diese kann eine höhere Quanteneffizienz ergeben und somit auch zu einer Verbesserung entsprechender Bauteile beitragen.

Die erfindungsgemäßen Polymere weisen in der Regel 10 bis 10000, bevorzugt 50 bis 5000, besonders bevorzugt 50 bis 2000 Wiederholeinheiten auf.

Die nötige Löslichkeit wird v. a. durch die Substituenten R¹, R³ und/oder R⁴ gewährleistet. Falls Substituenten R² vorhanden sind, tragen auch diese zur Löslichkeit bei.
Um ausreichende Löslichkeit zu gewährleisten ist es nötig, daß im Durchschnitt pro Wiederholeinheit mindestens 2 nicht-aromatische C-Atome in den Substituenten vorhanden sind. Bevorzugt sind dabei mindestens 4, besonders bevorzugt mindestens 8 C-Atome. Einzelne dieser C-Atome können auch noch durch O oder S ersetzt sein. Dies kann aber durchaus bedeuten, daß ein gewisser Anteil von Wiederholeinheiten, sowohl gemäß den Formeln (I) bis (XXXXX) als auch anderer Strukturtypen, keine weiteren nicht-aromatischen Substituenten trägt.

Um die Morphologie des Filmes nicht zu verschlechtern ist es bevorzugt, keine langkettigen Substituenten mit mehr als 12 C-Atomen in einer linearen Kette zu haben, bevorzugt keine mit mehr als 8 C-Atome, besonders bevorzugt keine mit mehr als 6 C-Atome.
Nicht-aromatische C-Atome sind, wie in der Beschreibung für bspw. R¹, in entsprechenden geradkettigen, verzweigten oder cyclischen Alkyl- oder Alkoxyketten enthalten.

Bevorzugt sind erfindungsgemäße Polymere bei denen für das Symbol X = C-H oder C-R¹ gilt.
Des weiteren bevorzugt sind erfindungsgemäße Polymere bei denen das Symbol Z für eine chemische Einfachbindung steht.

Bevorzugt sind weiterhin erfindungsgemäße Polymere, bei denen gilt:
- R¹: ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, eine Arylgruppe mit 6 bis 14 C-Atomen, welche auch durch ein oder mehrere nicht-aromatische Reste R¹ substituiert sind.

Besonders bevorzugt sind weiterhin erfindungsgemäße Polymere, bei denen gilt:
- R¹: ist bei jedem Auftreten gleich oder verschieden eine geradkettige oder verzweigte Alkyl- oder Alkoxykette mit 1 bis 8 C-Atomen, oder eine Arylgruppe mit 6 bis 10 C-Atomen, welche auch durch ein oder mehrere nicht-aromatische Reste R¹ substituiert sind;
- n: ist gleich oder verschieden 1 oder 2.

Bevorzugt sind weiterhin erfindungsgemäße Polymere, bei denen gilt:
- R²: ist bei jedem Auftreten gleich oder verschieden eine geradkettige oder verzweigte Alkyl- oder Alkoxykette mit 1 bis 10 C-Atomen, wobei auch ein oder mehrere H-Atome durch Fluor ersetzt sein können, eine Aryl- oder Aryloxygruppe mit 6 bis 14 C-Atomen, welche auch durch ein oder mehrere nicht-aromatische Reste R¹ substituiert sein können, oder CN;
- m: ist bei jedem Auftreten gleich oder verschieden 0 oder 1.

Besonders bevorzugt sind weiterhin erfindungsgemäße Polymere, bei denen gilt:
- R²: ist bei jedem Auftreten gleich oder verschieden eine geradkettige oder verzweigte Alkyl- oder Alkoxykette mit 1 bis 8 C-Atomen, wobei auch ein oder mehrere H-Atome durch Fluor ersetzt sein können, eine Arylgruppe mit 6 bis 10 C-Atomen, welche auch durch ein oder mehrere nicht-aromatische Reste R¹ substituiert sein können;
- m: ist bei jedem Auftreten gleich oder verschieden 0 oder 1, wobei für mindestens 50%, bevorzugt für mindestens 70%, ganz besonders bevorzugt für mindestens 90% aller im Polymer vorhandenen Wiederholeinheiten gemäß Formel **(I) bzw. (VI) bis (XIII)** gilt, daß m gleich 0 ist.

Des weiteren bevorzugt sind erfindungsgemäße Polymere, bei denen gilt:
- R³, R⁴: sind bei jedem Auftreten gleich oder verschieden eine geradkettige, verzweigte oder cyclische Alkylkette mit 1 bis 10 C-Atomen, in der auch ein oder mehrere nicht benachbarte C-Atome durch O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können.

Die erfindungsgemäßen Polymere sind per se Copolymere, die mindestens zwei verschiedene Wiederholeinheiten (eine gemäß Formel (I), eine weitere ausgewählt aus den Formeln (II) bis (XXXXX) besitzen. Die erfindungsgemäßen Copolymeren können nun statistische, alternierende oder auch blockartige Strukturen aufweisen, oder auch mehrere dieser Strukturen abwechselnd besitzen.
Es sind aber auch erfindungsgemäße Copolymere bevorzugt, die ein oder mehrere verschiedene Strukturen gemäß Formel (I) und/oder ein oder mehrere verschiedene Strukturen gemäß den Formeln (II) bis (XXXXX) aufweisen.
Durch das Verwenden mehrerer verschiedener Strukturelemente können Eigenschaften wie Löslichkeit, Festphasenmorphologie, Farbe, Ladungsinjektions-und -transporteigenschaften, Temperaturstabilität, Elektrooptische Charakteristik etc. eingestellt werden.

Bevorzugte erfindungsgemäße Polymere, sind solche, bei denen mindestens ein Strukturelement Ladungstransporteigenschaften aufweist.
Im Sinne dieses Anmeldetextes soll unter solchen Strukturelementen folgendes verstanden werden: würde man aus diesen Strukturelementen HOMOPOLYMERE oder -OLIGOMERE erzeugen, hätten diese - zumindest für einen Ladungsträger, d. h. entweder Elektronen oder Löcher - eine höhere Ladungsträgermobilität, wie dies bei einem Polymer, welches ausschließlich aus Strukturelementen gemäß Formeln (I) besteht, der Fall ist. Bevorzugt ist die Ladungsträgerbeweglichkeit (gemessen in cm²/(V*s)) mindestens einen Faktor 10, besonders bevorzugt mindestens einen Faktor 50 größer.

Strukturelemente, die Lochtransporteigenschaften aufweisen, sind beispielsweise Triarylaminderivate, Benzidinderivate, Tetraarylen-para-phenylendiaminderivate, Phenothiazinderivate, Phenoxazinderivate, Dihydrophenazinderivate, Thianthrenderivate, Benzo-p-dioxinderivate, Phenoxathiinderivate, Carbazolderivate, Azulenderivate, Thiophenderivate, Pyrrolderivate, Furanderivate und weitere O, S oder N-haltige Heterocyclen, mit hochliegenden HOMO (HOMO = höchstliegendes besetztes Molekülorbital); bevorzugt führen diese Heterocyclen zu einem HOMO im Polymer von weniger als 5.8 eV (gegen Vakuumlevel), besonders bevorzugt von weniger als 5.5 eV.

Bevorzugt sind dabei erfindungsgemäße Polymere, die noch mindestens eine Struktureinheit gemäß den Formeln (II) bis (XXX) enthalten. Der Anteil dieser Strukturelemente ist dabei mindestens 1 %, bevorzugt mindestens 5%. Der maximale Anteil ist dabei höchstens 50%, bevorzugt höchstens 30%. Auch diese Struktureinheiten können im Polymer statistisch, alternierend oder blockartig eingebaut sein.

Die Art des Einbaus dieser Strukturen ist bei etlichen schon direkt vorgegeben (siehe z. B. Formeln (II) bis (V) und Formeln (XIII) bis (XIX)). Bei anderen Strukturen sind jeweils mehrere Möglichkeiten erfindungsgemäß. Allerdings gibt es bei diesen auch bevorzugte Einbauweisen:

So ist bei den N-haltigen tricyclischen Heterocyclen (Formeln (VI) bis Formel (VIII)) jeweils die Verknüpfung via C-Atomen in para-Stellung zum Stickstoff (d. h. bei Phenothiazin- und Phenoxazinderivaten: 3,7-Position; bei Dihydrophenazinderivaten: 2,7- bzw. 3,7-Positon) bevorzugt. Analoges gilt auch bei Carbazolderivaten (Formel (XII)). Für die O- und/oder S-haltigen Tricyclen (Formeln (IX) bis (XI)) sind hingegen sowohl ortho- bzw. para-Positionen zu einem der Heteroatome bevorzugt. Bei den Heterocyclen, die mehr als einen Ring enthalten ist jeweils eine Verknüpfung zum Polymer über nur einen oder über zwei Ringe möglich.

Monomere für den Einbau von Struktureinheiten gemäß Formel (II), Formel (III), Formel (IV) und Formel (V) können beispielsweise gemäß WO98/06773 synthetisiert werden.
Monomere für den Einbau von Struktureinheiten gemäß Formel (VI), Formel (VII) und Formel (VIII) können beispielsweise gemäß M. Jovanovic et al., *J. Org. Chem.* **1984,** 49, 1905 und H. J. Shine et al., *J. Org. Chem.* **1979,** 44, 3310 synthetisiert werden.
Monomere für den Einbau von Struktureinheiten gemäß Formel (IX) und Formel (X) können beispielsweise gemäß J. Lovell et al., *Tetrahedron* 1996, 52, 4745,
US-A- 4.505.841 und den darin genannten Literaturstellen synthetisiert werden. Monomere für den Einbau von Struktureinheiten gemäß Formel (XI) können beispielsweise gemäß A. D. Kuntsevich et al., *Zh. Obshch. Khim.* **1994,** 64, 1722 und A. D. Kuntsevich et al., *Dokl. Akad. Nauk* **1993,** 332, 461 synthetisiert werden. Halogenierte Monomere für den Einbau von Struktureinheiten gemäß Formel (XII) sind in großer Breite in der Literatur bekannt und teilweise sogar kommerziell verfügbar. Eine Aufzählung aller möglichen Verfahren würde den Rahmen dieser Anmeldeschrift sprengen.
Monomere für den Einbau von Struktureinheiten gemäß Formel (XIII) können beispielsweise gemäß R. H.Mitchell et al., *Org. Prep. Proced. Int.* **1997,** 29, 715 synthetisiert werden.
Halogenierte Monomere für den Einbau von Struktureinheiten gemäß Formel (XIV) sind in großer Breite in der Literatur bekannt und teilweise sogar kommerziell verfügbar. Eine Aufzählung aller möglichen Verfahren würde den Rahmen dieser Anmeldeschrift sprengen.
Monomere für den Einbau von Struktureinheiten gemäß Formel (XV) können beispielsweise gemäß H. M. Gilow et al., *J. Org. Chem.* 1981, *46,* 2221 und G. A. Cordell, *J*. *Org. Chem.* 1975, 40, 3161 synthetisiert werden.
Monomere für den Einbau von Struktureinheiten gemäß Formel (XVI) können beispielsweise gemäß M. A. Keegstra et al., *Synth. Commun.* **1990,** 20, 3371 und R.Sornay et al., *Bull. Soc. Chim. Fr.* **1971,** 3, 990 synthetisiert werden und sind teilweise auch kommerziell verfügbar.
Monomere für den Einbau von Struktureinheiten gemäß Formel (XVII) sind teilweise kommerziell verfügbar.
Monomere für den Einbau von Struktureinheiten gemäß Formel (XVIII) können beispielsweise gemäß JP 63-250385 synthetisiert werden.
Monomere für den Einbau von Struktureinheiten gemäß Formel (XIX) können beispielsweise gemäß M. El Borai et al., *Pol. J. Chem.* **1981,** *55,* 1659 synthetisiert werden und sind teilweise auch kommerziell verfügbar.
In den hier aufgeführten Literaturstellen zur Synthese von Monomeren, die im Polymer Strukturen gemäß den Formeln (II) bis (XIX) geben, wird hauptsächlich die Synthese von Halogenderivaten, bevorzugt von Brom-derivaten beschrieben. Davon ausgehend, ist es für den Fachmann leicht z. B. Boronsäurederivate bzw. Stannate herzustellen. Dies kann beispielsweise durch Metallierung (z. B. mit Mg (Grignard-Reaktion) oder Li (z. B. durch Bu-Li)) und anschließender Umsetzung mit entsprechenden Bor- oder Zinnderivaten, wie z. B. Borsäuretrialkylestern oder Trialkylzinnhalogeniden geschehen. Es ist aber natürlich auch möglich, Boronsäurederivate aus den entsprechenden Bromiden unter Übergangsmetall-Katalyse und Einsatz von Boranen oder Diboranen zu erzeugen. Weitere literaturbekannte Verfahren sind sehr vielfältig und können vom Fachmann natürlich ebenso verwendet werden.

Strukturelemente,gemäß Gruppe 2, sind beispielsweise Pyridinderivate, Pyrimidinderivate, Pyridazinderivate, Pyrazinderivate, Oxadiazolderivate, Chinolinderivate, Chinoxalinderivate, Phenazinderivate und weitere O, S oder N-haltige Heterocyclen, mit niedrigliegendem LUMO (LUMO = niedrigstes unbesetztes Molekülorbital); bevorzugt führen diese Heterocyclen im Polymer zu einem LUMO von mehr als 2.7 eV (gegen Vakuumlevel), besonders bevorzugt von mehr als 3.0 eV.

Bevorzugt sind dabei erfindungsgemäße Polymere, die noch mindestens eine Struktrureinheit gemäß den Formeln (XX) bis (XXX) enthalten. Der Anteil dieser Strukturelemente ist dabei mindestens 1%, bevorzugt mindestens 5%. Der maximale Anteil ist dabei höchstens 70%, bevorzugt höchstens 50%. Auch diese Struktureinheiten können im Polymer statistisch, alternierend oder blockartig eingebaut sein.

Die Art des Einbaus dieser Strukturen ist bei etlichen schon direkt vorgegeben (siehe z. B. Formeln (XXIV), (XXIX) und (XXX)). Bei anderen Strukturen sind jeweils mehrere Möglichkeiten erfindungsgemäß. Allerdings gibt es bei diesen auch bevorzugte Einbauweisen:
So ist bei Pyridinderivaten die Verknüpfung via 2,5- bzw. 2,6-Position, bei Pyrazin-und Pyrimidinderivaten diejenige via 2,5-Position und bei Pyridazinderivaten diejenige via 3,6-Position bevorzugt.
Bei den bicyclischen Heterocyclen sind in der Regel mehrere Verknüpfungen möglich und auch bevorzugt. Bei Chinoxalin ist jedoch diejenige via 5,8-Position eindeutig bevorzugt.
Bei Phenazin kann es nun - wie angedeutet - sowohl bevorzugt sein, daß die Verknüpfung via den beiden äußeren Ringen erfolgt, oder daß nur an einem Ring eingebaut wird. Bevorzugte Positionen sind dadurch der Einbau am 1,4- bzw. 2,3- bzw. 2,7- bzw. 3,7-Kohlenstoffatom.

Die Chemie von Pyridinderivaten (XX) ist sehr ausführlich untersucht. So ist die Darstellung von 2,5- und 2,6-Dihalogenpyridinen ebenfalls bekannt. Es sei hier auf die zahlreichen Standardwerke der Heterocyclen Chemie verwiesen. Darüber hinaus sind etliche der Verbindungen auch kommerziell verfügbar.
Monomere für den Einbau von Struktureinheiten gemäß Formel (XXI) können beispielsweise gemäß Arantz et al., *J. Chem. Soc. C* **1971,** 1889 synthetisiert werden.

Monomere für den Einbau von Struktureinheiten gemäß Formel (XXII) können beispielsweise gemäß Pedrali et al., *J. Org. Synth.* **1958,** 23, 778 synthetisiert werden.
Monomere für den Einbau von Struktureinheiten gemäß Formel (XXIII) können beispielsweise gemäß Ellingson et al., *J*. *Am. Chem. Soc.* 1949, 71, 2798 synthetisiert werden.
Monomere für den Einbau von Struktureinheiten gemäß Formel (XXIV) können beispielsweise gemäß Stolle et al., *J. Prakt. Chem.* 1904, *69,* 480 synthetisiert werden.
Monomere für den Einbau von Struktureinheiten gemäß Formel (XXV) können beispielsweise gemäß Metzger, *Chem. Ber.* **1884,** *17*, 187 und A. I. Tochilkin et al., *Chem. Heterocycl. Compd. (Engl. Transl)* **1988,** 892 synthetisiert werden. Monomere für den Einbau von Struktureinheiten gemäß Formel (XXVI) können beispielsweise gemäß Calhane et al., *J*. *Am. Chem. Soc.* 1899, 22, 457 und T. Yamamoto et al., *J*. *Am. Chem. Soc.* 1996, 118, 3930 synthetisiert werden. Monomere für den Einbau von Struktureinheiten gemäß Formel (XXVII) und (XXVIII) können beispielsweise gemäß L. Horner et al., *J. Liebigs Ann. Chem.,* **1955,** 597, 1 und P. R. Buckland et al., *J. Chem. Res. Miniprint* **1981,** *12,* 4201 synthetisiert werden.
Monomere für den Einbau von Struktureinheiten gemäß Formel (XXIX) können beispielsweise gemäß K. Pilgram et al., *J. Heterocycl. Chem.* **1970,** 7, 629 und WO 00/55927 synthetisiert werden.
Monomere für den Einbau von Struktureinheiten gemäß Formel (XXX) können beispielsweise gemäß Hammick et al., *J. Chem. Soc.* **1931,** 3308 und K. Pilgram et al., *J*. *Heterocycl. Chem.* **1974**, 11, 813 synthetisiert werden.
Auch in den hier aufgeführten Literaturstellen zur Synthese von Monomeren, die im Polymer Strukturen gemäß den Formeln (XX) bis (XXX) geben, wird hauptsächlich die Synthese von Halogenderivaten, bevorzugt von Brom-derivaten beschrieben. Davon ausgehend, kann der Fachmann, wie auch oben bei den die Lochmobilität erhöhenden Einheiten beschrieben, weitere Umwandlungen, z. B. zu Boronsäurederivaten oder Stannaten, vornehmen.

Bevorzugt sind weiterhin auch erfindungsgemäße Polymere, bei denen Einheitengemäß Gruppe 3 enthalten sind.
Besonders bevorzugt sind demgemäß erfindungsgemäße Polymere, die sowohl ein oder mehrere Strukturen gemäß den Formeln (II) bis (XIX), als auch ein oder mehrere Strukturen gemäß den Formeln (XX) bis (XXX) enthalten.
Dabei sollen weiterhin die o. g. Grenzen für den jeweiligen Anteil gelten.
Es kann dabei ganz besonders bevorzugt sein, daß man in den erfindungsgemäßen Polymeren Einheiten hat, in denen Lochbeweglichkeit- und Elektronenbeweglichkeiterhöhende Strukturen direkt aufeinanderfolgen bzw. sich abwechseln, wie dies beispielsweise für die Formeln (XXXI) bis (XXXXV) der Fall ist, und etwas allgemeiner für die Formel (XXXXVI) angegeben ist.

Monomere gemäß den Formeln (XXXI) bis (XXXXVI) lassen sich gemäß den für die Formeln (III) bis (XXX) gemachten Angaben durch entsprechende Kombination der entsprechenden Vorstufen synthetisieren. Es sei auch darauf verwiesen, daß zumindest einige Synthesebeispiele in den oben bereits genannten Anmeldungen WO 00/46321 und WO 00/55927 aufgeführt sind. Weiterhin wird auch beispielsweise in H. A. M. Mullekom et al., *Chem. Eur. J.,* **1998,** 4, 1235 von derartigen Strukturen berichtet. Es sei darauf verwiesen, daß die Strukturen gemäß den Formeln (XXXI) bis (XXXXVI) keineswegs die Erfindung darauf begrenzen soll, sondern daß es natürlich für den Fachmann ein leichtes ist, aus den o. g. Strukturen (III) bis (XIX) bzw. (XX) bis (XXX) geeignete Kombinationen zu synthetisieren und diese in die erfindungsgemäßen Polymere zu inkorporieren.

Bevorzugt sind weiterhin Copolymere, deren Emissionscharakteristik insoweit verändert ist, daß statt Fluoreszenz Phosphoreszenz stattfindet. Dies ist insbesondere der Fall, wenn metallorganische Komplexe in die Hauptkette inkorporiert haben. Besonders bevorzugt sind dabei Komplexe der d-Übergangsmetalle, ganz besonders solche der höheren Metalle der Eisen-, Cobalt-und Nickeltriade, d. h. Komplexe von Ruthenium, Osmium, Rhodium, Iridium, Palladium und Platin. Derartige Komplexe sind häufig in der Lage, aus angeregten Triplett-Zuständen Licht zu emittieren, was häufig eine Steigerung der Energieeffizienz bewirkt. Die Verwendung derartiger Komplexe in niedermolekularen OLEDs ist beispielsweise in M. A. Baldo, S. Lamansky, P. E. Burrows, M. E. Thompson, S. R. Forrest, Applied Physics Letters, 1999, 75, 4-6 beschrieben. Über den Einbau dieser Verbindungen in Polymere wurde bislang noch nichts berichtet. Entsprechende Monomere sind in der noch nicht offengelegten Anmeldeschrift DE 10109027.7 beschrieben. Derartige Strukturelemente können die Morphologie aber auch in besonderem Maße die Emissionsfarbe und die Energieeffizienz der resultierende Polymere beeinflussen.
Als Beispiele für besonders bevorzugte Komplexe, die in erfindungsgemäße Polymere eingebaut werden können, seien hier die o. g. Verbindungen gemäß den Formeln (XXXXVII) bis (XXXXX) genannt.
Die Herstellung entsprechender Monomere ist in der o. g. nicht offengelegten Anmeldeschrift DE 10109027.7 ausgeführt; diese wird via Zitat als Bestandteil der vorliegenden Erfindung betrachtet.

Bevorzugte Copolymere, die noch weitere Strukturelemente neben denen gemäß Formel (I) und Formeln (II) bis (XXXXX) enthalten, sind des weiteren solche, die mindestens noch eine weitere aromatische oder eine andere konjugierte Struktur aufweisen, welche nicht unter die o. g. Gruppen fällt, d. h. die die Ladungsträgermobilitäten nicht oder nur wenig beeinflußt bzw. keine metallorganischen Komplexe darstellt. Derartige Strukturelemente können die Morphologie, aber auch die Emissionsfarbe der resultierende Polymere beeinflußen.

Bevorzugt sind dabei aromatische Strukturen, die 6 bis 40 C-Atome aufweisen oder auch Stilben- oder Bisstyrylarylenderivate, die jeweils mit einem oder mehreren nicht aromatischen Resten R¹ substituiert sein können.
Besonders bevorzugt ist dabei der Einbau von 1,4-Phenylen-, 1,4-Naphthylen-, 1,4-oder 9,10-Anthracenylen-, 1,6- oder 2,7- oder 4,9-Pyren-, 3,9- oder 3,10- Perylen-, 2,7- oder 3,6-Phenanthren-, 4,4'-Biphenylen-, 4,4"-Terphenylen-, 4,4'-Bi-1,1'-naphthylen-, 4,4'-Stilben- oder 4,4"-Bisstyrylarylenderivate.
Diese Strukturen sind auch in den eingangs zitierten Anmeldeschriften EP-A-0 707 020 und EP-A-0 894 107 aufgeführt, im Gegensatz zu den dortigen Angaben werden diese in die hier vorliegenden erfindungsgemäßen Polymere nur als zusätzliche Möglichkeiten, um weitere Modifikationen zu gestatten, eingeführt.
Derartige Strukturen sind vielfach in der Literatur bekannt und zum großen Teil auch kommerziell verfügbar. Eine Aufführung aller möglichen Synthesevarianten würde den Rahmen dieser Anmeldeschrift deutlich sprengen.

Die erfindungsgemäßen Polymere werden nun in der Regel durch Polymerisation von zwei oder mehreren Monomeren, von den mindestens eines anschließend Strukturen der Formel (I) und mindestens ein weiteres ausgewählt aus den Formeln (II) bis (XXXXX) ergibt, hergestellt.
Entsprechende Polymerisationsreaktionen gibt es prinzipiell relativ viele verschiedene, es haben sich jedoch die im folgenden aufgeführten Typen besonders bewährt. Grundsätzlich ergeben all diese Reaktionstypen C-C-Verknüpfungen:
(A) Polymerisation gemäß SUZUKI: Hierbei werden als Monomere zum einen Bishalogenide, zum anderen Bisboronsäuren und entsprechende -derivate, oder entsprechende Monohalogenid-monoboronsäurederivate, eingesetzt und unter Palladiumkatalyse, in Anwesenheit von Lösemitteln und basischen Bedingungen gekuppelt. Derartige Reaktionen, welche zu konjugierten Polymeren führen, sind bereits vielfach beschrieben. Es gibt eine ganze Reihe von Vorschlägen, wie derartige Reaktionen effizient ablaufen und zu hochmolekularen Polymeren führen; diese sind u. a. in den folgenden Stellen aufgeführt: (i) EP 707.020, (ii) EP 842.208, (iii) EP 1.025.142, (iv) WO 00/53656, und (v) in den darin zitierten Literaturstellen. Die entsprechenden Beschreibungen werden hiermit via Zitat als Bestandteil der Anmeldung erachtet.
(B) Polymerisationen gemäß YAMAMOTO: Hierbei werden als Monomere ausschließlich Bishalogenide verwendet. Diese werden in Anwesenheit von Lösemitteln, einer Nickel-verbindung, **eventuell** einer Base und gegebenenfalls eines Reduktionsmittels sowie weiterer Liganden durchgeführt. Derartige Reaktionen, welche zu konjugierten Polymeren führen, sind bereits öfters beschrieben. Es gibt einige Vorschläge, wie derartige Reaktionen effizient ablaufen und zu hochmolekularen Polymeren führen; diese sind u. a. in den folgenden Stellen aufgeführt: (i) M. Ueda et al., *Macromolecules,* 1991, 24, 2694, (ii) T. Yamamoto et al., *Macromolecules* **1992**, 25, 1214, (iii) T. Yamamoto et al., *Synth. Met.* **1995,** 69, 529-31, (iv) T. Yamamoto et al., *J*. *Organometallic Chem.* **1992,** 428, 223, (v) I. Colon et al., *J. Poly. Sci.: Part A: Poly. Chem.* **1990,** *28,* 367, (vi) T. Yamamoto et al., *Macromol. Chem. Phys.* **1997,** *198,* 341. Die entsprechenden Beschreibungen werden hiermit via Zitat als Bestandteil der Anmeldung erachtet.
(C) Polymerisationen gemäß STILLE: Hierbei werden als Monomere zum einen Bishalogenide, zum anderen Bisstannane, oder entsprechende Monohalogenidmonostannane, eingesetzt und unter Palladiumkatalyse, in Anwesenheit von Lösemitteln und **eventuell** basischen Bedingungen gekuppelt. Derartige Reaktionen, welche zu konjugierten Polymeren führen, sind bereits beschrieben. Es gibt hier allerdings noch nicht so weite Ausarbeitungen, wie dies im Falle der SUZUKI- oder YAMAMOTO-Kupplung der Fall ist. Ein konjugiertes Polymer, welches durch STILLE-Kupplung erhalten wurde, wird z. B. in W. Schorf et al., *J. Opt. Soc. Am. B* **1998**, 15, 889 beschrieben. Eine Übersicht über die Möglichkeiten und die Schwierigkeiten der STILLE-Reaktion gibt u. a. V. Farina, V. Krishnamurthy, W. J. Scott (Hers.) "The Stille Reaction" 1998, Verlag: Wiley, New York, N. Y. Die entsprechenden Beschreibungen werden hiermit via Zitat als Bestandteil der Anmeldung erachtet.

Nach der durchgeführten Polymerisation (Polykondensation) müssen die synthetisierten Polymere zunächst vom Reaktionsmedium abgetrennt werden. Dies geschieht in der Regel durch Ausfällen in einem Nicht-Lösemittel. Anschließend müssen die erhaltenen Polymere aufgereinigt werden, da gerade der Gehalt an organischen niedermolekularen Verunreinigungen und auch der lonengehalt bzw. Gehalt an sonstigen anorganischen Verunreinigungen teilweise sehr starke Auswirkungen auf die Anwendungseigenschaften der Polymere in PLEDs haben. So können niedermolekulare Bestandteile zum einen die Effizienz erheblich absenken, aber auch die operative Lebensdauer dramatisch verschlechtern. Analoges gilt für die Anwesenheit von anorganischen Verunreinigungen.
Geeignete Reinigungsverfahren sind zum einen Umfällvorgänge, bei denen das Polymer mehrfach gelöst und in einem Nicht-Lösemittel gefällt wird. Es ist dabei sinnvoll, die Polymerlösung über einen Filter zu geben, um von ungelösten Bestandteilen (Gelpartikel) und auch Staubpartikeln abzutrennen. Eine weitere Möglichkeit ist das Verwenden von Ionenaustauschern, um den Gehalt an Ionen zu erniedrigen. Hierbei kann auch das Ausrühren einer Polymerlösung mit einer wässrigen Lösung, welche z. B. chelatisierende Liganden enthält, helfen. Auch weitere organische oder anorganische Extraktionsverfahren, z. B. mit Lösemittel /Nicht-Lösemittelgemischen, oder mit überkritischem CO₂ können hier deutliche Verbesserungen bringen.

Die so erhaltenen erfindungsgemäßen Polymere können nun in PLEDs verwendet werden. Dazu wird in der Regel folgendes allgemeine Verfahren verwendet, daß natürlich für den Einzelfall dann entsprechend anzupassen ist:
- Ein Substrat (z. B. Glas oder auch ein Kunststoff, wie speziell behandeltes PET) wird mit einem transparenten Anodenmaterial beschichtet (beispielsweise Indium-Zinn-Oxid, ITO); anschließend wird die Anode (z. B. photolithografisch) der gewünschten Anwendung gemäß strukturiert und verschaltet. Es kann hier auch sein, daß das ganze Substrat und die entsprechende Verschaltung zunächst über einen recht aufwendigen Prozeß erzeugt wird, um dadurch eine sogenannte Aktiv-Matrix-Steuerung zu ermöglichen.
- Anschließend wird entweder vollflächig, oder nur auf die aktiven (= anodischen) Stellen i. d. R. zunächst ein leitfähiges Polymer, z. B. ein dotiertes Polythiophen-oder Polyanilinderivat, aufgebracht. Dies erfolgt in aller Regel durch Beschichtungsverfahren, welche eine Dispersion des entsprechenden Polymers aufbringen. Hierzu eignen sich prinzipiell die weiter unten für das lichtemittierende Polymer beschriebenen Verfahren. Die Schichtdicke dieser Polymerlage kann in weiten Bereichen variieren, wird aber für die praktische Anwendung im Bereich zwischen 10 und 1000 nm, bevorzugt zwischen 20 und 500 nm liegen.
- Darauf bringt man dann, je nach Anwendung, eine Lösung eines erfindungsgemäßen Polymers auf. Für mehr- oder vollfarbige Anzeigeelemente (Displays) werden dann mehrere verschiedene Lösungen in verschiedenen Regionen aufgebracht, um entsprechende Farben zu erzeugen.
   Die erfindungsgemäßen Polymeren werden dazu zunächst einzeln (es kann auch empfehlenswert sein, Blends von zwei oder mehr Polymeren zu verwenden) in einem Lösemittel oder Lösemittelgemisch gelöst, eventuell mechanisch nachbehandelt und schließlich filtriert. Da die organischen Polymere und v. a. die Grenzschichten (Interface) in der PLED teilweise extrem durch Sauerstoff oder andere Luftbestandteile beeinflußt werden, empfiehlt es sich, diese Operation unter Schutzgas durchzuführen. Als Lösemittel eignen sich aromatische Flüssigkeiten wie beispielsweise Toluol, Xylole, Anisol, Chlorbenzol, aber auch andere, wie beispielsweise cyclische Ether (z. B. Dioxan, Methyldioxan) oder auch Amide, wie beispielsweise NMP oder DMF, aber auch Lösemittelgemische, wie diese in der nicht offengelegten Anmeldeschrift DE 10111633.0 beschrieben werden.
   Mit diesen Lösungen können nun die vorher beschriebenen Träger beschichtet werden, und zwar entweder ganzflächig z. B. durch Spin-Coat-Verfahren oder Rackel-Techniken, oder aber auch aufgelöst durch Druckverfahren, wie Tintenstrahldrucken, Off-Set-Drucken, Screen-Printing-Verfahren, Tiefdruckverfahren, und ähnlichen.
   Diese o. g. Lösungen sind neu und damit ebenfalls Gegenstand der vorliegenden Erfindung.
- Auf diese Polymerschichten können nun wahlweise noch Elektroneninjektionsmaterialien aufgebracht werden, z. B. durch Aufdampfen, oder auch aus Lösung, durch Methoden, wie diese für die emittierenden Polymere beschrieben wurden. Als Elektroneninjektionsmaterialien können beispielsweise niedermolekulare Verbindungen, wie Triarylboranverbindungen oder auch Aluminium-trishydroxychinolinat (Alq₃), aber auch entsprechende Polymere, wie beispielsweise Poly-pyridinderivate und ähnliche, verwendet werden. Es ist auch möglich, dünne Schichten des emittierenden Polymers durch entsprechendes Dotieren, zu Elektroneninjektionsschichten umzuwandeln.
- Daran anschließend wird eine Kathode aufgedampft. Dies erfolgt i. d. R. durch einen Vakuumprozeß und kann beispielsweise sowohl durch thermisches Bedampfen als auch durch Plasmaspritzen (Sputtern) geschehen. Die Kathode kann dabei vollflächig oder auch durch eine Maske strukturiert aufgebracht werden. Als Kathode werden i. d. R. Metalle mit geringer Austrittsarbeit, z. B. Alkali-, Erdalkali- und f-Übergangsmetalle, wie z. B. Li, Ca, Mg, Sr, Ba, Yb, Sm, oder auch Aluminium, oder auch Legierungen von Metallen, oder auch mehrlagige Strukturen mit verschiedenen Metallen verwendet. Bei letzterem können auch Metalle mitverwendet werden, die eine relativ hohe Austrittsarbeit aufweisen, wie z. B. Ag. Es kann auch bevorzugt sein, zwischen das Metall und das emittierende Polymer bzw. die Elektroneninjektionsschicht, eine sehr dünne dielektrische Schicht (z. B. LiF oder ähnliches) einzubringen. Die Kathoden sind i. d. R. zwischen 10 und 10000 nm, bevorzugt zwischen 20 und 1000 nm, dick.
- Anschließend werden die so erzeugten PLEDs bzw. Displays entsprechend angeschlossen und verkapselt um dann getestet oder verwendet zu werden.

Wie oben beschrieben, eignen sich die erfindungsgemäßen Polymere ganz besonders als Elektroluminszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, daß die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

PLEDs finden z.B. Anwendung als selbstleuchtende Anzeigeelemente, wie Kontrollampen, alphanumerische Displays, mehr- oder vollfarbigen Displays, Hinweisschilder, und in optoelektronischen Kopplern.

Im vorliegenden Anmeldetext und auch in den im weiteren folgenden Beispielen wird auf die Verwendung erfindungsgemäßer Polymere oder Blends aus erfindungsgemäßen Polymeren in Bezug auf PLEDs und den entsprechenden Displays abgezielt. Trotz dieser Beschränkung der Beschreibung ist es für den Fachmann ohne weiteres erfinderisches Zutun möglich, die erfindungsgemäßen Polymere auch für weitere Verwendungen in anderen elektronischen Devices (Vorrichtungen) zu benutzen, z. B. für Organische Integrierte Schaltungen (O-ICs), in Organischen Feld-Effekt-Transistoren (OFETs), in Organischen Dünnfilmtransistoren (OTFTs), für Organische Solarzellen (O-SCs) oder auch Organische Laserdioden (O-Laser), um nur einige Anwendungen zu nennen.

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße Lösungen bereiten und diese anwenden, um daraus Schichten zu erzeugen.

### Teil A: Synthese der Monomere:

### A1: Monomere für Einheiten gemäß Formel (I) (Spiro-Verbindungen)

### A1.1. Herstellung symmetrischer Spiro-Monomere

*Herstellung von 2,7-Dibromo-2',3',6',7'-tetra(2-methylbutyloxy)spirobifluoren **(S-SY1)** und 2',3',6',7'-Tetra(2-methylbutyloxy)spirobifluoren-2,7-bisboronsäureethylenglycolester **(S-SY2)** Herstellung von 2,7-Dibrom-2',7'-di-tert-butyl-spirobifluoren **(S-SY3)** Herstellung von 2',7'-Di-t-butyl-spirobifluoren-2,7-bisboronsäureglycolester **(S-SY4)***

Die Synthese ist in der nicht-offengelegten deutschen Anmeldeschrift DE 10114477.6 beschrieben.

### A1.2. Herstellung unsymmetrischer Spiro-Monomere

Die Herstellung der unsymmetrischen Spirobifluorenmonomere wurde nach dem folgenden Schema durchgeführt:

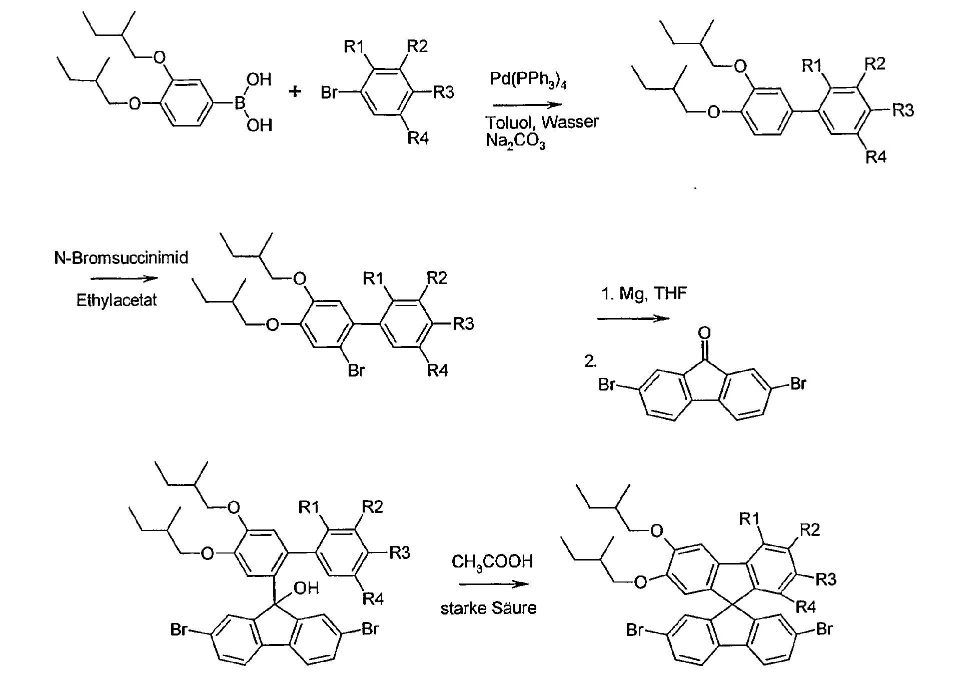

Für Monomer ***S-US1*** wird die Synthese ausführlich beschrieben, die weiteren Monomere sind analog dazu hergestellt worden.

Herstellung von 2,7-Dibromo-8'-*t*-butyl-5'-(4"-*t*-butylphenyl)-2',3'-bis(2-methylbutyloxy)spirobifluoren **(S-US1)**

### Darstellung von 5'-t-Butyl-2'-(4"-t-butylphenyl)-2,3-bis(2-methylbutyloxy)biphenyl

205.5 g (0.595 mol) 2-Brom-4,4'-di-*t*-butylbiphenyl, 188.7 g (0.641 mol) 3,4-Bis(-2-methylbutyloxy)benzolboronsäure und 177.2 g (1.282 mol) K₂CO₃ wurden in 840 mL Toluol und 840 mL H₂O suspendiert und 1 Stunde mit N₂ gesättigt. Anschließend wurde unter Schutzgas 1.48 g (1.28 mmol) Pd(PPh₃)₄ zugegeben und das Gemisch für ca. 8 h unter Schutzgasüberlagerung bei Rückfluss kräftig gerührt. Es wurden 630 mL 1%ige NaCN-Lösung zugegeben und für 2 h gerührt.
Die organische Phase wurde dreimal mit Wasser nachgewaschen, über Na₂SO₄ getrocknet, filtriert und anschließend am Rotationsverdampfer vollständig eingeengt.

Man erhielt 300.2 g (98%) eines leicht braunen Öls, welches It. ¹H NMR 97%ig war und direkt in die Folgereaktion eingesetzt wurde.
¹H NMR (CDCl₃, 500 MHz): [ppm] = 7.5-7.3 (m, 3 H); 7.23 (m, 2 H); 7.08 (m, 2H); 6.81-6.87 (m, 2H); 6.51 (d, 1 H); 3.87-3.7 (m, 2H, OCH₂); 3.44-3.30 (m, 2H, OCH₂); 1.88 (m, 1H, H-C); 1.71 (m, 1 H, H-C); 1.62-1.42 (m, 2H, CH₂); 1.39 (s, 9H, C(CH₃)₃); 1.29 (s, 9H, C(CH₃)₃); 1.10-1.33 (m, 4H, CH₂); 1.07-0.83 (m, 12 H, 4 x CH₃).

### Darstellung von 2-Bromo-5'-t-butyl-2'-(4"-t-butylphenyl)-4,5-bis(2-methylbutyloxy)biphenyl

300.2 g (0.583 mol) 5'-*t*-Butyl-2'-(4"-t-butylphenyl)-2,3-bis(2-methylbutyloxy)biphenyl wurden in 500 mL Ethylacetat unter Schutzgas gelöst und auf 0 °C gekühlt. Danach wurden 103.8 g (0.583 mol) N-Bromsuccinimid als Feststoff zugegeben und auf Raumtemperatur erwärmt. Die Umsetzung war nach 1 h abgeschlossen. Die organische Phase wurde dreimal mit Wasser gewaschen, getrocknet, einrotiert und anschliessend aus Ethanol umkristallisiert. Man erhielt 294.1 g (85%) eines farblosen Feststoffes, welcher lt. ¹H-NMR eine Reinheit von >99% und lt. HPLC von 99.7% aufwies.
¹H NMR (CDCl₃, 500 MHz): [ppm] = 7.45-7.35 (m, 3 H); 7.19 (m, 2 H); 7.06 (m, 3H); 6.50 (d, 1 H); 3.87-3.70 (m, 2H, OCH₂); 3.55-3.25 (m, 2H, OCH₂); 1.88 (m, 1 H, H-C); 1.67 (m, 1 H, H-C); 1.62-1.42 (m, 1 H, CH₂); 1.38 (s+m, 10H, C(CH₃)₃+1H); 1.27 (s+m, 10H, C(CH₃)₃+1 H); 1.15 (m, 1 H, CH₂); 1.12 (d, 3H, CH₃); 0.95 (t, 3H, CH₃); 0.9-0.8 (m, 6H, 2 x CH₃).

### Darstellung von 2,7-Dibromo-8'-t-butyl-5'-(4"-t-butylphenyl)-2',3'-bis(2-methylbutyloxy)spirobifluoren, (S-US1)

294 g (0.495 mol) 2-Bromo-5'-t-butyl-2'-(4"-t-butylphenyl)-4,5-bis(2-methylbutyloxy)biphenyl wurden in 700 mL destilliertem THF gelöst. 12.4 g (0.510 mol) Magnesiumspäne sowie einige Kristalle Jod wurden in einem unter Schutzgas gelagerten Kolben vorgelegt. Es wurde kurz erhitzt und 10% der Eduktmenge in THF zugegeben. Nach dem Anspringen der Reaktion gab man den Rest so zu, daß das Reaktionsgemisch ohne weitere Wärmezuführung von selbst am Rückfluß siedete (eine Stunde). Man ließ weitere 3 h refluxieren und gab danach noch weitere 100 mL destilliertes THF zu. Eine Suspension von 189.7 g (561.2 mmol) 2,7-Dibromfluoren-9-on in 500 mL destilliertem THF wurde auf 0 °C abgekühlt. Die Grignardlösung wurde nun bei einer Temperatur von 0-5 °C zu der Suspension getropft. Anschließend wurde für 90 min unter Rückfluß erhitzt. Nach Kühlung auf Raumtemperatur wurde das Reaktionsgemisch mit einer Mischung aus 600 mL Eiswasser, 33.2 mL HCl und 900 mL Ethylacetat versetzt und die organische Phase je zweimal mit NaHCO₃-Lösung und Wasser gewaschen, anschließend getrocknet und einrotiert.Dieses leicht braune Öl wurde mit 3000 mL Eisessig und 21 mL 37%iger Salzsäure unter Schutzgas zum Sieden erhitzt, wobei ein farbloser Niederschlag ausfiel. Es wurde noch 2 h erhitzt, auf RT abgekühlt, der Feststoff abgesaugt und mit 1500 mL Eisessig nachgewaschen. Nach einmaliger Umkristallisation aus 2-Butanon ergaben sich 310.1 g (75%) des Produktes, welches eine Reinheit lt. ¹H-NMR von >99.5% und lt. HPLC von 99.8% aufwies.
¹H NMR (CDCl₃, 500 MHz): [ppm] = 7.67 (d, 2H); 7.55 (d, 2H); 7.53-7.43 (m, 5H); 7.26 (d, 1 H); 6.97 (s, 1 H); 6.27 (s, 1 H); 5.60 (s, 1 H), 3.40-3.21 (m, 4H, OCH₂); 1.67-1.55 (m, 2H, H-C); 1.42 (s+m, 11 H, C(CH₃)₃+2H); 1.19-1-01 (m, 2H); 1.27 (s+m, 10H, C(CH₃)₃+1 H); 1.15 (m, 1 H, CH₂); 1.12 (d, 3H, CH₃); 0.95 (t, 3H, CH₃); 0.82 (s+m, 21 H, 1 x C(CH₃)₃ + 4 x CH₃).

Die weiteren Monomere sind in der folgenden Tabelle zusammengefaßt:

| Monomer | Ausgangs-Arylbromid | Gesamtausbeute nach obigem Schema [%] | Reinheit It. HPLC [%] |
|---|---|---|---|
| **S-US1** | 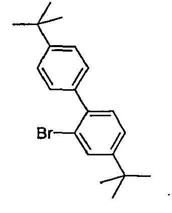 | 62.5 | 99.8 |
| **S-US2** | 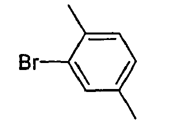 | 60.3 | 99.6 |
| **S-US3** | 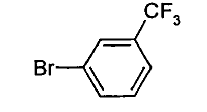 | 27.8 | 99.8 (als Mischung aus 2 Isomeren ca. 70/30) |
| **S-US4** | 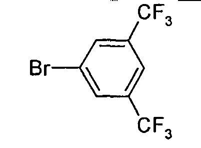 | 44.2 | 99.3 |

Zum Überblick werden die Monomere gemäß Formel (I), deren Herstellung hier ausgeführt ist, in der folgenden Übersicht zusammengefaßt:

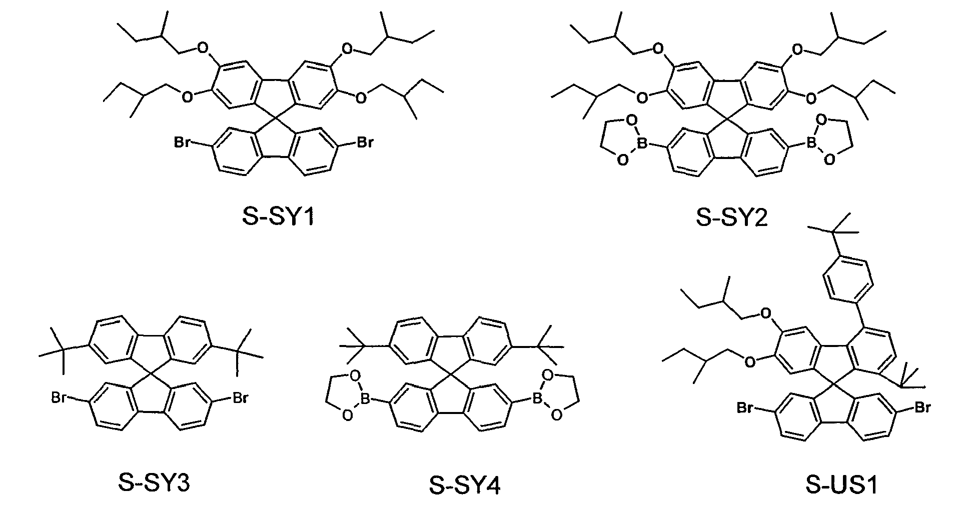

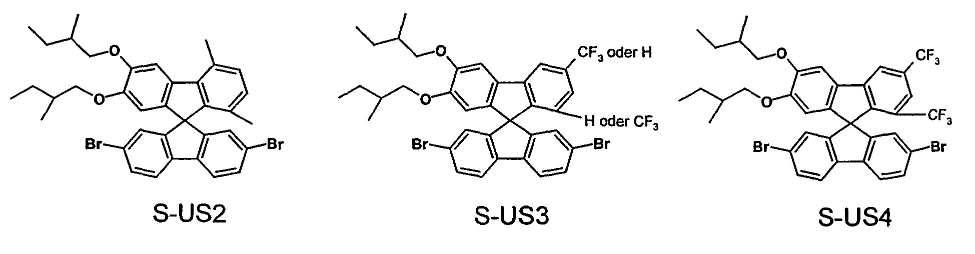

### A2: Monomere für Einheiten gemäß Formel (II) bis (V) (Triarylamine, Phenylendiaminderivate und Tetraarylbenzidine)

### Herstellung von N,N'-Bis(4-bromphenyl)-N,N'-bis(4-tert-butylphenyl)benzidin (AM1)

### Herstellung von N,N'-Bis(4-bromphenyl)-N,N'-bis(4-methoxyphenyl)benzidin (AM2)

### Herstellung von 4,4'-Dibromtriphenylamin (AM3)

Die Synthese ist in der nicht-offengelegten deutschen Anmeldeschrift DE 10114477.6 beschrieben.

Zum Überblick werden die Monomere gemäß Formeln (II) bis (V), deren Herstellung hier ausgeführt ist, in der folgenden Übersicht zusammengefaßt:

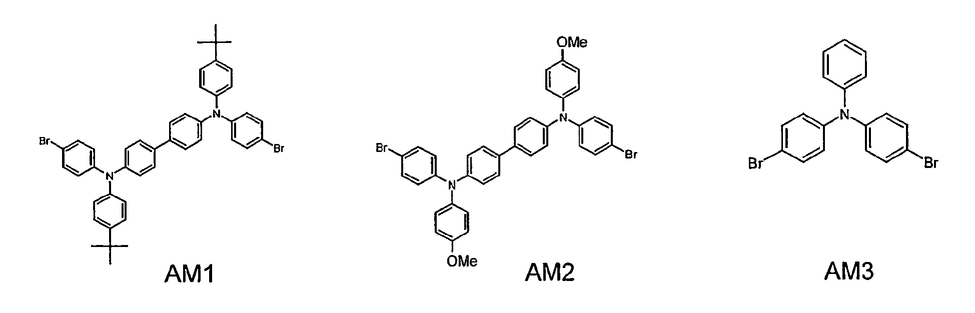

### A3: Monomere für Einheiten gemäß Formel (XXVI)

Die Herstellung substituierter Chinoxalin-Monomere wurde analog dem folgenden Schema durchgeführt:

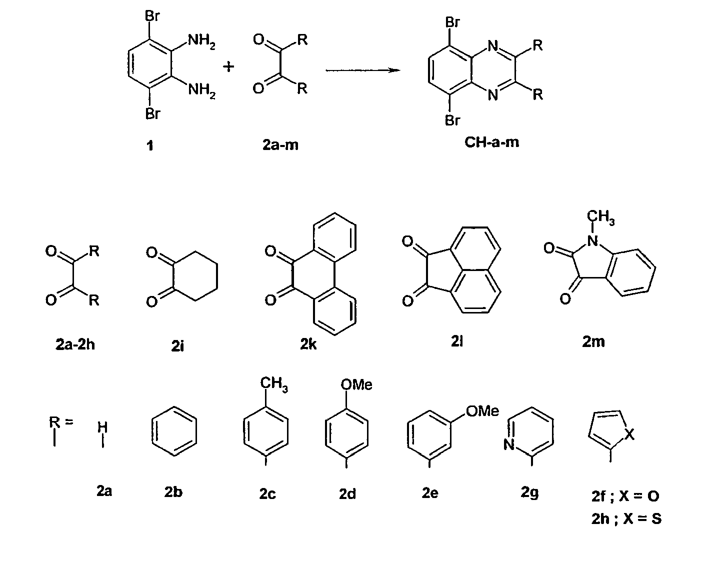

### Herstellung von 5,8-Dibrom-diphenyl-Chinoxalin (CH-b).

Eine Lösung aus 5.3 g (20 mmol), 3,6-Dibrom-1,2-phenylendiamin 1, 4 g (19 mmol) Benzil 2b, 4.2 g Natriumacetat und 150 mL Eisessig wurden 4 h unter Rückfluß erhitzt. Der Niederschlag wurde abfiltriert, mit 100 mL Wasser gewaschen und zweimal aus Dioxan umkristallisiert. Nach Trocknen im Vakuum bei 50 °C erhielt man das reine Produkt in Form farbloser Kristalle, die nach HPLC eine Reinheit von ca. 99.5 % aufwiesen. Die Ausbeute betrug 6.45 g (73 %).
¹H NMR (CDCl₃, 500 MHz): [ppm]= 7.92 (s, 2H), 7.67 (d, ³J_{HH} = 1.67 Hz, 2H), 6.66 (d, ³J_{HH} = 1.67 Hz, 2H), 7.37 (m, 6H).

Analog wurden die anderen Chinoxalin-Monomere CH-a und CH-c bis CH-m dargestellt. Die einzelnen Chinoxalin-Monomere können dem oben abgebildeten Schema entnommen werden.

### A4: Monomere für Einheiten gemäß Formeln (XXIX) und (XXX)

### Herstellung von 4,7-Dibrom-benzo[1,2,5]thiadiazol (N2S-1)

### Herstellung von 4,7-Dibromobenzofurazon (N20-1)

Die Synthese ist in der nicht-offengelegten deutschen Anmeldeschrift DE 10114477.6 beschrieben.

Für die bessere Übersichtlichkeit sind die beschriebenen Monomere, gemäß Formeln (XXIX) und (XXX), in der folgenden Grafik zusammengefaßt.

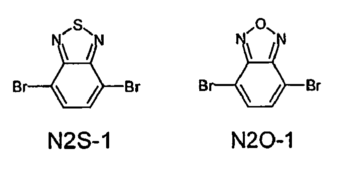

### A5: Monomere für Einheiten gemäß Formeln (XXXI) bis (XXXXVI)

Derartige Monomere wurden gemäß dem folgenden Schema dargestellt:

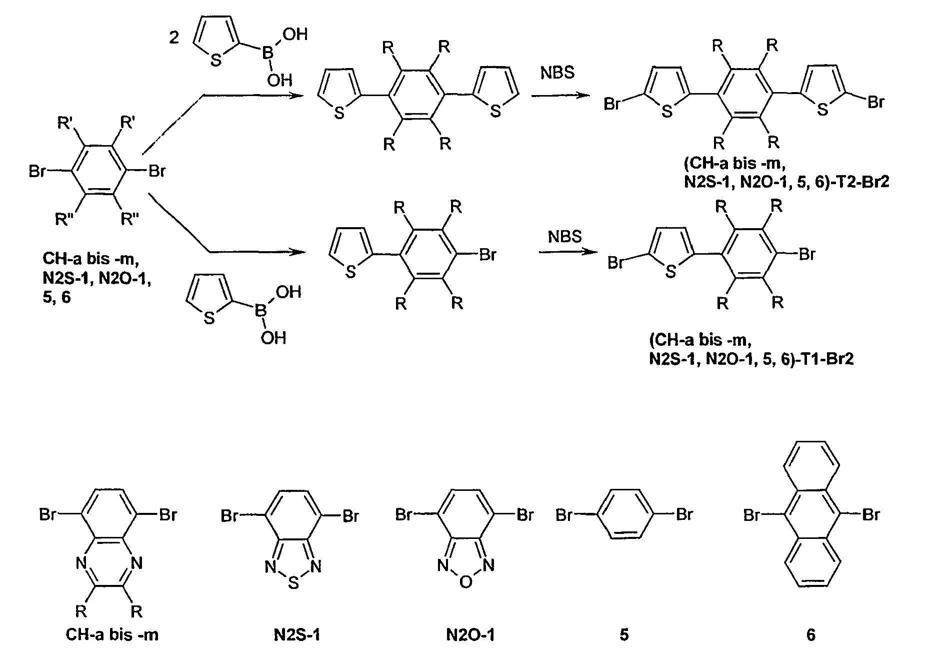

### Herstellung von Bis-4,7-(2'-brom-5'-thienyl)-2,1,3-benzothiadiazol (N2S-1)-T2-Br2.

### Herstellung von Bis-4,7-(thien-2-yl)-2,1,3-benzothiadiazol

Zur einer mit Stickstoff gesättigten Mischung bestehend aus 52.92 g (180 mmol) 1',4'-Dibrom-2,1,3,-benzothiadiazol, 60 g (468.9 mmol) 2.6 eq. Thiophen-2-boronsäure, 149 g (702 mmol) 3.9 eq. K₃PO₄, 1 L Dioxan und 1 L Wasser wurden 13.5 g (11.7 mmol) 0.065 eq. Pd(PPh₃)₄ gegeben und die Suspension für 7 h auf 80 °C erhitzt. Danach wurden 0.8 g NaCN zugegeben und die wässrige Phase abgetrennt. Die organische Phase wurde zweimal mit H₂O gewaschen und anschließend über Na₂SO₄ getrocknet. Nach dem Entfernen des Lösungsmittels und zweimaliger Umkristallisation aus CH₂Cl₂/MeOH erhielt man dunkelrote Nadeln, die lt. HPLC eine Reinheit von ca. 99% aufwiesen. Die Ausbeute betrug 43 g (80%).
¹H NMR (CDCl₃, 500 MHz): [ppm]= 8.11 (dd, ³J_{HH} = 3.68 Hz, 2H), 7.89 (s, 2H), 7.46 (dd, ³J_{HH} = 5.2 Hz, 2H), 7.21 (dd, ³J_{HH} = 5.2 Hz, 2H).

### Herstellung von Bis-4,7-(2'-brom-5'-thienyl)-2,1,3-benzothiadiazol (N2S-1)-T2-Br2

Zu einer Lösung von 7.72 g (25.7 mmol) Bis-4,7-(thien-2-yl)-2,1,3-benzothiadiazolin in 770 mL Chloroform wurden bei RT in einer Schutzgasatmosphäre und unter Lichtausschuß 9.51 g (54 mmol) N-Bromsuccinimid innerhalb 15 min zugegeben. Die Mischung wurde für 6 h gerührt, anschließend wurden 80 mL ges. Na₂CO₃ Lsg. zugegeben, die organische Phase abgetrennt und über Na₂SO₄ getrocknet. Nach Entfernen des Lösungsmittels wurde der Rückstand aus DMF/EtOH umkristallisiert. Nach Trocknen im Vakuum bei 50 °C erhielt man das Produkt in Form gelboranger Kristalle, die nach HPLC eine Reinheit von ca. 99.6% aufwiesen Die Ausbeute betrug 10 g (85%).
¹H NMR (DMSO-d₆, 500 MHz): [ppm]= 8.17 (s, 2H), 7.95 (d, ³J_{HH} = 4.2 Hz, 2H), 7.40 (d, ³J_{HH} = 4.2 Hz, 2H).

Analog konnten die Verbindungen (CH-a bis CH-m, 5, 6)-T2-Br2 hergestellt werden.

### Herstellung von 4-Brom-7-(2'-brom-5'-thienyl)-2,1,3-benzothiadiazol (N2S-1)-T1-Br2

### Herstellung von 4-Brom-7-(thien-2-yl)-2,1,3-benzothiadiazol

Zu einer mit Stickstoff gesättigten Mischung bestehend aus 52.92 g (180 mmol) 1',4'-Dibrom-2,1,3,-benzothiadiazol, 30 g (234.4 mmol) 1.3 eq. Thiophen-2-boronsäure, 74.5 g (351 mmol) 1.95 eq. K₃PO₄, 2 L Dioxan und 2 L Wasser wurden 6.75 g (5.85 mmol) 0.032 eq. Pd(PPh₃)₄ gegeben und die Suspension für sieben h auf 80 °C erhitzt. Danach wurden 0.8 g NaCN zugegeben und die wässrige Phase abgetrennt. Die organische Phase wurde zweimal mit H₂O gewaschen und anschließend über Na₂SO₄ getrocknet. Nach dem Entfernen des Lösungsmittels und zweimaliger Umkristallisation aus CH₂Cl₂/MeOH erhielt man dunkelrote Nadeln, die nach HPLC eine Reinheit von ca. 99 % aufwiesen. Die Ausbeute betrug 30 g (60%).
¹H NMR (CDCl₃, 500 MHz): [ppm]= 8.01 (d, ³J_{HH} = 3.9Hz, 2H), 7.79 (d, ³J_{HH} = 7.7 Hz, 2H), 6.64 (d, ³J_{HH} = 7.7 Hz, 2H), 7.40 (dd, ³J_{HH} = 5.2 Hz, 2H), 7.12 (dd, ³ J_{HH} = 5.2 Hz, 2H).

### Herstellung von 4-Brom-7-(2'-brom-5'-thienyl)-2,1,3-benzothiadiazol (N2S-1)-T1-Br2

Zu einer Lösung von 2.93 g (9.9 mmol) 4-Brom-7-(thien-2-yl)-2,1,3-benzothiadiazolin in 250 mL Chloroform und 150 mL Ethylacetat wurden bei RT in einer Schutzgasatmosphäre und unter Lichtausschuß 2.1 g (11.38 mmol) N-Bromsuccinimid innerhalb 15 min zugegeben. Die Mischung wurde für 6 h gerührt, anschließend wurden 50 mL ges. Na₂CO₃ Lsg. zugegeben, die organische Phase abgetrennt und über Na₂SO₄ getrocknet. Nach Entfernen des Lösungsmittels wurde der Rückstand aus DMF/EtOH umkristallisiert. Nach Trocknen im Vakuum bei 50 °C erhielt man die Dibromverbindung in Form gelboranger Kristalle, die nach HPLC eine Reinheit von ca. 99.6 % aufwiesen. Die Ausbeute betrug 3.2 g (87%).
¹H NMR (CDCl₃, 500 MHz): [ppm]= 8.07 (d, ³J_{HH} = 7.7 Hz, 1 H), 8.01 (d, ³J_{HH} = 7.7 Hz, 1 H), 7.93 (d, ³J_{HH} = 4.0 Hz, 1H), 7.38 (d, ³J_{HH} = 4.0 Hz, 1 H).

Analog konnten die Verbindungen (CH-a bis CH-m, 5, 6)-T1-Br2 hergestellt werden.

### A6: Herstellung weiterer Monomere, die in Copolymeren Verwendung finden können:

### Herstellung von 1-(2-Ethylhexyloxy)-4-methoxy-2,5-bis-(4-brom-2,5-dimethoxystyryl)-benzol (MX-1)

10.5 g (19.5 mmol) 1-(2-Ethylhexyloxy)-4-methoxy-2,5-methylenphosphonat wurden in 85 mL trockenem DMF gelöst und unter Stickstoff mit 2.4 g (43 mmol) NaOMe und anschließend mit 10.6 g (43 mmol) 4-Brom-2,5-dimethoxybenzaldehyd versetzt. Die orange Suspension wurde für 5 h bei RT gerührt, auf Wasser gegossen, der gelbe Niederschlag abfiltriert, mit MeOH und n-Hexan gewaschen und zweimal aus Toluol/Hexan umkristallisiert. Man erhielt 11.8 g (83%) des Bisphenylen-vinylens als gelbe Nadeln mit einem Gehalt von 99.8%, bestimmt durch RP-HPLC.
¹H NMR (CDCl₃, 500 MHz): [ppm] = 7.43 (m, 4H), 7.18 (s, 1 H), 7.17 (s, 1H), 7.14 (s, 2H), 7.10 (s, 2H), 3.97 (m, 2H), 3.93 (s, 3H), 3.92 (s, 3H), 3.91 (s, 3H), 3.85 (s, 6H), 1.81 (m, 1 H), 1.61 (m, 4H), 1.35 (m, 4H), 0.98 (t, ³J_{HH} = 7.4 Hz, 3H), 0.89 (t, ³J_{HH} = 7.3 Hz, 3H).

### Herstellung von 2,3,6,7-Tetra-(2-Methylbutyloxy)-2',7'-(4-bromstyryl)-9,9'-spirobifluoren (MX2)

12.8 g (13.8 mmol) 2,3,6,7-(2-Methylbutyloxy)-9,9'-spirobifluoren-2',7'-methylenphosphonat wurden in 60 mL trockenem DMF gelöst, nacheinander 1.7 g NaOMe und 5.6 g (30.4 mmol) Brombenzaldehyd in 20 mL trockenem DMF zugegeben. Das Gemisch wurde für 6 h auf 90 °C erhitzt, anschließend in Wasser gegossen, der Niederschlag abgesaugt, mit H₂O, MeOH und Hexan gewaschen und zweimal aus Toluol/Hexan umkristallisiert. Man erhielt das Spirobifluoren in Form gelber Plättchen mit einem Gehalt von 99.7%, bestimmt durch RP-HPLC.
¹H NMR (CDCl₃, 500 MHz): [ppm] = 7.78 (d, ³J_{HH} = 7.7 Hz, 2H, Spiro), 7.49 (dd, ³J_{HH} = 8.0 Hz, ⁴J_{HH} = 1.4 Hz, 2H, Spiro), 7.40 (d, ³J_{HH} = 9.0 Hz, 4H Phenylen), 7.26 (m, 6H, Phenylen, Spiro), 6.91 (2 d, ³J_{HH} = 16.1 Hz, 4H, Olefin), 6.88 (s, 2H, Spiro), 6.2 (s, 2H, Spiro), 3.95 (m, 4H, CH₂), 3.55 (m, 4H, CH₂), 1.95 (m, 2H, CH₂), 1.75 (m, 2H, CH₂), 1.64 (m, 2H, CH), 1.48 (m, 2H, CH), 1.34 (m, 2H, CH₂), 1.18 (m, 2H, CH₂), 1.09 (d, ³J_{HH} = 6.7 Hz, 6H, CH₃), 0.99 (t, ³J_{HH} = 7.3 Hz, 6H, CH₃), 0.93 (d, ³J_{HH} = 9.7 Hz, 6H, CH₃), 0.86 (t, ³J_{HH} = 7.5 Hz, 6H, CH₃).

### Herstellung von 1,4-Dibrom-2,5-(4-fluorstyryl)-benzol (MX-3)

15.3 g 1,4-Dibrombenzol-2,5-methylenphosphonat wurden in 60 mL DMF gelöst, 3.3 g (60 mmol) NaOMe zugegeben und anschließend die Lösung von 7.1 g (57 mmol) in 10 mL DMF unter Wärmetönung zugetropft. Nach 10 min wurde die gelbe Lösung in Wasser gegossen, der gelbe, filzige Feststoff abgesaugt und mit Wasser, MeOH und Hexan gewaschen. Nach dreimaliger Umkristallisation aus CHCl₃ erhielt man 10 g (70%) gelbe Nadeln mit einer Reinheit von 99.9% (RP-HPLC).
¹H NMR (Tetrachlorethan D₂, 500 MHz): [ppm] = 7.85 (s, 2H, Dibromphenyl), 7.53 (m, 4H, Phenylen), 7.28 (d, ³J_{HH} = 16.1 Hz, 2H, Olefin), 7.09 (m, 4H, Phenylen), 7.04 (d, ³J_{HH} = 16.1 Hz, 2H, Olefin).

### Herstellung von 2,7-Dibrom-2 ; 7'-N, N-diphenylamino-9, 9'-spirobifluoren (MX-4)

### (A) 2,7-Diiod-2',7'-dibrom-9,9'-spirobifluoren:

92.0 g (194.1 mmol) 2,7-Dibromspirobifluoren wurden in 200 mL CHCl₃ gelöst, 100.1 g (233 mmol) Bis-(trifluoracetoxy)-iodbenzol und 59.0 g l₂ zugegeben und die Mischung unter Stickstoff bei RT für 12 h gerührt. Die Suspension wurde filtriert, der Rückstand mit CHCl₃ gewaschen und zweimal aus 1,4-Dioxan umkristallisiert. Die Ausbeute an diiodiertem Spirobifluoren betrug 121.4 g (86%) bei einer Reinheit von >99% (¹H-NMR).
¹H NMR (DMSO-d₆, 500 MHz): 8.04 (d, ³J_{HH} = 7.9 Hz, 2H), 7.88 (d, ³,J_{HH} = 7.9 Hz, 2H), 7.82 (dd, ³ J_{HH} = 7.9 Hz, ⁴J_{HH} = 1.5 Hz, 2H), 7.66 (dd, **³**J**_{HH}** = 8.3 Hz, **⁴.J_{HH}** = 1.9 Hz, 2H), 6.98 (d, ⁴J_{HH} = 1.2 Hz, 2H), 6.83 (d, ⁴J_{HH} = 1.5 Hz, 2H).

### (B) 2,7-Dibrom-2',7'-N,N-diphenylamino-9,9'-spirobifluoren (MX-4)

30.0 g (41 mmol) 2,7-Diiod-2',7'-dibrom-9,9'-spirobifluoren und 15.1 g (93 mmol) Diphenylamin wurden in Toluol gelöst, die Lösung mit N₂ gesättigt und danach aufeinanderfolgend 93 mg (0.41 mmol) Pd(OAc)₂, 167 mg (0.82 mmol) Tris-o-tolylphosphan und 11 g (115 mmol) NaO*^{t}*Bu gegeben und die entstandene Suspension für 12 h auf 70 °C erhitzt. Nach dieser Zeit tropfte man 20 mL 1 %ige NaCN-Lsg. zu, ließ 2 h rühren und saugte den ausgefallenen Feststoff ab. Er wurde mit H₂O und EtOH gewaschen und dreimal aus Toluol umkristallisiert. Man isolierte 21.7 g (65%) des Diamins in Form farbloser Kristalle mit einer Reinheit von 99.6% (RP-HPLC). ¹H NMR (DMSO-d₆, 500 MHz): [ppm] = 7.83 (m, 4H, Spiro), 7.56 (dd, ³J_{HH} = 8.1 Hz, ⁴J_{HH} = 2.0 Hz, 2H, Spiro), 7.18 (m, 8H, N-Phenyl), 6.96 (m, 6H, N-Phenyl, Spiro), 6.88 (m, 10H, N-Phenyl, Spiro), 6.19 (d, ⁴J_{HH} = 2.0 Hz, 2H, Spiro).

Zur besseren Übersicht sind die in A6 beschriebenen Monomere nochmals in der folgenden Grafik zusammengefaßt:

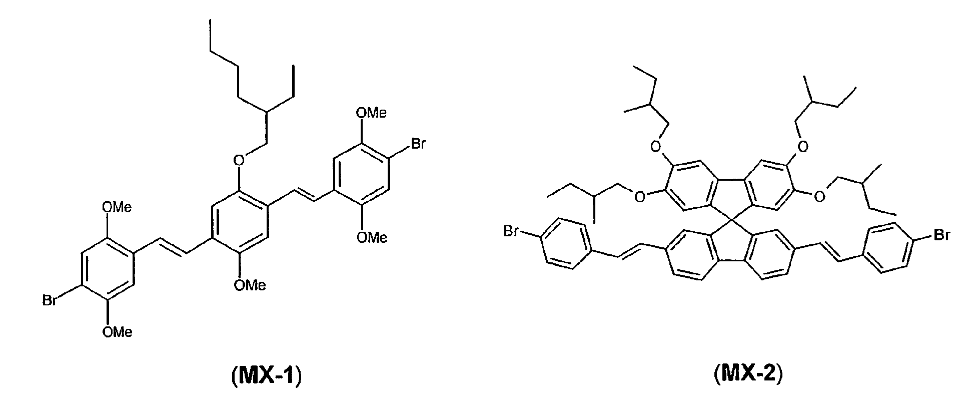

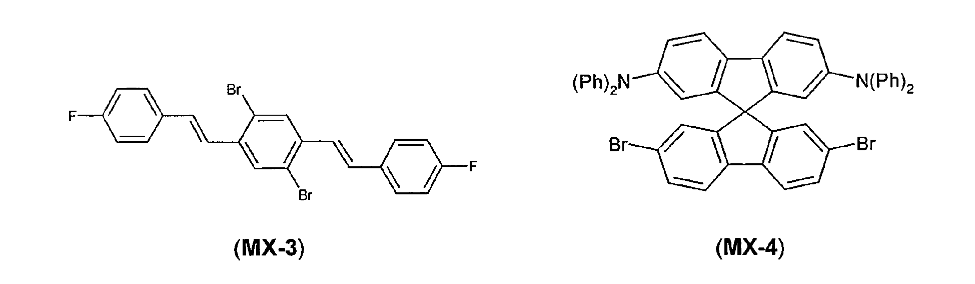

### Teil B: Herstellung der Polymere

### Copolymerisation von 87.5 mol% 2,7-Dibromo-2',3',6', 7'-tetra(2-methylbutyloxy)-spirobifluoren (S-SY1), und 12.5 mol% von N,N'-Bis(4-brom)-phenyl-N,N'-bis-(4-tert-butylphenyl)-benzidin (AM1) durch Yamamoto-Kupplung (Polymer P1)

Unter Argon wurden 1.53 g (5.57 mmol) Ni(COD)₂ sowie 0.87 g (5.57 mmol) 2,2'-Bipyridyl in ein Schlenkgefäß überführt. 25 mL Dimethylformamid und 80 mL Toluol wurden zugegeben und die Mischung auf 80° C erwärmt. Nach 30 min wurde zuerst 0.379 g (3.51 mmol, 0.43 mL) 1,5-Cyclooctadien, dann eine Lösung von 1.768 g (2.11 mmol) 2,7-Dibrom-2`,3',6`,7`-tetra-(2-methylbutyloxy)-spirobifluoren (S-SY1) und 0.183 g (0.242 mmol) N,N'-Bis(4-bromphenyl)-N,N'-bis-(4-*tert*-butylphenyl)-benzidin (AM1) in 20 mL Toluol zugeben. Nach 144 h wurde abgekühlt, 5 mL HCI in Dioxan zugeben und die Reaktionsmischung wurde 15 min gerührt. Es wurde 50 mL Chloroform zugeben und 15 min gerührt. Die organische Phase wurde zweimal mit je 100 mL 5M HCl und einmal mit 100 mL ges. NaHCO₃ Lösung gewaschen. Die Lösung wurde in 450 mL Methanol gefällt und das rohe Polymer abgesaugt. Es wurde noch zweimal aus jeweils 100 mL THF/150 mL Methanol umgefällt. Man erhielt 1.30 g (2.24 mmol, 83%) faseriges, leicht gelbes Polymer **P1.**
¹H NMR (CDCl₃): [ppm] = 7.7-6.7 (m, 9.4H, Spiro, TAD); 6.2-6.0 (m, 2H, Spiro); 4.0-3.2 (2 x m, 7.2H, OCH₂); 1.9-0.7 (m, Alkyl H, darunter bei 1.30 *t*-Butyl). GPC: THF; 1 mL/min, Plgel 10µm Mixed-B 2 x 300 x 7.5 mm², 35°C, RI Detektion: Mw = 155000 g/mol, Mn = 53000 g/mol

### Copolymerisation von 50 mol % 2';3';6'; 7'-Tetra-(2-methylbutyloxy)-spirobiffuoren-2,7-bisboronsäureethylenglycolester (S-SY2), 40 mol% 2,7-Dibrom-2',3',6', 7'-tetra-(2-methylbutyloxy)-spirobifluoren (S-SY1) und 10 mol% N,N'-Bis(4-bromphenyl)-N,N'-bis(4-tert-butylphenyl)-benzidin (AM1) durch Suzuki-Reaktion (Polymer P2).

8.0065 g (10.00 mmol) 2',3',6',7'-Tetra-(2-methylbutyloxy)-spirobifluoren-2,7-bisboronsäureethylenglycolester (S-SY2), 6.5499g (8.00 mmol) 2,7-Dibrom-2',3',6',7'-tetra-(2-methylbutyloxy)-spirobifluoren (S-SY1), 1.5173 g (2.00 mmol) N,N'-Bis(4-bromophenyl)-N,N'-bis(4-tert-butylphenyl)benzidin (AM1), 9.67 g (42 mmol) K₃PO₄.H₂O, 30 mL Toluol, 15 mL Wasser und 0.25 mL Ethanol wurden 30 min durch Durchleiten von N₂ entgast. Anschließend wurden 175 mg (0.15 mmol) Pd(PPh₃)₄ unter Schutzgas zugegeben. Die Suspension wurde unter N₂-Überlagerung bei 87 °C Innentemperatur (leichter Rückfluß) kräftig gerührt. Nach 4 Tagen wurden weitere 0.30 g 2',3',6',7'-Tetra-(2-methylbutyloxy)-spirobifluoren-2,7-bisboronsäureethylenglycolester zugesetzt. Nach weiteren 6 h Erhitzen wurden 0.3 mL Brombenzol zugesetzt und noch 3 h zum Rückfluß erhitzt.
Die Reaktionslösung wurde mit 200 mL Toluol verdünnt, die Lösung wurde mit 200 mL 2%iger wässriger NaCN Lsg. 3h ausgerührt. Dabei hellte sich die Mischung nahezu vollständig auf. Die organische Phase wurde mit H₂O gewaschen und durch Eintropfen in 800 mL Ethanol gefällt. Das Polymer wurde in 200 mL THF 1 h bei 40 °C gelöst, mit 250 mL MeOH ausgefällt, gewaschen und im Vakuum getrocknet. In 200 mL THF/ 250 mL Methanol wurde ein weiteres Mal umgefällt, abgesaugt und bis zur Massenkonstanz getrocknet. Man erhielt 12.25 g (18.8 mmol, 94 %) des Polymeren P2 als leicht gelben Feststoff.
¹H NMR (CDCl₃): [ppm] = 7.7-6.7 (m, 9.4H, Spiro, TAD); 6.2-6.0 (m, 2H, Spiro); 4.0-3.2 (2 x m, 7.2 H, OCH₂); 1.9-0.7 (m, Alkyl H, darunter bei 1.30 *t*-Butyl). GPC: THF; 1 mL/min, PLgel 10 µm Mixed-B 2 x 300 x 7.5 mm², 35 °C, RI Detektion: Mw = 124000 g/mol, Mn = 39000 g/mol.

### Beispiel P3 Copolymerisation von 50 mol% 2',3',6',7'-Tetra-(2-methylbutyloxy)-spirobifluoren-2, 7-bisboronsäureethylenglycolester (S-SY2), 30 mol% 2,7-Dibromo-2',3',6',7'-tetra-(2-methylbutyloxy)-spirobifluoren (S-SY1), 10 mol% 5,8-Dibrom-diphenyl-chinoxalin (CH-b) und 10 mol% N,N'-Bis(4-bromophenyl)-N,N'-bis(4-tert-butylphenyl)-benzidin (AM1) durch Suzuki-Reaktion (Polymer P13).

4.9124 g (6.00 mmol) 2',3',6',7'-Tetra(2-methylbutyloxy)spirobifluoren-2,7-bisboronsäureethylenglycolester (S-SY2), 8.0065g (10.00 mmol) 2,7-Dibromo-2',3',6',7'-tetra(2-methylbutyloxy)spirobifluoren (S-SY1), 0.8803g (2.00) 5,8-Dibrom-diphenyl-Chinoxalin (CH-b), 1.5173 g (2.00 mmol) N,N'-Bis(4-bromophenyl)-N,N'-bis(4-tert-butylphenyl)benzidin (AM1), 9.67 g (42 mmol) K₃PO₄·H₂O, 30 mL Toluol, 15 mL Wasser und 0.25 mL Ethanol wurden 30 min durch Durchleiten von N₂ entgast. Anschließend wurde 175 mg (0.15 mmol) Pd(PPh₃)₄ unter Schutzgas zugegeben. Die Suspension wurde unter N₂-Überlagerung bei 87 °C Innentemperatur (leichter Rückfluß) kräftig gerührt. Nach 4 Tagen wurden weitere 0.30 g 2',3',6',7'-Tetra-(2-methylbutyloxy)-spirobifluoren-2,7-bisboronsäure-ethylenglycolester zugesetzt. Nach weiteren 6 h Erhitzen wurden 0.3 mL Brombenzol zugesetzt und noch 3 h zum Rückfluß erhitzt.
Die Reaktionslösung wurde mit 200 mL Toluol verdünnt und mit 200 mL 2%iger wässriger NaCN Lsg. 3 h ausgerührt. Dabei hellte sich die Mischung nahezu vollständig auf. Die organische Phase wurde mit H₂O gewaschen und durch Eintropfen in 800 mL Ethanol gefällt. Das Polymer wurde in 200 mL THF 1 h bei 40 °C gelöst, mit 250 mL MeOH ausgefällt, gewaschen und im Vakuum getrocknet. In 200 mL THF/ 250 mL Methanol wurde ein weiteres Mal umgefällt, abgesaugt und bis zur Massenkonstanz getrocknet. Man erhielt 17.8 g (18.6 mmol, 93%) des Polymeren P13 als leicht gelben Feststoff.
¹H NMR (CDCl₃): [ppm] = 7.8-6.7 (m, 9.6H, Spiro, TAD); 6.4-6.0 (m, 2H, Spiro); 4.0-3.4 (2 x m, 6.4H, OCH₂); 1.9-0.7 (m, Alkyl H, darunter bei 1.30 *t*-Butyl).
GPC: THF; 1 mL/min, PLgel 10 µm Mixed-B 2 x 300 x 7.5 mm², 35 °C, RI Detektion: Mw = 54000 g/mol, Mn = 22000 g/mol.

### Beispiel P4 Copolymerisation von 50 mol% 2',3',6',7'-Tetra(2-methylbutyloxy)-spirobifluoren-2, 7-bisboronsäureethylenglycolester (S-SY2), 30 mol% 2,7-Dibromo-2',3',6',7'-tetra(2-methylbutyloxy)spirobifluoren(S-SY1), 10 mol% N,N'-Bis(4-bromphenyl)-N,N'-bis(4-tert-butylphenyl)-benzidin (AM1) und 10 mol% 2, 3, 6, 7-Tetra-(2-methylbutyloxy)-2', 7'-(4-bromstyryl)-9,9'-spirobifluoren (MX-2) durch Suzuki-Reaktion (verbesserte Version) (Polymer P35*).

### Polymerisationsverfahren gemäß der nicht offengelegten Anmeldeschrift DE 10159946.3:

16.0131 g (20.00 mmol) 2',3',6',7'-Tetra(2-methylbutyloxy)spirobifluoren-2,7-bisboronsäureethylenglycolester (S-SY2), 9.8249 g (12.00 mmol) 2,7-Dibromo-2',3',6',7'-tetra(2-methylbutyloxy)spirobifluoren (S-SY1), 3.0346 g (4.00 mmol) N,N'-Bis(4-bromophenyl)-N,N'-bis(4-tert-butylphenyl)benzidin (AM1), 4.0923 g (4.00 mmol) 2,3,6,7-Tetra-(2-methylbutyloxy)-2',7'-(4-bromstyryl)-9,9'-spirobifluoren (MX-2), 19.57 g (85 mmol) K₃PO₄·H₂O, 250 mL Toluol, 250 mL Dioxan, 40 mL Wasser wurden 30 min durch Durchleiten von Argon entgast. Anschließend wurde eine Mischung von 2.25 mg (0.01 mmol) PdAc₂ und 18.3 mg (0.06 mmol) P(o-Tolyl)₃ in 1 mL Toluol unter Schutzgas zugegeben. Die Suspension wurde unter Argon-Überlagerung unter leichtem Rückfluß für ca. 5 h kräftig gerührt. In dieser Zeit wurde das Reaktionsgemisch zäh und fluoreszierte bläulich. Anschließend wurde zunächst 118 mg (0.4 mmol) 3,4-Bis-(2-methylbutyloxy)benzol-boronsäure in 150 mL Toluol zugegeben und für eine weitere Stunde refluxiert. Schließlich wurde noch 165 mg (0.5 mmol) 3,4-Bis-(2-methylbutyloxy)-brombenzol in weiteren 100 mL zugegeben und erneut für eine Stunde refluxiert.
Die Reaktionsmischung wurde abgekühlt, die wässrige Phase abgetrennt; anschließend wurde zweimal mit je 250 mL einer 5%igen Natrium-diethyl-dithiocarbamat-lösung in Wasser bei 60°C ausgerührt. Danach wurde dreimal mit je 250 mL Wasser ausgerührt, mit 750 mL THF verdünnt und schließlich durch Zugabe von 2 L Methanol das Rohpolymer ausgefällt. Dieses wurde durch zweimaliges Umfällen aus THF (1%ige Lösung) in Methanol weiter aufgereinigt. Endreinigung erfolgte durch Soxhletextraktion mit Methanol / THF (1 : 1) für ca. 48 h.
Es wurden 24.14 g (90%) Polymer als gelbe Fasern erhalten.
¹H NMR (CDCl₃): 7.8-6.2 (m, 12.6 H, Spiro, Vinyl, TAD); 4.0-3.3 (2 x m, 7.2 H, OCH₂); 1.9-0.7 (m, 34.2 H, Alkyl H, darunter bei 1.25 *t*-Butyl).
GPC: THF; 1 mL/min, PLgel 10 µm Mixed-B 2 x 300 x 7.5 mm², 35 °C, Rl Detektion: Mw = 830000 g/mol, Mn = 220000 g/mol.
Dieses Polymer hatte ein höheres Molekulargewicht, als das in der Tabelle (s. u.) angegebene Polymer **P35,** welches mit dem alten Polymerisationsverfahren dargestellt wurde.
Dadurch konnte auch noch einige Eigenschaftsveränderungen erzielt werden; einige weitere Angaben:
- Viskositätsangaben: Lösung **(P35*)** in Anisol / o-Xylol (14 g/L): 20.8 mPas (@ 40s⁻¹); Lösung **(P35*)** in Tetralin (8 g/L): 15.8 mPas (@ 40s⁻¹).
- EL-Daten: max. Eff.: 5.35 Cd/A; 3.8 V @ 100 Cd/m²; Farbe: hell-blau (CIE-1931: x/y=0.18,0.25); operative Lebensdauer (@100 Cd/m²): 4000 h.

Weitere Polymere wurden analog den Beschreibungen für **P1, P2** und **P13** dargestellt. Die chemischen Eigenschaften sind in der folgenden Tabelle zusammengefaßt. All diese Polymere wurden auch für einen Einsatz in PLEDs untersucht. Wie PLEDs dargestellt werden können, ist zum einen oben schon ausgeführt und wird detaillierter noch in Teil C beschrieben.
Auch die wichtigsten Device-Eigenschaften (Farbe, Effizienz und Lebensdauer) sind in der Tabelle mit aufgeführt.

| | Anteil der Monomere in der Polymerisation [%] | | | | GPC** | | Elektrolumineszenz*** | | | | | Visco.**** |
|---|---|---|---|---|---|---|---|---|---|---|---|---|
| Polymer (Typ)* | Monom.1 | Monom.2 | Monom.3 | Monom.4 | M_{W} (1000 g/mol) | M_{N} (1000 g/mol) | λₘₐₓ [nm] | Max. Eff [Cd/A] | Spannung bei 100Cd/m² [V] | EL-Farbe | Lebensdauer bei 100 Cd/m² [h] | Geltemp. [°C] |
| P1(Y) | 87.5% S-SY1 | 12.5% AM1 | | | 155 | 53 | 465 | 2.7 | 4.0 | Blau | 800 | < 0°C |
| P2 (S) | 50%S-SY2 | 40%S-SY1 | 10%AM1 | | 124 | 39 | 463 | 2.8 | 4.5 | Blau | 1250 | <0°C |
| P3 (S) | 50%S-SY2 | 40%S-US1 | 10% AM1 | | 101 | 41 | 465 | 2.6 | 4.5 | Blau | 1150 | <0°C |
| P4 (S) | 50%S-SY2 | 40%S-US2 | 10% AM1 | | 90 | 40 | 470 | 3.0 | 4.7 | Blau | 1550 | 10°C |
| P5 (S) | 50%S-SY2 | 40%S-US3 | 10% AM1 | | 115 | 45 | 473 | 3.2 | 4.2 | Blau | 2250 | <0 °C |
| P6 (S) | 50%S-SY2 | 40%S-US4 | 10% AM1 | | 87 | 36 | 472 | 2.8 | 4.5 | Blau | 1250 | <0 °C |
| P7 (S) | 50% S-SY2 | 40%S-SY3 | 10% AM1 | | 120 | 46 | 467 | 1.9 | 5.1 | Blau | 610 | 10°C |
| P8 (S) | 50% S-SY4 | 40%S-SY1 | 10% AM1 | | 110 | 38 | 468 | 1.8 | 5.3 | Blau | 410 | 15°C |
| P9 (S) | 50% S-SY2 | 40%S-SY1 | 10% AM2 | | 89 | 30 | 470 | 2.2 | 5.0 | Blau | 900 | < 0 °C |
| P10 (S) | 50% S-SY2 | 40%S-SY1 | 10% AM3 | | 83 | 29 | 465 | 1.6 | 5.8 | Blau | 800 | < 0 °C |
| P11(S) | 50% S-SY2 | 40%S-SY1 | 10% AM1 | | 124 | 39 | 463 | 2.8 | 4.5 | Blau | 1250 | < 0 °C |
| P12 (S) | 50% S-SY2 | 30%S-SY1 | 10% AM1 | 10% CH-a | 98 | 48 | 509 | 6.8 | 5.8 | Grün | 3000 | < 0 °C |
| P13 (S) | 50% S-SY2 | 30%S-SY1 | 10%AM1 | 10% CH-b | 77 | 32 | 516 | 7.6 | 4.6 | Grün | 4300 | < 0°C |
| P14 (S) | 50% S-SY2 | 30%S-SY1 | 10% AM1 | 10% CH-c | 99 | 29 | 516 | 5.9 | 5.8 | Grün | 2800 | < 0°C |
| P15 (S) | 50% S-SY2 | 30%S-SY1 | 10% AM1 | 10% CH-d | 110 | 51 | 545 | 6.9 | 4.7 | Grüngelb | 4000 | < 0 °C |
| P16 (S) | 50% S-SY2 | 30%S-SY1 | 10% AM1 | 10% CH-e | 105 | 37 | 527 | 7.7 | 3.9 | Grün | >5000 | < 0 °C |
| P17 (S) | 50%S-SY2 | 30%S-SY1 | 10% AM1 | 10% CH-f | 120 | 48 | 525 | 6.0 | 4.9 | Grün | 2100 | < 0 °C |
| P18 (S) | 50%S-SY2 | 30%S-SY1 | 10% AM1 | 10% CH-g | 29 | 10 | 525 | 3.1 | 7.1 # | Grün | --- | -20 °C |
| P19 (S) | 50% S-SY2 | 30%S-SY1 | 10% AM1 | 10% CH-h | 91 | 29 | 535 | 6.7 | 3.8 | Grün | >5000 | <0°C |
| P20 (S) | 50% S-SY2 | 30%S-SY1 | 20% CH-h | | 87 | 36 | 534 | 6.1 | 4.1 | Grün | 4000 | < 0 °C |
| P21 (S) | 50% S-SY2 | 30%S-SY1 | 10% AM1 | 10% CH-i | 124 | 63 | 553 | 6.5 | 4.8 | Grüngelb | 2500 | < 0 °C |
| P22 (S) | 50%S-SY2 | 30%S-SY1 | 10% AM1 | 10% CH-k | 54 | 20 | 541 | 2.2 | 5.8 | Grüngelb | --- | ~5°C |
| P23 (S) | 50%S-SY2 | 30%S-SY1 | 10%AM1 | 10% CH-I | 111 | 54 | 524 | 5.9 | 5.1 | Grün | 1800 | <0 °C |
| P24 (S) | 50% S-SY2 | 20%S-SY1 | 20% MX-4 | 10% CH-b | 138 | 56 | 516 | 8.8 | 3.8 | Grün | >5000 | <0 °C |
| P25 (S) | 50% S-SY2 | 30%S-SY1 | 10% AM1 | 10% N2S-1 | 98 | 37 | 551 | 7.1 | 4.9 | Grüngelb | 1600 | < 0 °C |
| P26 (S) | 50% S-SY2 | 30%S-SY1 | 10% AM1 | 10%N2O-1 | 87 | 39 | 575 | 6.2 | 5.4 | Gelb | 1200 | < 0 °C |
| P27 (S) | 50%S-SY2 | 10% AM1 | 35%N2S-1 | 5%(N2S- | 89 | 40 | 632 | 1.5 | 3.6 | Rot | >5000 | < 0 °C |
| P28 (S) | 50% S-SY2 | 10% AM1 | 35%N2S-1 | 1)-T2-Br2 5%(N2S- | 112 | 45 | 597 | 1.6 | 4.9 | Rot- | >5000 | < 0°C |
| P29(S) | 50% S-SY2 | 10% AM1 | 35%N2S-1 | 1)-T1-Br2 5%(CH-b)- | 56 | 20 | 619 | 1.5 | 3.5 | Orange Rot | >5000 | < 0 °C |
| P30(S) | 50% S-SY2 | 10% AM1 | 35%N2S-1 | T2-Br2 5%(CH-b)- | 89 | 45 | 590 | 1.9 | 3.9 | Rot- | >5000 | < 0 °C |
| P31(S) | 50%S-SY2 | 10%AM1 | 35%N2S-1 ; | T1-Br2 5%(5)-T2- | 120 | 62 | 560 | 3.2 | 4.9 | Orange Gelb- | ---- | < 0 °C |
| P32(S) | 50%S-SY2 | 10% AM1 | 35%N2S-1 | Br2 5%(6)-T2- | 79 | 30 | 575 | 1.0 | 6.9 | Orange Gelb- | ---- | < 0 °C |
| P33(S) | 50% S-SY2 | 10% MX-1 | 35%N2S-1 | Br2 5%(N2S- | 117 | 48 | 642 | 1.9 | 3.0 | Orange Rot | >5000 | < 0 °C |
| P34 (S) | 50% S-SY2 | 30%S-SY1 | 10% AM1 | 10% MX-1 | 135 | 53 | 520 | 9.8 | 3.5 | Grün | >5000 | < 0 °C |
| P35 (S) | 50% S-SY2 | 30%S-SY1 | 10% AM1 | 10% MX-2 | 102 | 45 | 475 | 4.0 | 4.2 | Blau-Grün | 2100 | < 0 °C |
| P36 (S) | 50%S-SY2 | 30%S-SY1 | 10% AM1 | 10% MX-3 | 65 | 25 | 460 | 2.0 | 4.4 | Blau | 1200 | < 0 °C |
| P37 (S) | 50% S-SY2 | 30%S-SY1 | 10% AM1 | 10% MX-4 | 128 | 60 | 468 | 3.2 | 4.0 | Blau | 2000 | < 0 °C |
| P38 (S) | 50%S-SY2 | 20%S-SY1 | 10% AM1 | 20% MX-4 | 99 | 39 | 468 | 3.2 | 3.8 | Blau | 1900 | < 0 °C |
| P39 (Y) | 80%S-SY1 | 10% AM1 | 10% MX-4 | | 176 | 76 | 466 | 3.3 | 4.0 | Blau | 2500 | < 0 °C |
| P40 (S) | 50%S-SY2 | 20%S-SY1 | 10% AM1 | 10% MX-4 | 112 | 60 | 517 | 10.2 | 3.0 | Grün | >5000 | < 0 °C |
| P41 (S) | 50%S-SY2 | 20%S-SY1 | 10% AM1 | 10% CH-b 10% MX-1 | 122 | 62 | 515 | 11.2 | 2.9 | Grün | >5000 | < 0 °C |
| | | | | 10% CH-b | | | | | | | | |
| V1(S) | 50% S-SY2 | 50%S-SY1 | | | 142 | 62 | 451 | 0.1 | 8.9 | Blau | ---- | < 0 °C |
| V2 (S) | 50%S-SY2 | 40%S-SY1 | 10% MX-1 | | 102 | 60 | 518 | 2.1 | 9.3 | Grün | 100 h | <0 °C |
| V3 (S) | 50% S-SY2 | 25%S-SY1 | 25%MX-1 | | 99 | 38 | 523 | 2.0 | 9.2 | Grün | 80 h | <0°C |

| | | | | | | | | | | | | |
|---|---|---|---|---|---|---|---|---|---|---|---|---|
| *S = Durch Suzuki-Polymerisation hergestellt (vgl. Bsp. P2), Y = Durch Yamamoto-Polymerisation hergestellt (vgl. Bsp. P1) ** GPC Messungen THF; 1 mL/min, Plgel 10 µm Mixed-B 2 x 300 x 7.5 mm², 35 °C, RI Detektion wurde gegen Polystyrol geeicht *** Zur Herstellung der Polymer LEDs, siehe Teil C ****Lösungen des Polymers (10 mg/mL) in Toluol wurden auf 60 °C erwärmt, mit 1 °C/Minute abgekühlt und die Viskosität wurde in einem Brookfield LVDV-III Rheometer (CP-41) gemessen. Bei der so ermittelten Geltemperatur trat ein starker Anstieg in der Viskosität auf. # Aufgrund der schlechten Löslichkeit wurden die PLEDs aus Chlorbenzol hergestellt | | | | | | | | | | | | |

### Teil C: Herstellung und Charakterisierung von LEDs:

Die Herstellung von LEDs erfolgte nach dem im folgenden skizzierten allgemeinen Verfahren. Dieses mußte natürlich im Einzelfall auf die jeweiligen Gegebenheiten (z.B. Polymerviskosität und optimale Schichtdicke des Polymers im Device) angepaßt werden. Die im nachfolgenden beschriebenen LEDs waren jeweils Zweischichtsysteme, d. h. Substrat//ITO//PEDOT//Polymer//Kathode. PEDOT ist ein Polythiophen-Derivat, das z.B. von der BAYER AG als Baytron P^{™} bezogen werden kann.

### Allgemeines Verfahren zur Herstellung von hocheffizienten, langlebigen LEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z.B. Seifenlösung, Millipore-Wasser, Isopropanol).
Zur Trocknung werden sie mit einer N₂-Pistole abgepustet und in einem Exsikkator gelagert. Vor der Beschichtung mit dem Polymer werden sie mit einem Ozon-Plasma-Gerät für ca. 20 Minuten behandelt. Von dem jeweiligen Polymer wird eine Lösung (in der Regel mit einer Konzentration von 4-25 mg/mL in beispielsweise Toluol, Chlorbenzol, Xylol:Cyclohexanon (4:1)) angesetzt und durch Rühren bei Raumtemperatur gelöst. Je nach Polymer kann es auch vorteilhaft sein, für einige Zeit bei 50 - 70 °C zu rühren. Hat sich das Polymer vollständig gelöst, wird es durch einen 5 µm Filter filtriert und bei variablen Geschwindigkeiten (400-6000) mit einem Spincoater aufgeschleudert. Die Schichtdicken können dadurch im Bereich von ca. 50 und 300 nm variiert werden. Die Messungen erfolgen mit einem Dektak-Gerät wie in EP 1029019 beschrieben. Vorab wird meist auf das (strukturierte) ITO ein leitfähiges Polymer, bevorzugt dotiertes PEDOT oder PANI, aufgebracht.
Auf die Polymerfilme werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ba, Yb, Ca) als Kathode kontaktiert und die Device-Parameter bestimmt.
Die mit den beschriebenen Polymeren erhaltenen Resultate sind in der Tabelle in Teil B zusammengefaßt.

## Patentansprüche

1. Konjugierte Polymere, die neben Einheiten der Formel (I) 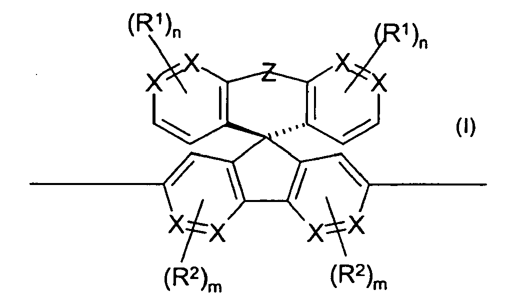 zusätzlich noch ein oder mehrere Einheiten ausgewählt aus folgenden Gruppen 1 bis 4 enthalten,
wobei die Gruppe 1 für Einheiten steht, welche die Lochinjektions- odertransporteigenschaften der Polymere deutlich erhöhen und aus den Formeln (II) bis (XI) und (XIII) bis (XIX) ausgewählt sind, 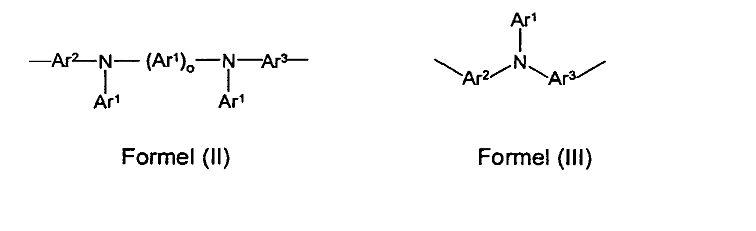 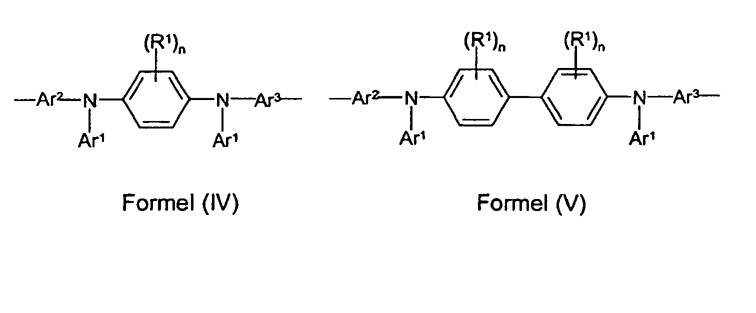 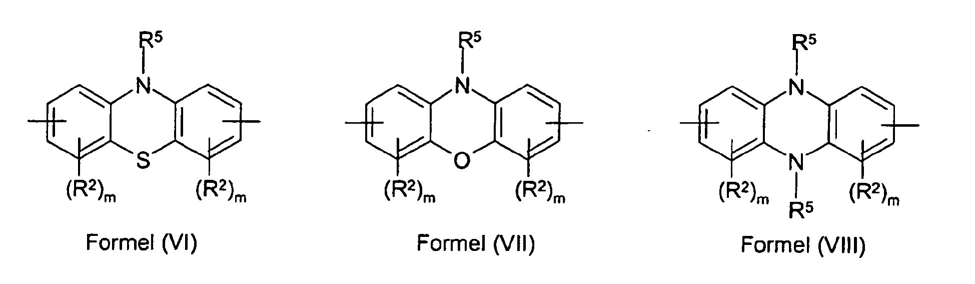 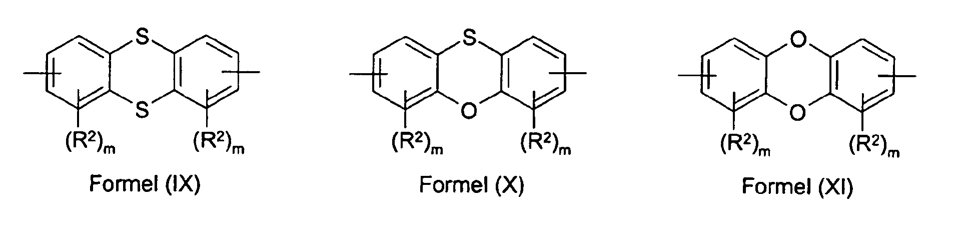 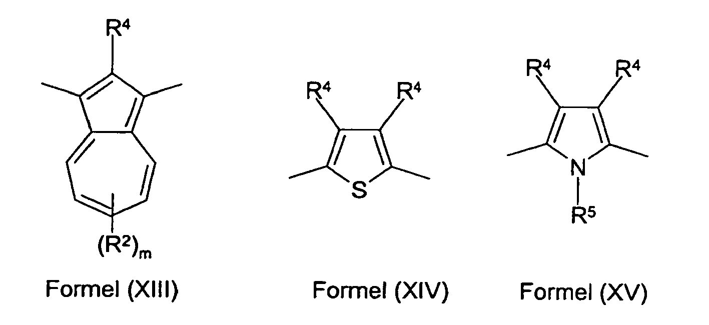 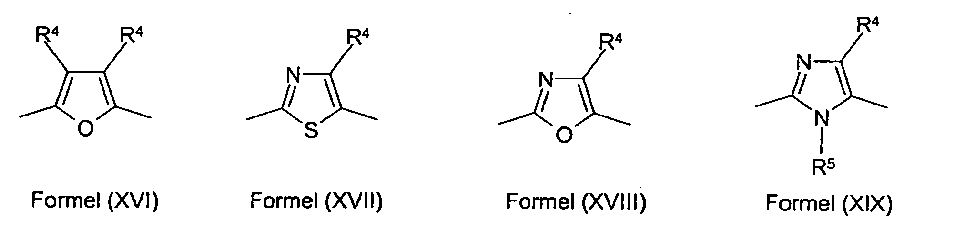 wobei die Symbole
Ar¹, Ar², Ar³ bei jedem Auftreten gleich oder verschieden aromatischen oder heteroaromatischen Kohlenwasserstoffen mit 2 bis 40 C-Atomen, welche auch mit einem oder mehreren nicht-aromatischen Resten R¹ substituiert sein können, sind;
o 1, 2 oder 3 ist;
wobei die Gruppe 2 für Einheiten steht, welche die Elektroneninjektions- oder - transporteigenschaften der Polymere deutlich erhöhen und aus den Formeln (XX) bis (XXX) ausgewählt sind, 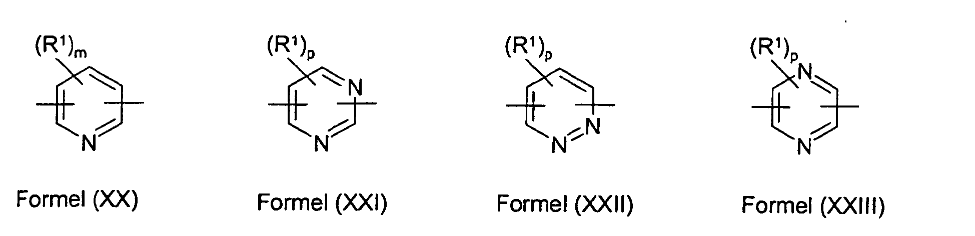 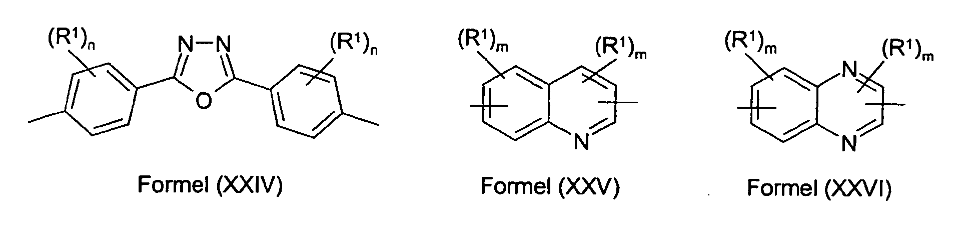 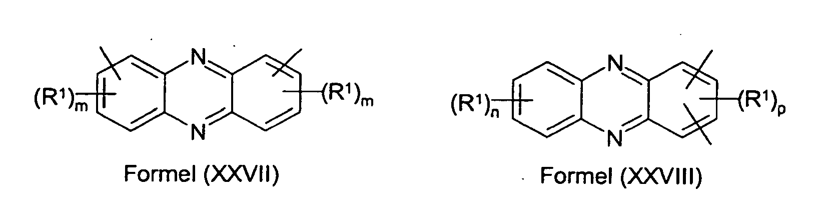 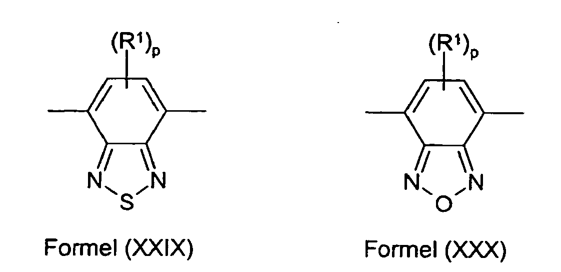 wobei die Symbole
p 0, 1 oder 2 bedeuten;
wobei die Gruppe 3 für Einheiten steht, die Kombinationen von Einzeleinheiten der Gruppe 1 und Gruppe 2 enthalten und aus den Formeln (XXXI) bis (XXXXVI) ausgewählt sind, 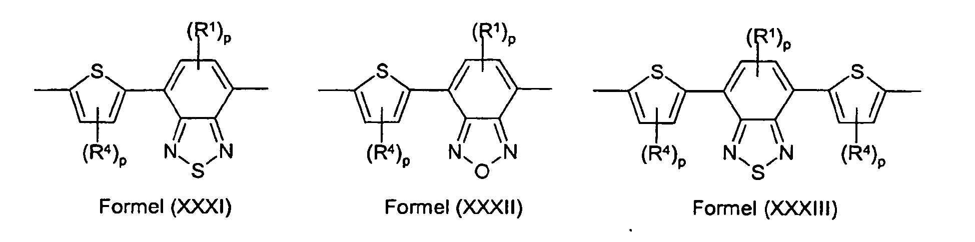 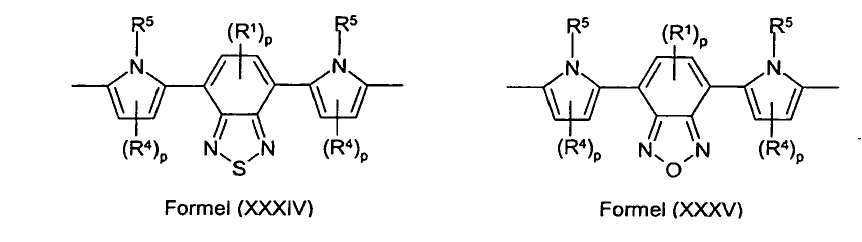 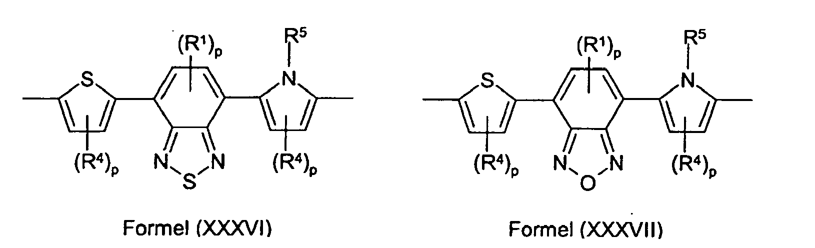 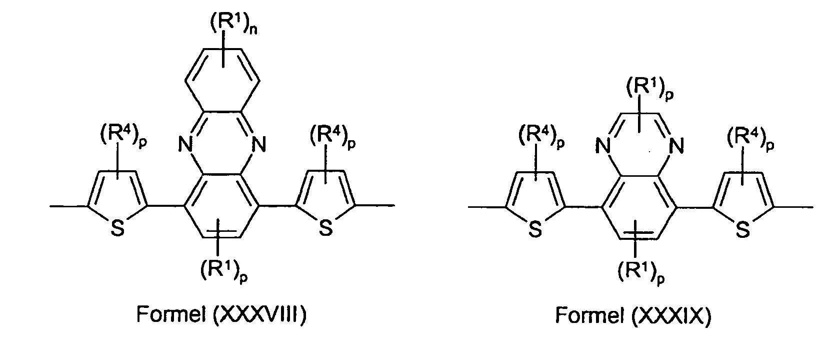 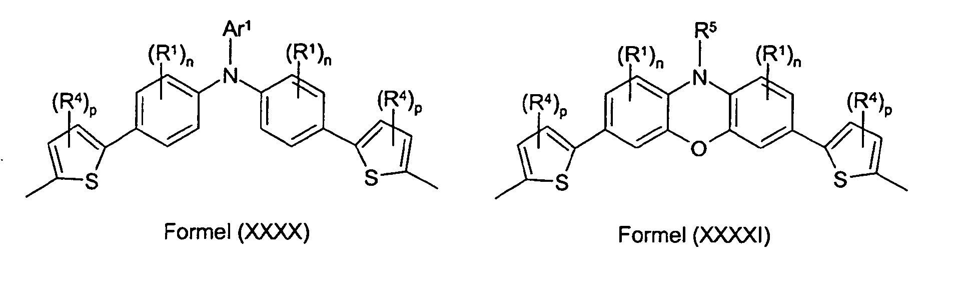 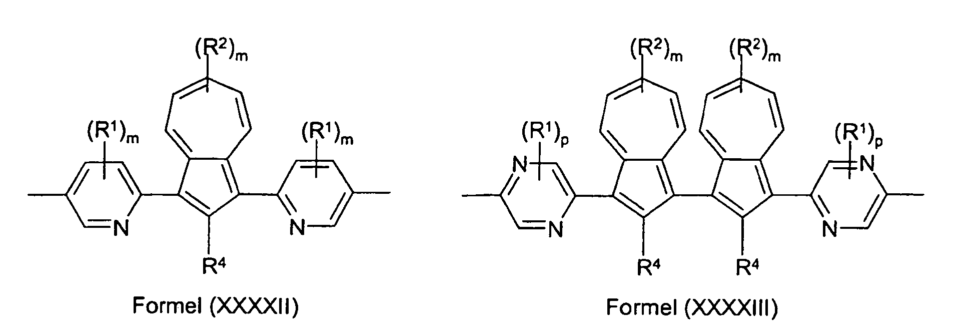 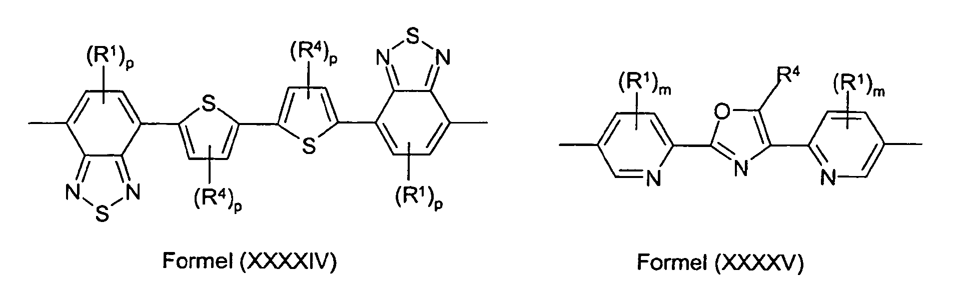 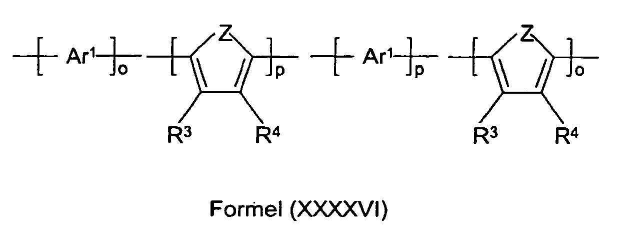 wobei die Symbole
o 1, 2 oder 3, bevorzugt 1 oder 2 bedeuten und;
p 0, 1 oder 2, bevorzugt 0 oder 1 ist;
wobei die Gruppe 4 für Einheiten steht, welche die Emissionscharakteristik insoweit verändern, daß statt Fluoreszenz Phosphoreszenz erhalten werden kann und aus den Formeln (XXXXVII) bis (XXXXX) ausgewählt sind, 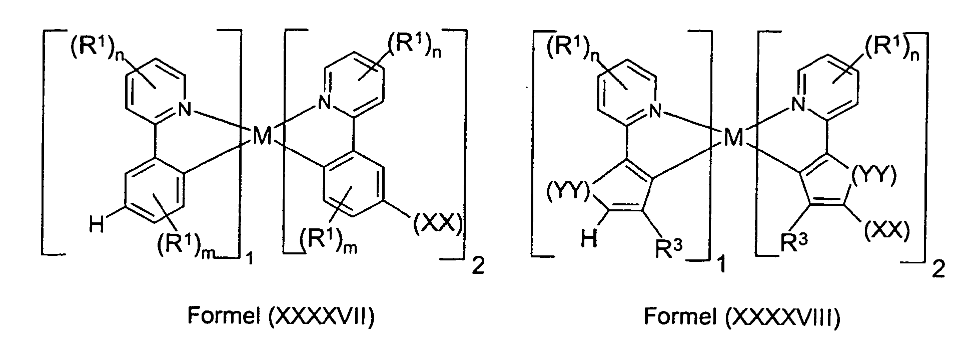 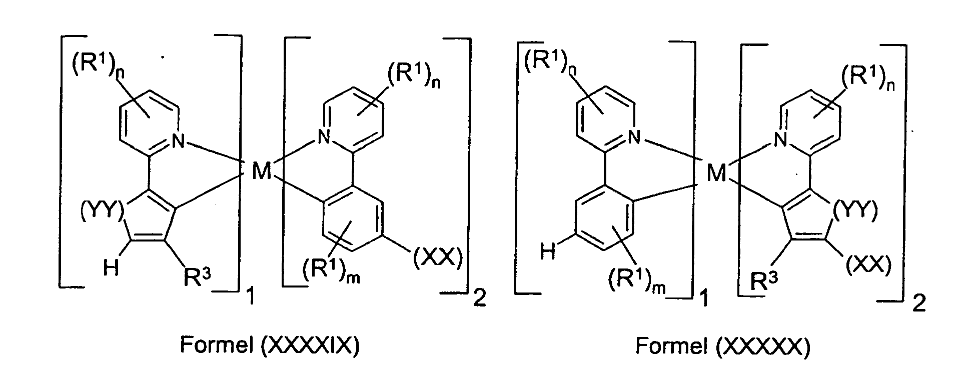 wobei das Symbol
M Rh oder Ir entspricht;
XX der Verknüpfungsstelle im Polymer entspricht;
YY bei jedem Auftreten gleich oder verschieden O, S oder Se ist;
und die anderen Symbole und Indizes die folgende Bedeutung haben:
X ist bei jedem Auftreten gleich oder verschieden CH, CR¹ oder N,
Z ist bei jedem Auftreten gleich oder verschieden einer chemischen Einfachbindung, einer CR³R⁴-Gruppierung, einer -CR³R⁴-CR³R⁴-Gruppierung, einer -CR³=CR⁴-Gruppierung, O, S, N-R⁵, C=O, C=CR³R⁴ oder SiR³R⁴;
R¹ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R⁵)₂, N(R⁵)₃⁺ wobei auch zwei oder mehrere Reste R¹ miteinander ein Ringsystem bilden können;
R² ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN;
R³, R⁴ sind bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN; mehrere benachbarte Reste R³ und/oder R⁴ können zusammen auch einen Ring ausbilden;
R⁵ ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
m ist bei jedem Auftreten gleich oder verschieden 0, 1, 2, oder 3;
n ist bei jedem Auftreten gleich oder verschieden 0, 1, 2, 3, oder 4;
mit der Maßgabe, daß der Gesamtanteil der Wiederholeinheiten vom Typ Formel (I) und der Einheiten gemäß aus den Gruppen 1 bis 4 zusammen mindestens 40% aller Wiederholeinheiten im Polymer ausmachen, und daß dabei das Verhältnis der Wiederholeinheiten vom Typ Formel (I) zur Summe derer aus den Gruppen 1 bis 4 im Bereich von 20:1 bis 1:2 liegt,
ausgenommen Polymere die eine Gruppe der Formel 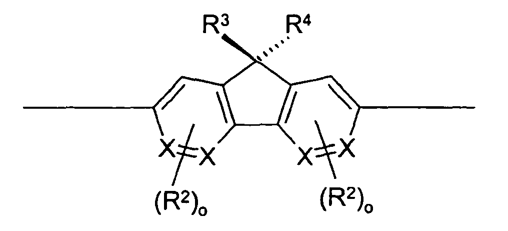 worin die Reste folgende Bedeutungen haben:
X ist bei jedem Auftreten gleich oder verschieden CH, CR¹ oder N,
R¹ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R⁵)₂, wobei auch zwei oder mehrere Reste R¹ miteinander ein Ringsystem bilden können;
R² ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN;
R³, R⁴ sind bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R⁵, O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder CN; die beiden Reste R³ und R⁴ können zusammen auch einen Ring ausbilden, der allerdings nicht zu Strukturen gemäß Formel (I) führt;
R⁵ ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
o ist bei jedem Auftreten gleich oder verschieden 0, 1, 2, oder 3,
enthalten.
mit der Maßgabe, daß der Gesamtanteil der Wiederholeinheiten vom Typ Formel (I) und der Einheiten gemäß aus den Gruppen 1 bis 4 zusammen mindestens 40% aller Wiederholeinheiten im Polymer ausmachen, und daß dabei das Verhältnis der Wiederholeinhalten vom Typ Formel (I) zur Summe derer aus den Gruppen 1 bis 4 im Bereich von 20:1 bis 1:2 liegt.

2. Polymere gemäß Anspruch 1 oder 2, **dadurch gekennzeichnet, daß** diese gleichzeitig neben Struktureinheiten gemäß Formel (I), zusätzlich mindestens zwei Gruppen ausgewählt aus den Gruppen 1 bis 4 vorliegen haben.

3. Polymere gemäß Anspruch 2, **dadurch gekennzeichnet, daß** gleichzeitig neben Struktureinheiten gemäß Formel (I) weitere Einheiten der Gruppen 1 und 2, bzw. 1 und 3, bzw. 1 und 4, bzw. 2 und 3, bzw. 2 und 4, bzw. 3 und 4 vorhanden sind.

4. Polymere gemäß Anspruch 2, **dadurch gekennzeichnet, daß** gleichzeitig neben Struktureinheiten gemäß Formel (I) weitere Strukturen aus den Gruppen 1 und 2 und 3, bzw. 1 und 2 und 4, bzw. 2 und 3 und 4 vorliegen.

5. Polymere gemäß einem oder mehreren der Ansprüche 1 bis 4, **dadurch gekennzeichnet, daß** gleichzeitig neben Struktureinheiten gemäß Formel (I) weitere Einheiten gemäß den Formeln (II) bis (V) und solche gemäß den Formeln (XXIV) bzw. (XXVI) bis (XXX) vorliegen.

6. Polymere gemäß einem oder mehreren der Ansprüche 1 bis 5, **dadurch gekennzeichnet, daß** gleichzeitig mehr als eine Struktureinheiten aus einer Gruppe vorliegt.

7. Polymere gemäß einem oder mehreren der Ansprüche 1 bis 6, **dadurch gekennzeichnet, daß** für das Symbol X = C-H oder C-R¹ gilt.

8. Polymere gemäß einem oder mehreren der Ansprüche 1 bis 7, **dadurch gekennzeichnet, daß** das Symbol Z für eine chemische Einfachbindung steht.

9. Polymere gemäß einem oder mehreren der Ansprüche 1 bis 8, **dadurch gekennzeichnet, daß** gilt:
R¹ ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, eine Arylgruppe mit 6 bis 14 C-Atomen, weiche auch durch ein oder mehrere nicht-aromatische Reste R¹ substituiert sind.

10. Polymere gemäß einem oder mehreren der Ansprüche 1 bis 9, **dadurch gekennzeichnet, daß** gilt:
R¹ ist bei jedem Auftreten gleich oder verschieden eine geradkettige oder verzweigte Alkyl- oder Alkoxykette mit 1 bis 8 C-Atomen, oder eine Arylgruppe mit 6 bis 10 C-Atomen, weiche auch durch ein oder mehrere nicht-aromatische Reste R¹ substituiert sind;
n ist gleich oder verschieden 1 oder 2.

11. Polymere gemäß einem oder mehreren der Ansprüche 1 bis 10, die mindestens noch eine weitere aromatische oder eine andere konjugierte Struktur aufweisen, welche nicht unter die Gruppen 1 bis 4 fällt.

12. Polymere gemäß Anspruch 11, **dadurch gekennzeichnet, daß** sie aromatische Strukturen, mit 6 bis 40 C-Atome oder auch Stilben- oder Bisstyrylarylenderivate aufweisen, die jeweils mit einem oder mehreren nicht aromatischen Resten R¹ substituiert sein können.

13. Polymere gemäß den Ansprüchen 11 und/oder 12, **dadurch gekennzeichnet, daß** 1,4-Phenylen-, 1,4-Naphthylen-, 1,4- oder 9,10-Anthracenylen-, 1,6- oder 2,7-oder 4.9-Pyren-, 3,9- oder 3,10- Perylen-, 2,7- oder 3,6-Phenanthren-, 4,4'-Biphenylen-, 4.4"-Terphenylen-, 4,4'-81-1.1'-naphthylen-, 4,4'-Stilben- oder 4,4"-Bisstyrylarylanderivate eingebaut sind.

14. Verwendung eines oder mehrerer der Polymere gemäß einem oder mehreren der Ansprüchen 1 bis 13 in einer PLED, insbesondere als Elektrolumineszenzmaterial.

15. PLED mit einer oder mehreren aktiven Schichten, wobei mindestens eine dieser aktiven Schichten ein oder mehrere erfindungsgemäße Polymere gemäß einem oder mehreren der Ansprüchen 1 bis 13 enthält.

16. Elektronisches Bauteil (Device) enthaltend ein oder mehrere Polymere gemäß einem oder mehreren der Ansprüchen 1 bis 13.

17. Organische Integrierte Schaltungen (O-ICs), Organischen Feld-Effekt-Transistoren (OFETs), Organischen Dünnfilmtransistoren (OTFTs), Organische Solarzellen (O-SCs) oder Organische Laserdioden (O-Laser) **dadurch gekennzeichnet, daß** sie ein oder mehrere Polymere gemäß einem oder mehreren der Ansprüchen 1 bis 13 enthalten.

18. Lösungen, enthaltend ein oder mehrere Polymere gemäß eines oder mehreren der Ansprüche 1 bis 13, in einem oder mehreren Lösemitteln.

## Claims

1. Conjugated polymers which, besides units of the formula (I) 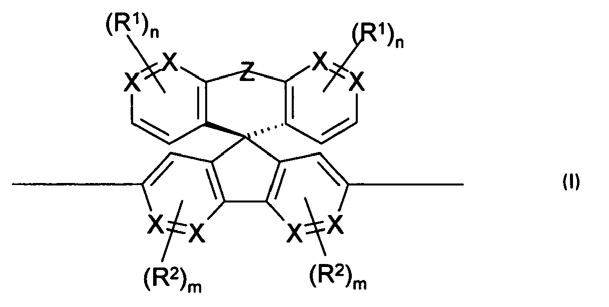 additionally also contain one or more units selected from the following groups 1 to 4, where group 1 stands for units which significantly increase the hole-injection or -transport properties of the polymers and are selected from the formulae (II) to (XI) and (XIII) to (XIX) 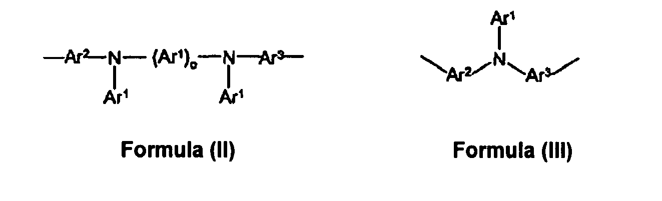 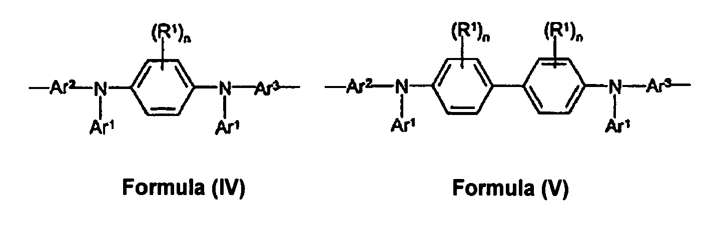 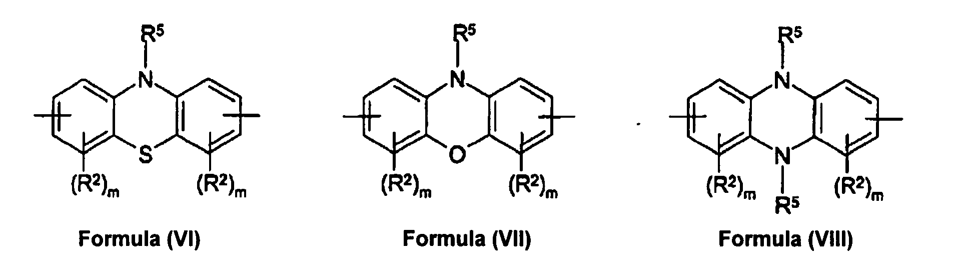 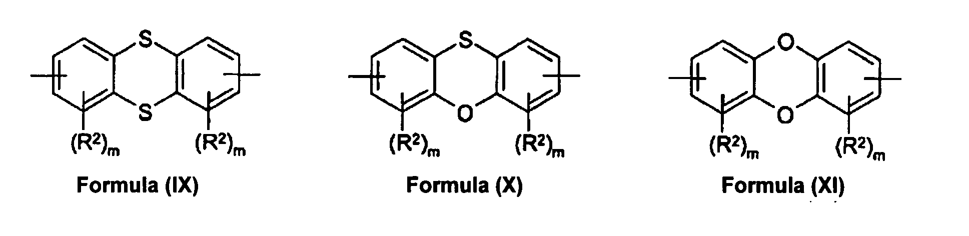 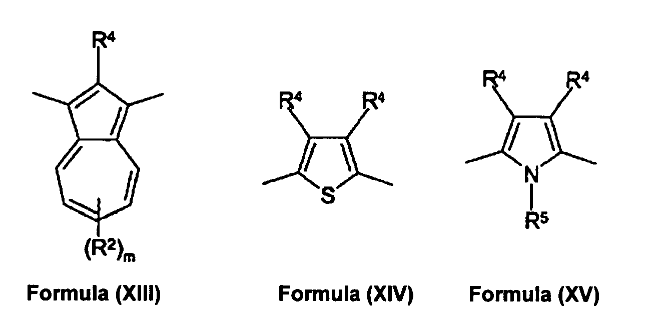 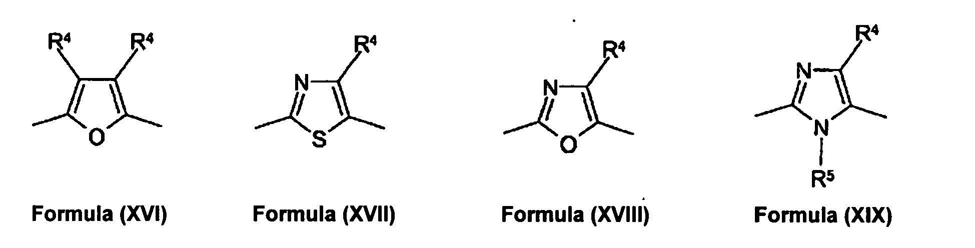 where the symbols
Ar¹, Ar², Ar³ on each occurrence, identically or differently, are aromatic or hetero-aromatic hydrocarbons having 2 to 40 C atoms, which may also be substituted by one or more non-aromatic radicals R¹;
o is 1, 2 or 3;
where group 2 stands for units which significantly increase the electron-injection or -transport properties of the polymers and are selected from the formulae (XX) to (XXX) 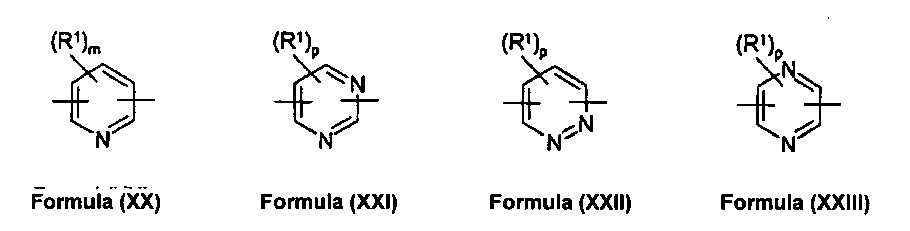 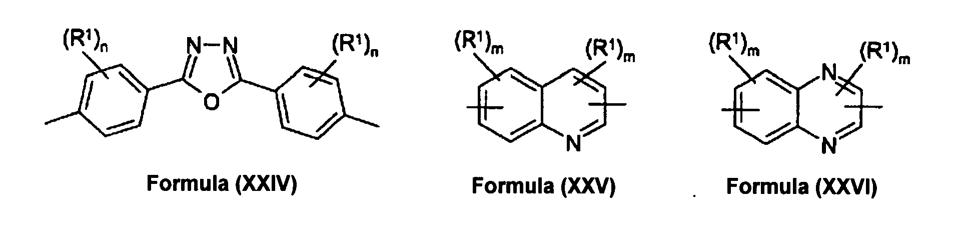 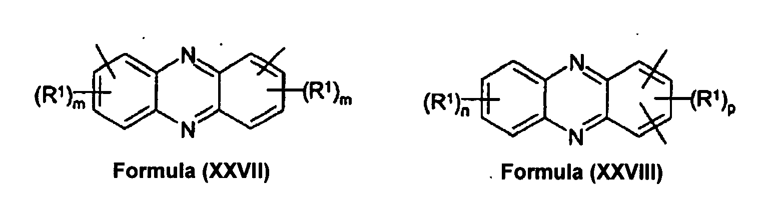 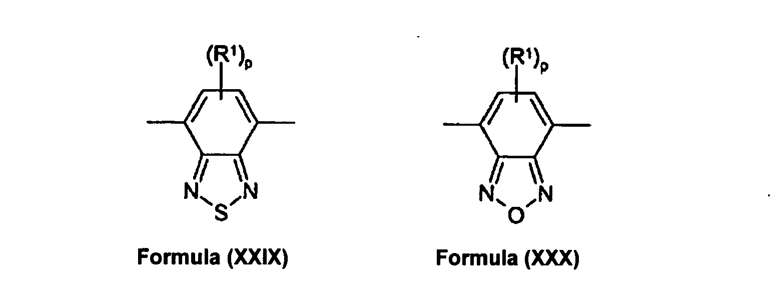 where the symbols
p denote 0, 1 or 2;
where group 3 stands for units which contain combinations of individual units from group 1 and group 2 and are selected from the formulae (XXXI) to (XXXXVI) 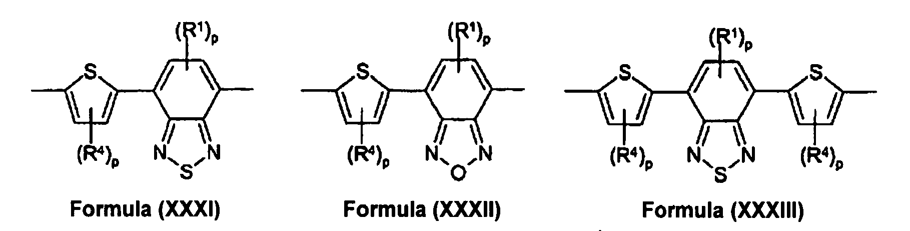 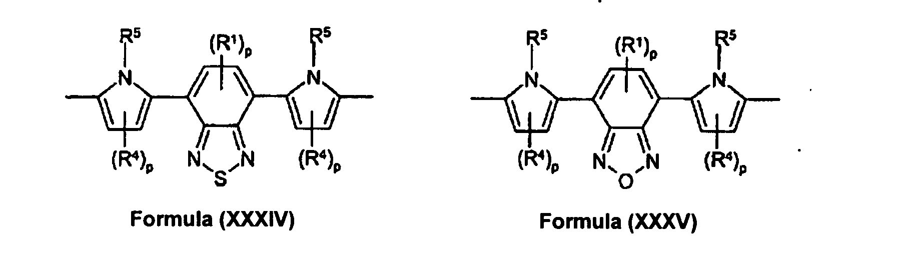 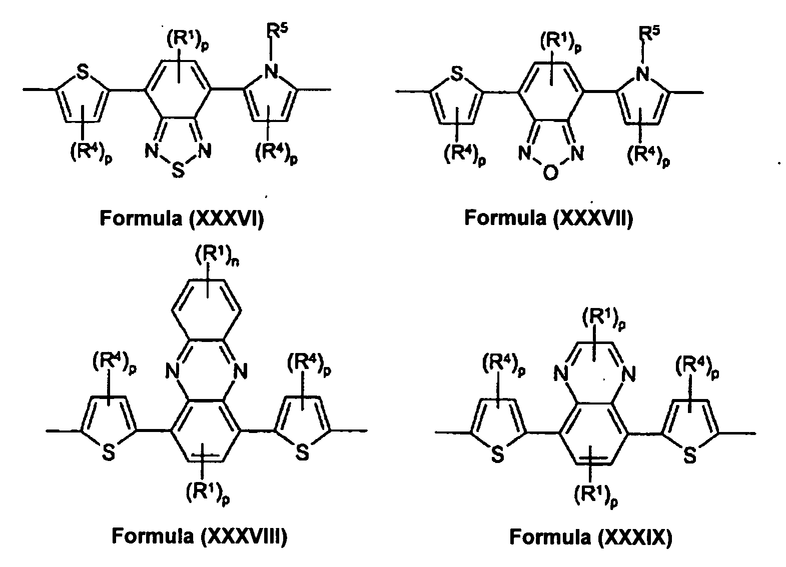 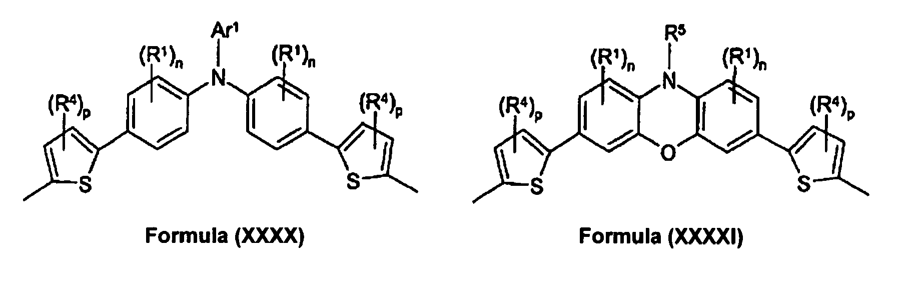 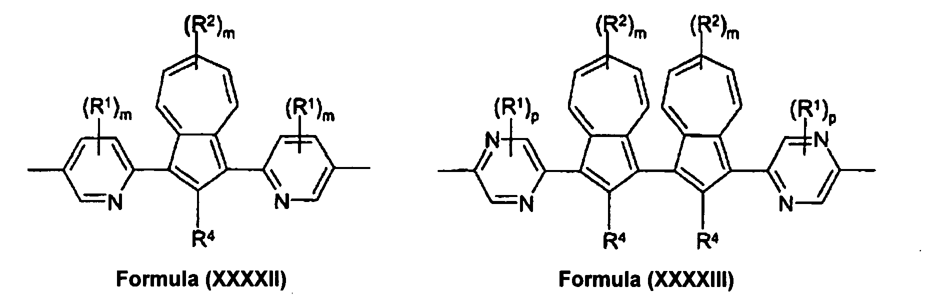 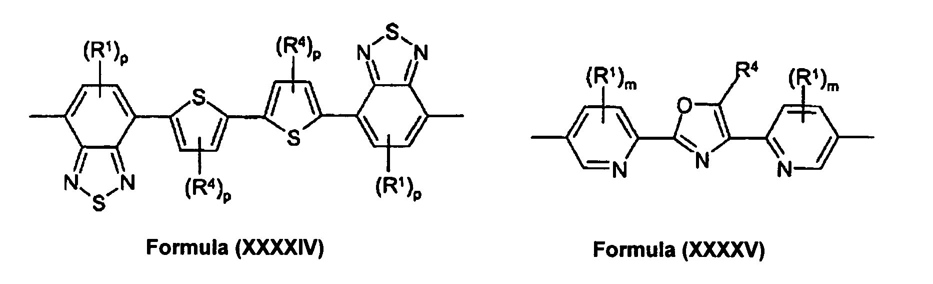 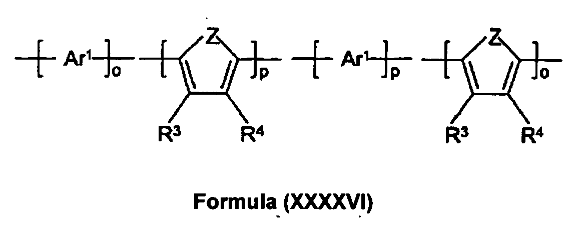 where the symbols
o denote 1, 2 or 3, preferably 1 or 2, and;
p is 0, 1 or 2, preferably 0 or 1;
where group 4 stands for units which modify the emission characteristics to such an extent that phosphorescence can be obtained instead of fluorescence and are selected from the formulae (XXXXVII) to (XXXXX) 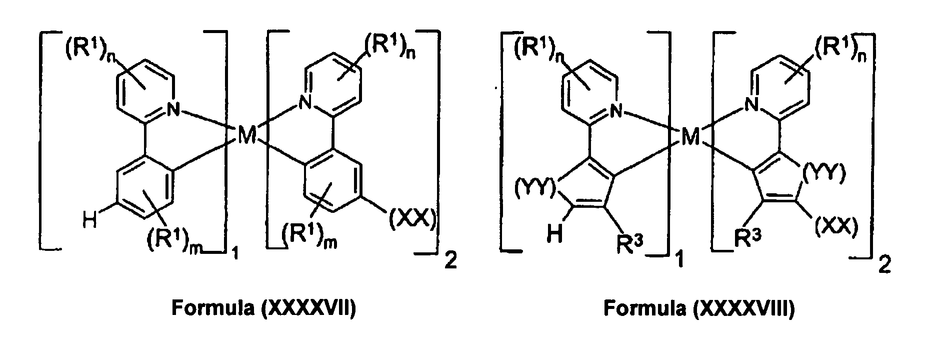 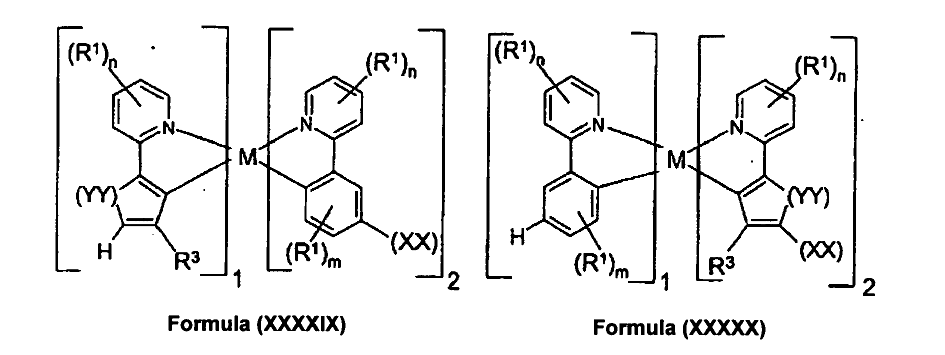 where the symbol
M corresponds to Rh or Ir;
XX corresponds to the linking point in the polymer;
YY on each occurrence, identically or differently, is O, S or Se;
and the other symbols and indices have the following meaning:
X is on each occurrence, identically or differently, CH, CR¹ or N,
Z is on each occurrence, identically or differently, a chemical single bond, a CR³R⁴ group, a -CR³R⁴-CR³R⁴- group, a -CR³=CR⁴- group, O, S, N-R⁵, C=O, C=CR³R⁴ or SiR³R⁴;
R¹ is on each occurrence, identically or differently, a straight-chain, branched or cyclic alkyl or alkoxy chain having 1 to 22 C atoms, in which, in addition, one or more non-adjacent C atoms may be replaced by N-R⁵, O, S, -CO-O-, O-CO-O and in which one or more H atoms may be replaced by fluorine, an aryl or aryloxy group having 5 to 40 C atoms, in which, in addition, one or more C atoms may be replaced by O, S or N and which may be substituted by one or more non-aromatic radicals R¹, or Cl, F, CN, N(R⁵)₂, N(R⁵)₃⁺, where, in addition, two or more radicals R¹ may form a ring system with one another;
R² is on each occurrence, identically or differently, a straight-chain, branched or cyclic alkyl or alkoxy chain having 1 to 22 C atoms, in which, in addition, one or more non-adjacent C atoms may be replaced by N-R⁵, O, S, -CO-O-, O-CO-O and in which one or more H atoms may be replaced by fluorine, an aryl or aryloxy group having 5 to 40 C atoms, in which, in addition, one or more C atoms may be replaced by O, S or N and which may be substituted by one or more non-aromatic radicals R¹, or CN;
R³, R⁴ are on each occurrence, identically or differently, H, a straight-chain, branched or cyclic alkyl chain having 1 to 22 C atoms, in which, in addition, one or more non-adjacent C atoms may be replaced by N-R⁵, O, S, -CO-O-, O-CO-O and in which one or more H atoms may be replaced by fluorine, an aryl group having 5 to 40 C atoms, in which, in addition, one or more C atoms may be replaced by O, S or N and which may be substituted by one or more non-aromatic radicals R¹, or CN; a plurality of adjacent radicals R³ and/or R⁴ together may also form a ring;
R⁵ is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O and in which one or more H atoms may be replaced by fluorine, an aryl group having 5 to 40 C atoms, in which, in addition, one or more C atoms may be replaced by O, S or N and which may be substituted by one or more non-aromatic radicals R¹;
m is on each occurrence, identically or differently, 0, 1, 2 or 3;
n is on each occurrence, identically or differently, 0, 1, 2, 3 or 4;
with the proviso that the total proportion of the recurring units of the formula (I) type and the units from groups 1 to 4 together makes up at least 40% of all recurring units in the polymer, and that the ratio of the recurring units of the formula (I) type to the sum of those from groups 1 to 4 is in the range from 20 : 1 to 1 : 2,
with the exception of polymers which contain a group of the formula 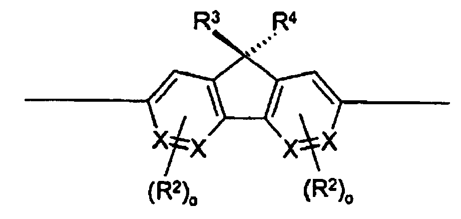 in which the radicals have the following meanings:
X is on each occurrence, identically or differently, CH, CR¹ or N,
R¹ is on each occurrence, identically or differently, a straight-chain, branched or cyclic alkyl or alkoxy chain having 1 to 22 C atoms, in which, in addition, one or more non-adjacent C atoms may be replaced by N-R⁵, O, S, -CO-O-, O-CO-O and in which one or more H atoms may be replaced by fluorine, an aryl or aryloxy group having 5 to 40 C atoms, in which, in addition, one or more C atoms may be replaced by O, S or N and which may be substituted by one or more non-aromatic radicals R¹, or Cl, F, CN, N(R⁵)₂, where, in addition, two or more radicals R¹ may form a ring system with one another;
R² is on each occurrence, identically or differently, a straight-chain, branched or cyclic alkyl or alkoxy chain having 1 to 22 C atoms, in which, in addition, one or more non-adjacent C atoms may be replaced by N-R⁵, O, S, -CO-O-, O-CO-O and in which one or more H atoms may be replaced by fluorine, an aryl or aryloxy group having 5 to 40 C atoms, in which, in addition, one or more C atoms may be replaced by O, S or N and which may be substituted by one or more non-aromatic radicals R¹, or CN;
R³, R⁴ are on each occurrence, identically or differently, H, a straight-chain, branched or cyclic alkyl chain having 1 to 22 C atoms, in which, in addition, one or more non-adjacent C atoms may be replaced by N-R⁵, O, S, -CO-O-, O-CO-O and in which one or more H atoms may be replaced by fluorine, an aryl group having 5 to 40 C atoms, in which, in addition, one or more C atoms may be replaced by O, S or N, and which may be substituted by one or more non-aromatic radicals R¹, or CN; the two radicals R³ and R⁴ together may also form a ring, which, however, does not result in structures of the formula (I);
R⁵ is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O and in which one or more H atoms may be replaced by fluorine, an aryl group having 5 to 40 C atoms, in which, in addition, one or more C atoms may be replaced by O, S or N and which may be substituted by one or more non-aromatic radicals R¹;
o is on each occurrence, identically or differently, 0, 1, 2 or 3;
with the proviso that the total proportion of the recurring units of the formula (I) type and the units from groups 1 to 4 together makes up at least 40% of all recurring units in the polymer, and that the ratio of recurring units of the formula (I) type to the sum of those from groups 1 to 4 is in the range from 20 : 1 to 1 : 2.

2. Polymers according to Claim 1 or 2, **characterised in that** they simultaneously, besides structural units of the formula (I), additionally have at least two groups selected from groups 1 to 4.

3. Polymers according to Claim 2, **characterised in that**, besides structural units of the formula (I), further units from groups 1 and 2, or 1 and 3, or 1 and 4, or 2 and 3, or 2 and 4, or 3 and 4 are present simultaneously.

4. Polymers according to Claim 2, **characterised in that**, besides structural units of the formula (I), further structures from groups 1 and 2 and 3, or 1 and 2 and 4, or 2 and 3 and 4 are present simultaneously.

5. Polymers according to one or more of Claims 1 to 4, **characterised in that**, besides structural units of the formula (I), further units of the formulae (II) to (V) and those of the formulae (XXIV) and (XXVI) to (XXX) are present simultaneously.

6. Polymers according to one or more of Claims 1 to 5, **characterised in that** more than one structural unit from one group is present simultaneously.

7. Polymers according to one or more of Claims 1 to 6, **characterised in that** the symbol X = C-H or C-R¹.

8. Polymers according to one or more of Claims 1 to 7, **characterised in that** the symbol Z stands for a chemical single bond.

9. Polymers according to one or more of Claims 1 to 8, **characterised in that**
R¹ is on each occurrence, identically or differently, a straight-chain, branched or cyclic alkyl or alkoxy chain having 1 to 10 C atoms, in which, in addition, one or more H atoms may be replaced by fluorine, an aryl group having 6 to 14 C atoms, which, in addition, are substituted by one or more non-aromatic radicals R¹.

10. Polymers according to one or more of Claims 1 to 9, **characterised in that**
R¹ is on each occurrence, identically or differently, a straight-chain or branched alkyl or alkoxy chain having 1 to 8 C atoms, or an aryl group having 6 to 10 C atoms, which, in addition, are substituted by one or more non-aromatic radicals R¹;
n is, identically or differently, 1 or 2.

11. Polymers according to one or more of Claims 1 to 10, which also have at least one further aromatic or another conjugated structure which does not fall under groups 1 to 4.

12. Polymers according to Claim 11, **characterised in that** they have aromatic structures having 6 to 40 C atoms or also stilbene or bisstyrylarylene derivatives, each of which may be substituted by one or more non-aromatic radicals R¹.

13. Polymers according to Claims 11 and/or 12, **characterised in that** 1,4-phenylene, 1,4-naphthylene, 1,4- or 9,10-anthracenylene, 1,6- or 2,7- or 4,9-pyrene, 3,9- or 3,10-perylene, 2,7- or 3,6-phenanthrene, 4,4'-biphenylene, 4,4"-terphenylene, 4,4'-bi-1,1'-naphthylene, 4,4'-stilbene or 4,4"-bisstyrylarylene derivatives are incorporated.

14. Use of one or more of the polymers according to one or more of Claims 1 to 13 in a PLED, in particular as electroluminescent material.

15. PLED having one or more active layers, where at least one of these active layers comprises one or more polymers according to the invention according to one or more of Claims 1 to 13.

16. Electronic component (device) comprising one or more polymers according to one or more of Claims 1 to 13.

17. Organic integrated circuits (O-ICs), organic field-effect transistors (OFETs), organic thin-film transistors (OTFTs), organic solar cells (O-SCs) or organic laser diodes (O-lasers), **characterised in that** they comprise one or more polymers according to one or more of Claims 1 to 13.

18. Solutions comprising one or more polymers according to one or more of Claims 1 to 13 in one or more solvents.

## Revendications

1. Polymères conjugués qui, en plus d'unités de la formule (I) 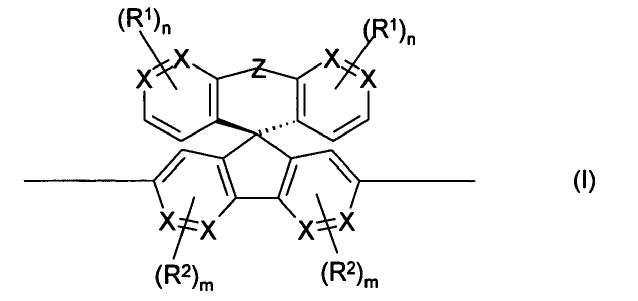 contiennent également de façon additionnelle une ou plusieurs unités choisies parmi les groupes qui suivent 1 à 4, dans lesquels le groupe 1 représente des unités qui augmentent de manière significative les propriétés d'injection ou de transport de trous des polymères et qui sont choisies à partir des formules (II) à (XI) et (XIII) à (XIX) 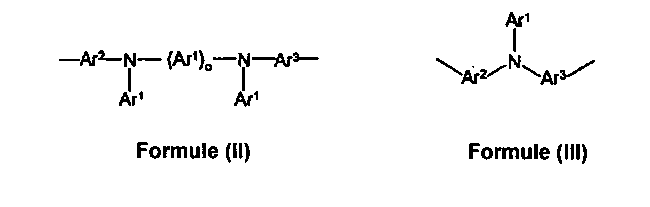 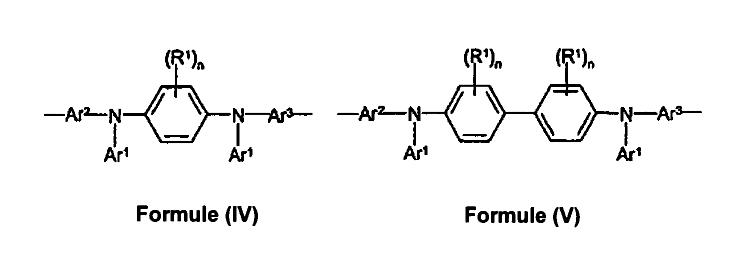 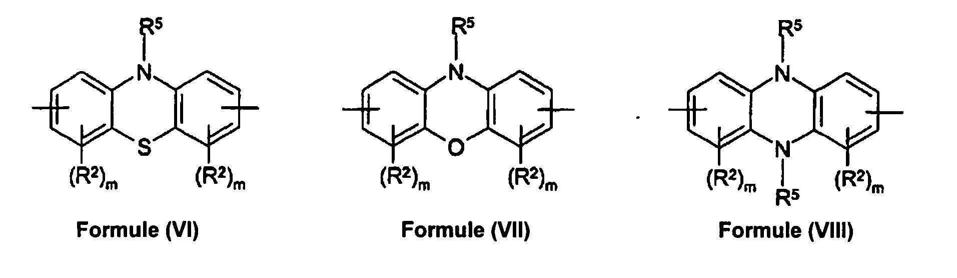 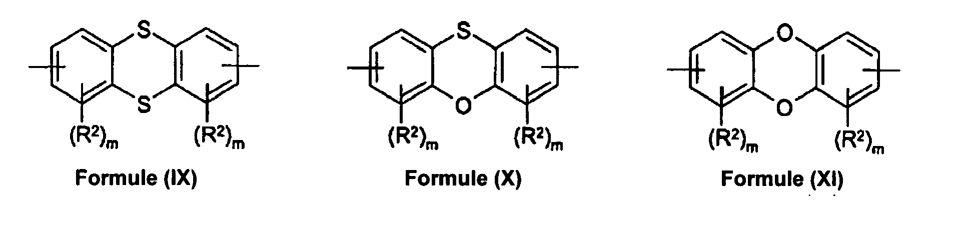 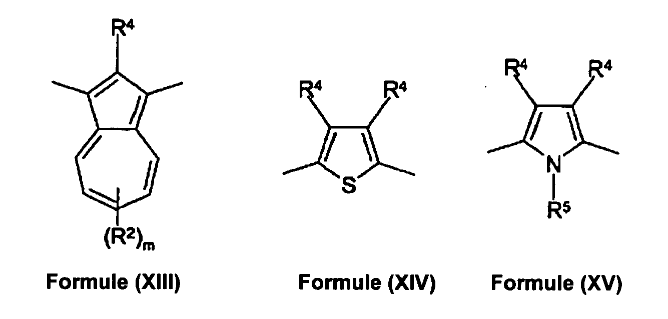 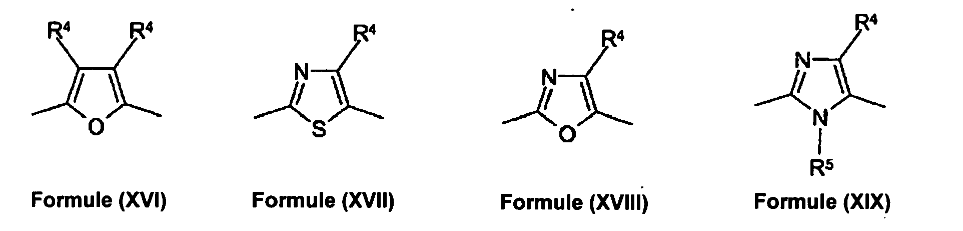 dans lesquelles les symboles
Ar¹, Ar², Ar³ lors de chaque occurrence, de manière identique ou différente, sont des hydrocarbones aromatiques ou hétéroaromatiques comportant de 2 à 40 atomes de C, qui peuvent également être substitués par un ou plusieurs radicaux non aromatiques R¹ ;
o est 1, 2 ou 3 ;
dans lesquels le groupe 2 représente des unités qui augmentent de façon significative les propriétés d'injection ou de transport d'électrons des polymères et qui sont choisies parmi les formules (XX) à (XXX) 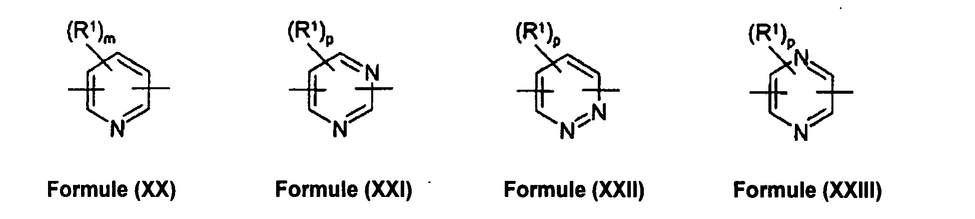 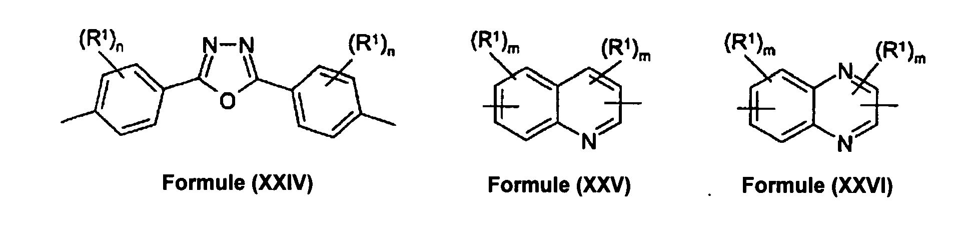 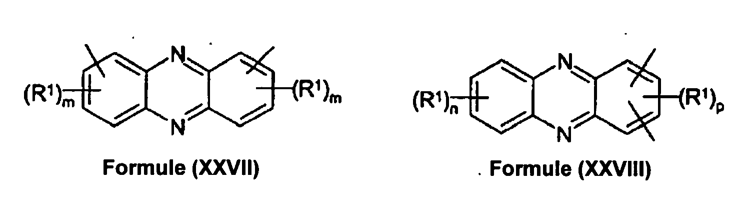 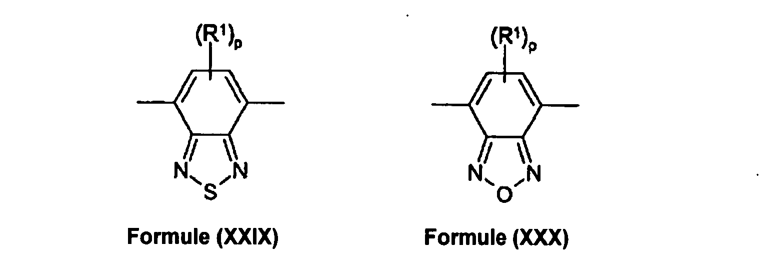 dans lesquelles les symboles
p représente 0, 1 ou 2 ;
dans lesquels le groupe 3 représente des unités qui contiennent des combinaisons d'unités individuelles provenant du groupe 1 et du groupe 2 et qui sont choisies parmi les formules (XXXI) à (XXXXVI) 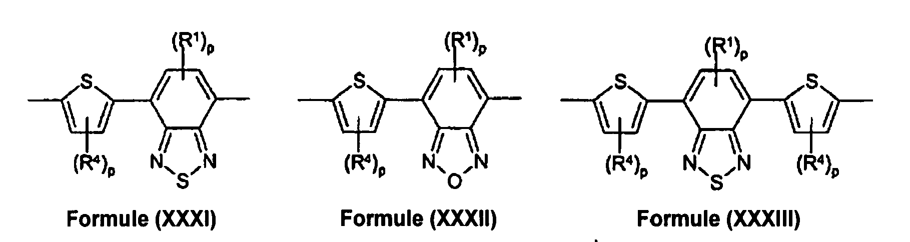 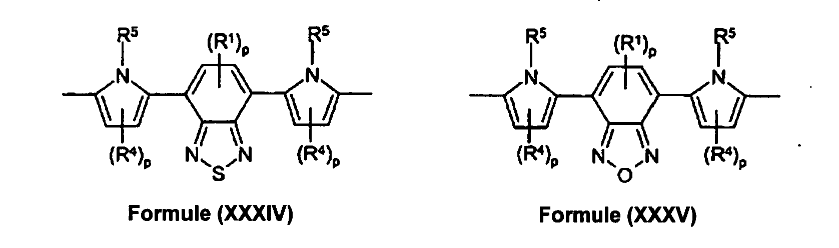 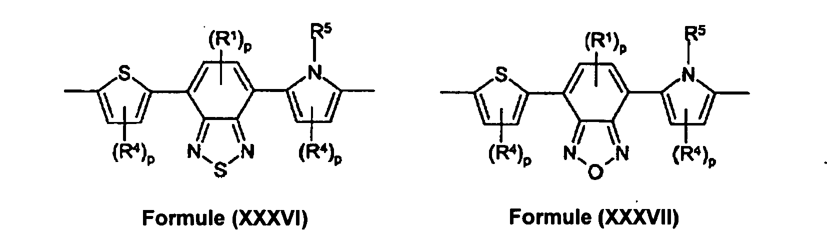 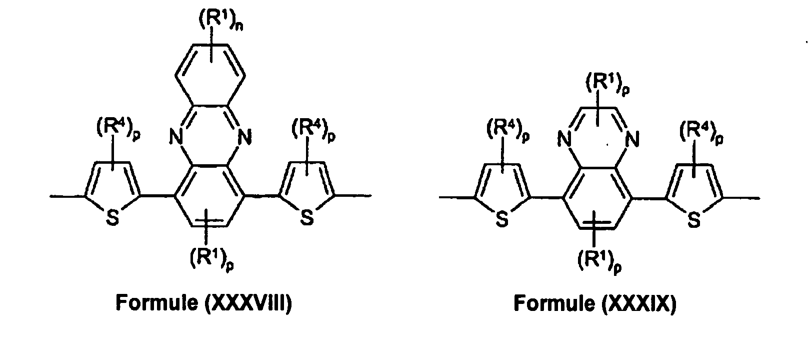 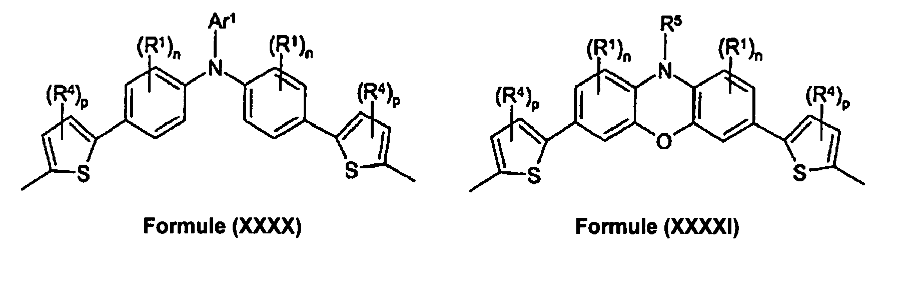 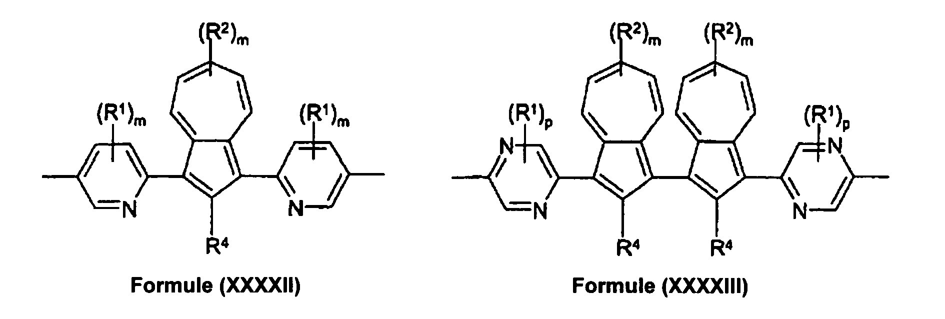 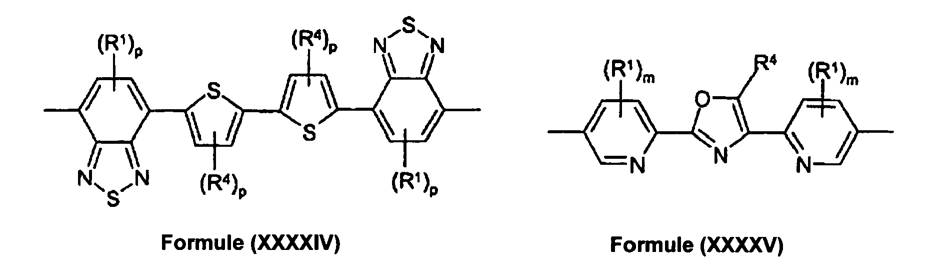 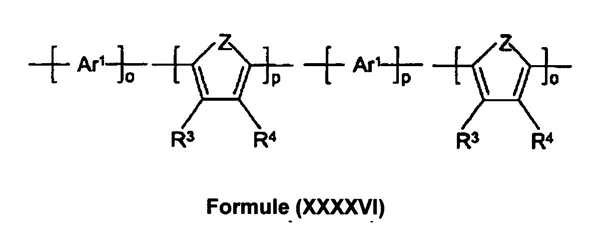 dans lesquelles les symboles
o représente 1, 2 ou 3, de préférence 1 ou 2, et
p est 0, 1 ou 2, de préférence 0 ou 1 ;
dans lesquels le groupe 4 représente des unités qui modifient les caractéristiques d'émission selon un degré qui est tel qu'une phosphorescence peut être obtenue en lieu et place d'une fluorescence et qui sont choisies parmi les formules (XXXXVII) à (XXXXX) 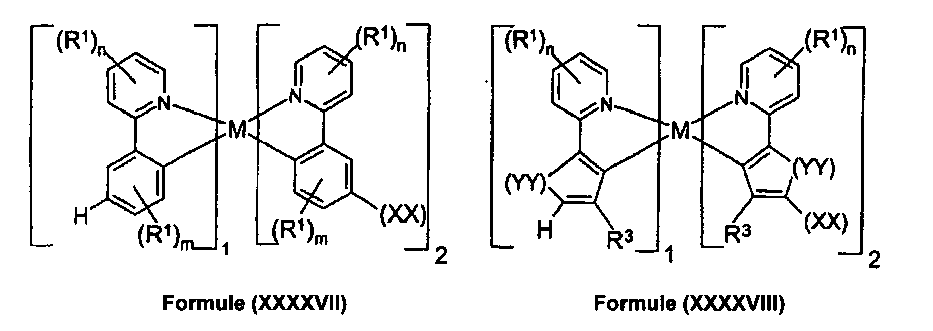 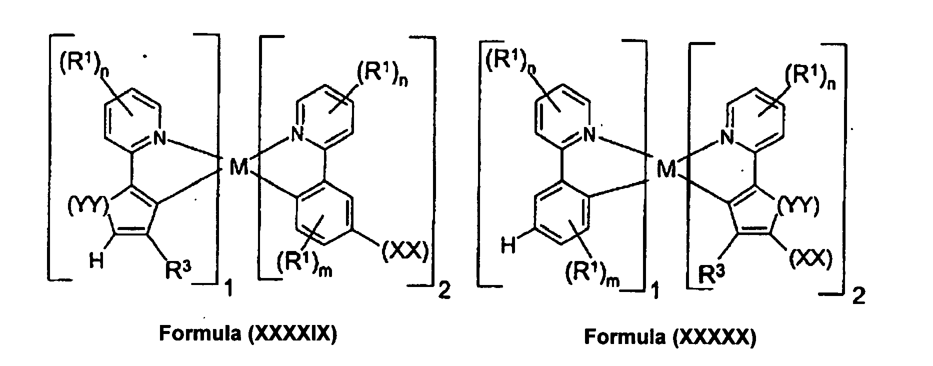 dans lesquelles le symbole
M correspond à Rh ou Ir ;
XX correspond au point de liaison dans le polymère ;
YY lors de chaque occurrence, de manière identique ou différente, est O, S ou Se ;
et les autres symboles et indices présentent la signification qui suit :
X est, lors de chaque occurrence, de manière identique ou différente, CH, CR¹ ou N,
Z est, lors de chaque occurrence, de manière identique ou différente, une liaison simple chimique, un groupe CR³R⁴, un groupe -CR³R⁴-CR³R⁴-, un groupe -CR³=CR⁴-, O, S, N-R⁵, C=O, C=CR³R⁴ ou SiR³R⁴ ;
R¹ est, lors de chaque occurrence, de manière identique ou différente, une chaîne alkyle ou alkoxy en chaîne droite, ramifiée ou cyclique, comportant de 1 à 22 atomes de C où, en plus, un ou plusieurs atomes de C non adjacents peuvent être remplacés par N-R⁵, O, S, -CO-O-, O-CO-O et où un ou plusieurs atomes de H peuvent être remplacés par fluor, un groupe aryle ou aryloxy comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹, ou Cl, F, CN, N(R⁵)₂, N(R⁵)₃⁺, où, en plus, deux radicaux R¹ ou plus peuvent former un système d'anneau avec un autre ;
R² est, lors de chaque occurrence, de manière identique ou différente, une chaîne alkyle ou alkoxy en chaîne droite, ramifiée ou cyclique comportant de 1 à 22 atomes de C où, en plus, un ou plusieurs atomes de C non adjacents peuvent être remplacés par N-R⁵, O, S, -CO-O-, O-CO-O et où un ou plusieurs atomes de H peuvent être remplacés par fluor, un groupe aryle ou aryloxy comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹ ou CN ;
R³, R⁴ sont, lors de chaque occurrence, de manière identique ou différente, H, une chaîne alklyle en chaîne droite, ramifiée ou cyclique comportant de 1 à 22 atomes de C, où, en plus, un ou plusieurs atomes de C non adjacents peuvent être remplacés par N-R⁵, O, S, -CO-O-, O-CO- et où, un ou plusieurs atomes de H peuvent être remplacés par fluor, un groupe aryle comportant de 5 à 40 atomes de C où, en plus, un ou plusieurs atomes de C peuvent être remplacés par O, S ou N et lesquels atomes peuvent être substitués par un ou plusieurs radicaux non aromatiques R¹, ou CN ; une pluralité de radicaux adjacents R³ et/ou R⁴ peuvent en association former également un anneau ;
R⁵ est, lors de chaque occurrence, de manière identique ou différente, H, une chaîne alkyle en chaîne droite, ramifiée ou cyclique comportant de 1 à 22 atomes de C, où, en plus, un ou plusieurs atomes de C non adjacents peuvent être remplacés par O, S, -CO-O-, O-CO-O et où un ou plusieurs atomes de H peuvent être remplacés par fluor, un groupe aryle comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹ ;
m est, lors de chaque occurrence, de manière identique ou différente, 0, 1, 2 ou 3 ;
n est, lors de chaque occurrence, de manière identique ou différente, 0, 1, 2, 3 ou 4,
étant entendu que la proportion totale des unités récurrentes du type de la formule (I) et des unités prises parmi les groupes 1 à 4 constitue en association au moins 40% de toutes les unités récurrentes dans le polymère et que le rapport des unités récurrentes du type de la formule (I) sur la somme de celles en provenance des groupes 1 à 4 est dans la plage de 20:1 à 1:2,
à l'exception des polymères qui contiennent un groupe de la formule 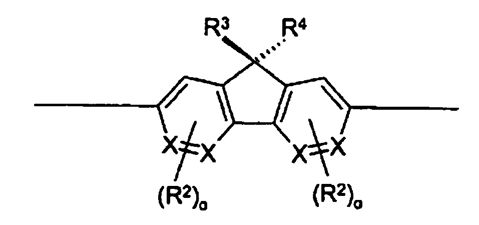 dans laquelle les radicaux présentent les significations qui suivent :
X est, lors de chaque occurrence, de manière identique ou différente, CH, CR¹ ou N,
R¹ est, lors de chaque occurrence, de manière identique ou différente, une chaîne alkyle ou alkoxy en chaîne droite, ramifiée ou cyclique comportant de 1 à 22 atomes de C où, en plus, un ou plusieurs atomes de C non adjacents peuvent être remplacés par N-R⁵, O, S, -CO-O-, O-CO-O et où un ou plusieurs atomes de H peuvent être remplacés par fluor, un groupe aryle ou aryloxy comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹, ou Cl, F, CN, N(R⁵)₂, où, en plus, deux radicaux R¹ ou plus peuvent former un système d'anneau avec un autre ;
R² est, lors de chaque occurrence, de manière identique ou différente, une chaîne alkyle ou alkoxy en chaîne droite, ramifiée ou cyclique comportant de 1 à 22 atomes de C où, en plus, un ou plusieurs atomes de C non adjacents peuvent être remplacés par N-R⁵, O, S, -CO-O-, O-CO-O et où un ou plusieurs atomes de H peuvent être remplacés par fluor, un groupe aryle ou aryloxy comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹ ou CN ;
R³, R⁴ sont, lors de chaque occurrence, de manière identique ou différente, H, une chaîne alkyle en chaîne droite, ramifiée ou cyclique comportant de 1 à 22 atomes de C, où, en plus, un ou plusieurs atomes de C non adjacents peuvent être remplacés par N-R⁵, O, S, -CO-O-, O-CO- et où, un ou plusieurs atomes de H peuvent être remplacés par fluor, un groupe aryle comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹, ou CN ; les deux radicaux R³ et R⁴ peuvent également former ensemble un anneau qui cependant n'aboutit pas à des structures de la formule (I) ;
R⁵ est, lors de chaque occurrence, de manière identique ou différente, H, une chaîne alkyle en chaîne droite, ramifiée ou cyclique comportant de 1 à 22 atomes de C où, en plus, un ou plusieurs atomes de C non adjacents peuvent être remplacés par O, S, -CO-O-, O-CO-O et où un ou plusieurs atomes de H peuvent être remplacés par fluor, un groupe aryle comportant de 5 à 40 atomes de C, où, en plus, un ou plusieurs atomes de C peuvent être remplacés par O, S ou N et lesquels atomes peuvent être substitués par un ou plusieurs radicaux non aromatiques R¹;
o est, lors de chaque occurrence, de manière identique ou différente, 0, 1, 2 ou 3 ;
étant entendu que la proportion totale des unités récurrentes du type de la formule (I) et des unités prises parmi les groupes 1 à 4 constitue en association au moins 40% de toutes les unités récurrentes dans le polymère et que le rapport des unités récurrentes du type de la formule (I) sur la somme de celles en provenance des groupes 1 à 4 est dans la plage de 20:1 à 1:2.

2. Polymères selon la revendication 1 ou 2, **caractérisés en ce que**, de manière simultanée, en plus d'unités structurelles de la formule (I), ils comportent de manière additionnelle au moins deux groupes choisis parmi les groupes 1 à 4.

3. Polymères selon la revendication 2, **caractérisés en ce que**, en plus d'unités structurelles de la formule (I), des unités supplémentaires issues des groupes 1 et 2 ou 1 et 3 ou 1 et 4 ou 2 et 3 ou 2 et 4 ou 3 et 4 sont présentes de manière simultanée.

4. Polymères selon la revendication 2, **caractérisés en ce que**, en plus d'unités structurelles de la formule (I), des structures supplémentaires issues des groupes 1 et 2 et 3 ou 1 et 2 et 4 ou 2 et 3 et 4 sont présentes de manière simultanée.

5. Polymères selon une ou plusieurs des revendications 1 à 4, **caractérisés en ce que**, en plus d'unités structurelles de la formule (I), des unités supplémentaires des formules (II) à (V) et celles des formules (XXIV) et (XXVI) à (XXX) sont présentes de manière simultanée.

6. Polymères selon une ou plusieurs des revendications 1 à 5, **caractérisés en ce que** plus d'une unité structurelle issue d'un groupe est présente de manière simultanée.

7. Polymères selon une ou plusieurs des revendications 1 à 6, **caractérisés en ce que** le symbole X = C-H ou C-R¹.

8. Polymères selon une ou plusieurs des revendications 1 à 7, **caractérisés en ce que** le symbole Z représente une liaison simple chimique.

9. Polymères selon une ou plusieurs des revendications 1 à 8, **caractérisés en ce que**
R¹ est, lors de chaque occurrence, de manière identique ou différente, une chaîne alkyle ou alkoxy en chaîne droite, ramifiée ou cyclique comportant de 1 à 10 atomes de C, où, en plus, un ou plusieurs atomes de H peuvent être remplacés par fluor, un groupe aryle comportant de 6 à 14 atomes de C lesquels atomes, en outre, sont substitués par un ou plusieurs radicaux non aromatiques R¹.

10. Polymères selon une ou plusieurs des revendications 1 à 9, **caractérisés en ce que**
R¹ est, lors de chaque occurrence, de manière identique ou différente, une chaîne alkyle ou alkoxy en chaîne droite ou ramifiée comportant de 1 à 8 atomes de C ou un groupe aryle comportant de 6 à 10 atomes de C, lesquels atomes, en plus, sont substitués par un ou plusieurs radicaux non aromatiques R¹ ;
n est, de manière identique ou différente, 1 ou 2.

11. Polymères selon une ou plusieurs des revendications 1 à 10, qui comportent également au moins une structure aromatique supplémentaire ou une autre structure conjuguée qui ne tombe pas sous les groupes 1 à 4.

12. Polymères selon la revendication 11, **caractérisés en ce qu'**ils comportent des structures aromatiques comportant de 6 à 40 atomes de C ou également des dérivés de stilbène ou de bisstyrylarylène dont chacun peut être substitué par un ou plusieurs radicaux non aromatiques R¹.

13. Polymères selon la revendication 11 et/ou 12, **caractérisés en ce que** des dérivés de 1,4-phénylène, de 1,4-naphthylène, de 1,4- ou 9,10-anthracénylène, de 1,6- ou 2,7- ou 4,9-pyrène, de 3,9- ou 3,10-pérylène, de 2,7- ou 3,6-phénanthrène, de 4,4'-biphénylène, de 4,4"-terphénylène, de 4,4'-bi-1,1'-naphthylène, de 4,4'-stilbène ou de 4,4"-bisstyrylarylène sont incorporés.

14. Utilisation d'un ou de plusieurs des polymères selon une ou plusieurs des revendications 1 à 13 dans une PLED, en particulier en tant que matériau électroluminescent.

15. PLED comportant une ou plusieurs couches actives où au moins l'une de ces couches actives comprend un ou plusieurs polymères selon l'invention selon une ou plusieurs des revendications 1 à 13.

16. Composant (dispositif) électronique comprenant un ou plusieurs polymères selon une ou plusieurs des revendications 1 à 13.

17. Circuits intégrés organiques (O-IC), transistors à effet de champ organiques (OFET), transistors en film mince organiques (OTFT), cellules solaires organiques (O-SC) ou diodes laser organiques (O-lasers), **caractérisés en ce qu'**ils comprennent un ou plusieurs polymères selon une ou plusieurs des revendications 1 à 13.

18. Solutions comprenant un ou plusieurs polymères selon une ou plusieurs des revendications 1 à 13 dans un ou plusieurs solvants.
